# EUROPEAN PATENT APPLICATION

(11) **EP 4 610 730 A2**
(43) Date of publication of application: **03.09.2025**
(21) Application number: 25157621.1
(22) Date of filing: 13.02.2025
(51) Int. Cl.: G03F 7/09, G03F 7/11

(54) **COMPOSITION FOR FORMING ORGANIC FILM, METHOD FOR FORMING ORGANIC FILM, AND PATTERNING PROCESS**

(30) Priority: 27.02.2024 JP 2024027233
(71) Applicant: SHIN-ETSU CHEMICAL CO., LTD., Tokyo 1000005 (JP)
(72) Inventor: Kori, Daisuke, Niigata (JP); Yamamoto, Yasuyuki, Niigata (JP)
(74) Representative: Sonnenhauser, Thomas Martin

(57) **Abstract**

The present invention is a composition for forming an organic film, containing: (A) a resin or compound for forming an organic film; (B) a fluorine-containing compound represented by formula (1); and (C) a solvent, where L represents a single bond or an n1-valent organic group having 1 to 50 carbon atoms, R₁ represents a saturated or unsaturated monovalent organic group having 1 to 20 carbon atoms, the organic group R₁ having at least one fluorine-containing structure represented by any of the following formulae (2), and "*" represents an attachment point in the organic group represented by the R₁, the organic group R₁ optionally having two or more kinds among the structures represented by the formulae (2), or optionally having two or more identical structures. This can provide a composition for forming an organic film, which is excellent in film-formability on a substrate, filling property, and hump suppression property at the time of an EBR process, and furthermore, makes it possible to form an organic film having an excellent process margin when used as an organic film for a multilayer resist.

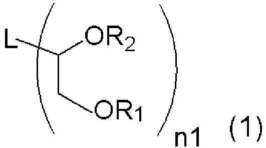

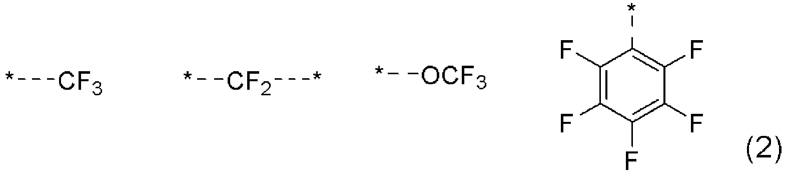

## Description

### TECHNICAL FIELD

The present invention relates to: a composition for forming an organic film; a method for forming an organic film by using the composition; and a patterning process using the composition.

### BACKGROUND ART

Recently, along with advancements toward higher integration and higher processing speed of semiconductor devices, a finer pattern rule has been required. In this situation, various techniques have been developed in regard to how patterning process can be performed more finely and precisely depending on light sources used in lithography with light exposure, which is a commonly-employed technique at present.

As the light source for lithography employed in resist pattern formation, light exposure using a g-line (436 nm) or an i-line (365 nm) of a mercury lamp is widely adopted for portions where the degree of integration is low. Meanwhile, for portions where the degree of integration is high and finer patterning is required, lithography using a KrF excimer laser (248 nm) or an ArF excimer laser (193 nm) with shorter wavelengths has also been practically used. Moreover, for the most-advanced generation requiring further finer patterning, lithography with extreme ultraviolet ray (EUV, 13.5 nm) is about to be put to practical use.

It is well known that in a monolayer resist method, which is employed as a typical resist patterning process, as the thinning of resist patterns progresses as described above, the ratio of a pattern height to a pattern line width (aspect ratio) is increased, and pattern collapse occurs due to the surface tension of a developer during development. It is known that, in this situation, a multilayer resist method, in which a pattern is formed by laminating films having different dry etching properties, is excellent in forming a pattern with a high aspect ratio on an uneven substrate. There have been developed: a two-layer resist method in which a photoresist layer made of a silicon-containing photosensitive polymer is combined with an underlayer made of an organic polymer containing carbon, hydrogen, and oxygen as main constituent elements, for example, a novolak polymer (Patent Document 1); and a three-layer resist method in which a photoresist layer made of an organic photosensitive polymer used in a monolayer resist method is combined with a middle layer made of a silicon-based polymer or a silicon-based CVD film, and an underlayer made of an organic polymer (Patent Document 2).

In the three-layer resist method, for example, an organic film made of a novolak or the like is formed uniformly as a resist underlayer film on a substrate to be processed; a silicon-containing resist middle layer film is formed thereon as a resist middle layer film; and an ordinary organic photoresist film is formed thereon as a resist upper layer film. In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma. According to this method, the pattern can be transferred to the silicon-containing resist middle layer film even when using a resist composition that causes difficulties in forming a pattern having a sufficient film thickness for directly processing the substrate to be processed or when using a resist composition that does not have sufficient dry etching resistance for processing the substrate. In addition, by subsequently transferring the pattern by dry etching with an oxygen-based gas plasma, it is possible to obtain a pattern in an organic film (e.g. a resist underlayer film such as a novolak film) having sufficient dry etching resistance for processing.

Many techniques are already known (e.g. Patent Document 3) regarding organic underlayer films like the organic underlayer film described above. However, in association with recent progress in miniaturization, the need for excellent filling property in addition to dry etching property is rising. There is a demand for an organic underlayer film material that enables uniform film formation even on an underlying substrate to be processed having a complex form or any material, and that has a filling property that allows a required pattern to be filled without gaps.

When a semiconductor substrate or the like is manufactured, the above-described organic underlayer film is formed using a coater/developer that can perform treatments such as spin-coating process, EBR process, and baking process. An EBR (Edge Bead Removal) process is a process of removing, after forming a film on a substrate (wafer) by spin-coating, the film on the edge of the substrate with a remover for the purpose of preventing the contamination of a substrate-conveying arm of the coater/developer. For example, a mixed solution of propylene glycol monomethyl ether acetate and propylene glycol monomethyl ether (30 mass%:70 mass%) is a remover used in EBR processes, and such removers are widely used in EBR processes of resist films, resist underlayer films (e.g. organic underlayer films), and resist middle layer films (e.g. silicon-containing resist middle layer films).

Due to the effect of a remover in an EBR process, a state where a peripheral portion of an organic underlayer film has a thick film thickness (a hump) occurs in some cases. In the above-described dry etching step at the time of substrate processing, a hump causes defects, and therefore, an organic underlayer film in which a hump is suppressed is desired.

Furthermore, after forming the spin-coating film, the organic underlayer film is baked to form a cured film in order to use in a multilayer resist process. This is because it is necessary to achieve an insoluble and infusible organic underlayer film for applying a silicon-containing resist middle layer film thereon. On the surface of an organic film formed by baking, a hydrophobic surface caused by a surfactant contained in the composition for forming an organic film is formed, and induces coating abnormality of the silicon-containing resist middle layer film in some cases. To improve the coating property of the silicon-containing resist middle layer film and widen the process margin, the contact angle of the surface of the organic underlayer film is required to be controlled.

### CITATION LIST

### PATENT LITERATURE

Patent Document 1: JP H6-118651 A
Patent Document 2: JP 2005-128509 A
Patent Document 3: JP 2004-205685 A

### SUMMARY OF INVENTION

### TECHNICAL PROBLEM

The present invention has been made in view of the above-described circumstances. An object of the present invention is to provide: a composition for forming an organic film which is excellent in film-formability (in-plane uniformity) on a substrate (wafer) and filling property, is excellent in suppressing humps in an EBR process, and furthermore, makes it possible to form an organic film having an excellent process margin when used as an organic film for a multilayer resist; a method for forming an organic film, using the composition; and a patterning process using the composition.

### SOLUTION TO PROBLEM

To achieve the object, the present invention provides a composition for forming an organic film, comprising:
(A) a resin or compound for forming an organic film;
(B) a fluorine-containing compound represented by the following general formula (1); and
(C) a solvent, 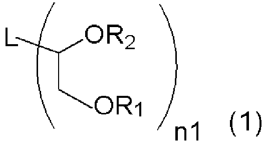
   wherein L represents a single bond or an n1-valent organic group having 1 to 50 carbon atoms, R₁ represents a saturated or unsaturated monovalent organic group having 1 to 20 carbon atoms, the organic group R₁ having at least one fluorine-containing structure represented by any of the following formulae (2), R₂ represents a hydrogen atom or a monovalent organic group having 1 to 30 carbon atoms, and "n1" represents an integer of 2 to 8, 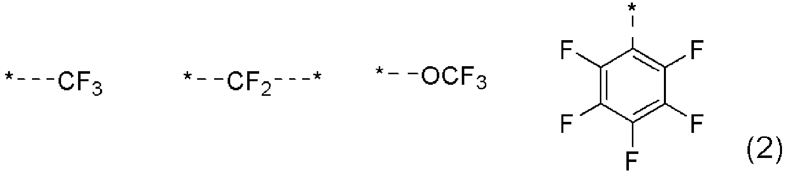
   wherein "*" represents an attachment point in the organic group represented by the R₁, the organic group R₁ optionally having two or more kinds among the structures represented by the formulae (2), or optionally having two or more identical structures.

Such a composition for forming an organic film is excellent in in-plane uniformity and filling property and makes it possible to form an organic film in which the formation of a hump due to the effect of a remover in an EBR process has been suppressed. Furthermore, by introducing, as a partial structure, a structure having multiple fluorine atoms into the fluorine-containing compound (B), the fluorine-containing compound (B) volatilizes from the surface of the organic film by virtue of the baking at the time of cured-film formation in a case where an organic underlayer film is formed, and the compound is removed from inside the film. Therefore, the composition for forming an organic film makes it possible to form an organic film excellent in the coating property of a silicon-containing middle layer film on the organic film and has an excellent process margin.

The R₁ in the general formula (1) preferably has a structure represented by any of the following general formulae (3), 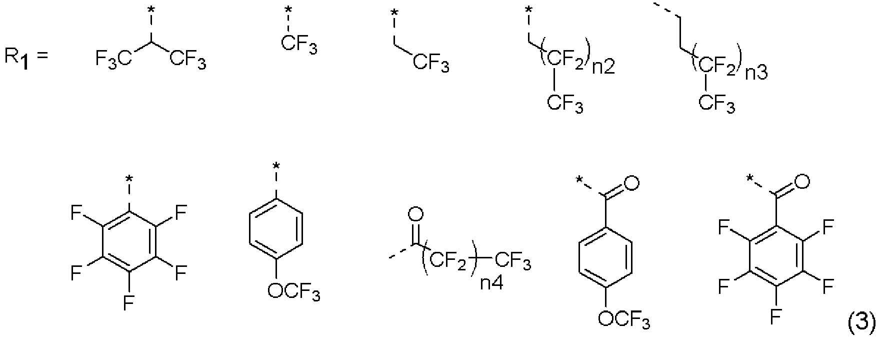 wherein "*" represents an attachment point in the organic group represented by the R₁; and "n2", "n3", and "n4" each represent an integer of 1 to 10.

A composition for forming an organic film containing a fluorine-containing compound (B) including such a partial structure has an appropriate fluorine content, and therefore, makes it possible to improve film-formability at the time of application and control the volatility during baking in an appropriate temperature range.

The L in the general formula (1) is preferably an organic group represented by any of the following general formulae (4), 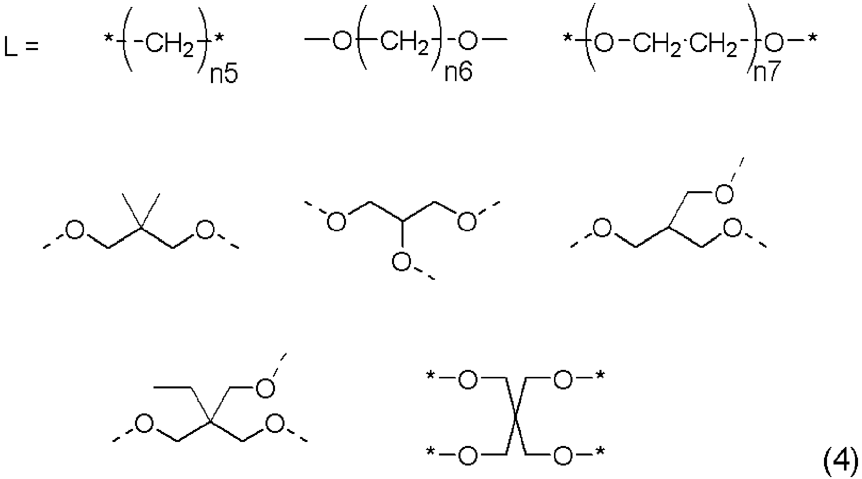 wherein "*" represents an attachment point to a terminal structure including the OR₁ and the OR₂; and "n5", "n6", and "n7" each represent an integer of 1 to 10.

According to a composition for forming an organic film containing a compound having the organic group L having such a structure, there is no risk of the in-plane uniformity of the film being degraded by decomposed products generated during baking, and there is no risk of insoluble components being formed by a reaction between decomposed products or the like. Therefore, the process margin does not become narrowed when the composition is used for an organic underlayer film, and inconvenience, such as equipment contamination, does not arise either.

The R₂ in the general formula (1) is preferably a hydrogen atom.

A composition for forming an organic film containing a compound having such a structure contains a hydroxy group, which is hydrophilic, and therefore, it is possible to control the surface active effect of the compound and prevent film formation failure that occurs when applying the composition for forming an organic film and forming an organic film.

The fluorine-containing compound (B) represented by the general formula (1) preferably has a weight-average molecular weight of 300 to 1500.

When the fluorine-containing compound (B) is contained in such a range of weight-average molecular weight, it is possible to form an organic film excellent in film-formability and filling property with more certainty. Furthermore, the contact angle of the film surface after film formation can be controlled to be in an appropriate range, and it is possible to form an organic underlayer film further suitable for use in a multilayer resist process.

The fluorine-containing compound (B) represented by the general formula (1) preferably satisfies 1.00 ≤ Mw/Mn ≤ 1.10, where Mw is a weight-average molecular weight and Mn is a number-average molecular weight measured by gel permeation chromatography in terms of polystyrene.

When the composition contains a fluorine-containing compound (B) in which the ratio of the weight-average molecular weight Mw to the number-average molecular weight Mn is within the above-described range, it is possible to form certainly an excellent organic film without generating foreign substances that cause film formation failure or defects after film formation.

The fluorine-containing compound (B) is preferably contained in an amount of 0.01 parts by mass to 5 parts by mass based on 100 parts by mass of the resin or compound (A) for forming an organic film.

A composition for forming an organic film containing the fluorine-containing compound (B) in such an amount allows better in-plane uniformity in a formed organic film, and is therefore preferable.

The present invention also provides a method for forming an organic film to be used in a manufacturing process of a semiconductor device, the method comprising:
spin-coating a substrate to be processed with the inventive composition for forming an organic film to obtain a coating film; and
forming a cured film by heating the coating film at a temperature of 100°C or higher and 600°C or lower for 10 to 600 seconds.

The inventive composition for forming an organic film makes it possible to fill sufficiently a pattern having a complicated shape on a substrate to be processed by spin-coating, and form an organic film having excellent in-plane uniformity. Therefore, the inventive composition for forming an organic film is particularly useful when the organic film on an edge portion is removed while suppressing humps in an EBR process.

The present invention also provides a patterning process comprising:
forming an organic underlayer film on a body to be processed by using the inventive composition for forming an organic film;
forming a resist middle layer film on the organic underlayer film by using a resist middle layer film material containing a silicon atom;
forming a resist upper layer film on the resist middle layer film by using a resist upper layer film material comprising a photoresist composition;
forming a circuit pattern in the resist upper layer film;
transferring the pattern to the resist middle layer film by etching while using the resist upper layer film having the formed circuit pattern as a mask;
transferring the pattern to the organic underlayer film by etching while using the resist middle layer film having the transferred pattern as a mask; and
further transferring the pattern to the body to be processed by etching while using the organic underlayer film having the transferred pattern as a mask.

The present invention also provides a patterning process comprising:
forming an organic underlayer film on a body to be processed by using the inventive composition for forming an organic film;
forming a resist middle layer film on the organic underlayer film by using a resist middle layer film material containing a silicon atom;
forming an organic antireflective film or an adhesive film on the resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the resist middle layer film by etching while using the resist upper layer film having the formed circuit pattern as a mask;
transferring the pattern to the organic underlayer film by etching while using the resist middle layer film having the transferred pattern as a mask; and
further transferring the pattern to the body to be processed by etching while using the organic underlayer film having the transferred pattern as a mask.

The present invention also provides a patterning process comprising:
forming an organic underlayer film on a body to be processed by using the inventive composition for forming an organic film;
forming an inorganic hard mask selected from the group consisting of a silicon oxide film, a silicon nitride film, and a silicon oxynitride film on the organic underlayer film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic underlayer film by etching while using the inorganic hard mask having the transferred pattern as a mask; and
further transferring the pattern to the body to be processed by etching while using the organic underlayer film having the transferred pattern as a mask.

The present invention also provides a patterning process comprising:
forming an organic underlayer film on a body to be processed by using the inventive composition for forming an organic film;
forming an inorganic hard mask selected from the group consisting of a silicon oxide film, a silicon nitride film, and a silicon oxynitride film on the organic underlayer film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic underlayer film by etching while using the inorganic hard mask having the transferred pattern as a mask; and
further transferring the pattern to the body to be processed by etching while using the organic underlayer film having the transferred pattern as a mask.

As described, the inventive composition for forming an organic film can be used suitably in various patterning processes such as a three-layer resist process using a silicon-containing resist middle layer film or an inorganic hard mask and a four-layer resist process additionally using an organic antireflective film. According to such patterning processes of the present invention, it is possible to transfer and form a circuit pattern of a resist upper layer film in a body to be processed with high accuracy.

The inorganic hard mask is preferably formed by a CVD method or an ALD method.

In the inventive patterning process, the inorganic hard mask can be formed by such methods, for example.

The circuit pattern is preferably formed by a lithography using light having a wavelength of 10 nm or more and 300 nm or less, a direct writing with electron beam, nanoimprinting, or a combination thereof.

The circuit pattern is preferably developed with an alkaline development or an organic solvent.

In the inventive patterning process, such means of forming and developing the circuit pattern can be used suitably.

The body to be processed is preferably a semiconductor device substrate or the semiconductor device substrate coated with any of a metal film, a metal carbide film, a metal oxide film, a metal nitride film, a metal oxycarbide film, and a metal oxynitride film.

The metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning process, such a body to be processed can be processed to form a pattern.

### ADVANTAGEOUS EFFECTS OF INVENTION

As described above, the inventive composition for forming an organic film makes it possible to provide a composition for forming an organic film having excellent film-formability (in-plane uniformity) on a substrate (wafer) and excellent filling property, and being excellent in the film-formability of a middle layer film on the organic film when used for an organic underlayer film and in hump suppression at the time of an EBR process. Because the inventive composition for forming an organic film is thus excellent in film-formability, filling property, the property of suppressing humps that are generated during an EBR process, and film-formability, that is, the process margin of a middle layer film on the organic film when used for an organic underlayer film, the inventive composition for forming an organic film is extremely useful as: for example, an organic underlayer film material used in multilayer resist processes, such as a two-layer resist process, a three-layer resist process using a silicon-containing resist middle layer film or an inorganic hard mask, or a four-layer resist process using a silicon-containing resist middle layer film or inorganic hard mask and an organic antireflective film; or for forming an organic film for manufacturing a semiconductor device. In addition, according to the inventive method for forming an organic film, it is possible to form an organic film in which humps have been suppressed, and therefore, semiconductor devices and so forth can be manufactured efficiently.

### BRIEF DESCRIPTION OF DRAWINGS

FIG. 1 is an explanatory diagram of an example of the inventive patterning process according to a three-layer resist process.
FIG. 2 is an example of a graph on measuring the height of a hump by using a stylus profiler in Example 2.
FIG. 3 is an example of a graph on measuring the height of a hump by using a stylus profiler in Comparative Example 2.
FIG. 4 is an explanatory diagram of a filling property evaluation method in the Examples.

### DESCRIPTION OF EMBODIMENTS

As described above, there has been required the development of a composition for forming an organic film that has excellent film-formability (in-plane uniformity) on a substrate (wafer) and excellent filling property, and that can form an organic film in which humps generated in an EBR process have been suppressed.

Usually, when an organic film is to be formed, a resin for forming an organic film and additives are dissolved in an organic solvent to form a composition, the composition is applied with a coater and a developer onto a substrate on which a structure, a circuit, etc. is formed, the composition is spread by the substrate rotating, the composition on the edge is removed in an EBR process, and then the composition is baked to form an organic film.

It is thought that if the flowability of the composition is insufficient, gaps are generated when a hole or trench having a very high aspect ratio is filled, and in addition, a hump is generated in the periphery of the organic film if the resin for forming an organic film or the additives have poor solubility in the remover used in the EBR process.

The present inventors have further studied earnestly and found out that when a compound having a particular substituent is contained in a composition for forming an organic film, the composition has both excellent film-formability and high filling property and allows excellent hump suppression property during an EBR process. Thus, the present invention has been completed.

That is, the present invention is a composition for forming an organic film, comprising:
(A) a resin or compound for forming an organic film;
(B) a fluorine-containing compound represented by the following general formula (1); and
(C) a solvent, 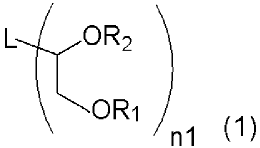
   wherein L represents a single bond or an n1-valent organic group having 1 to 50 carbon atoms, R₁ represents a saturated or unsaturated monovalent organic group having 1 to 20 carbon atoms, the organic group R₁ having at least one fluorine-containing structure represented by any of the following formulae (2), R₂ represents a hydrogen atom or a monovalent organic group having 1 to 30 carbon atoms, and "n1" represents an integer of 2 to 8, 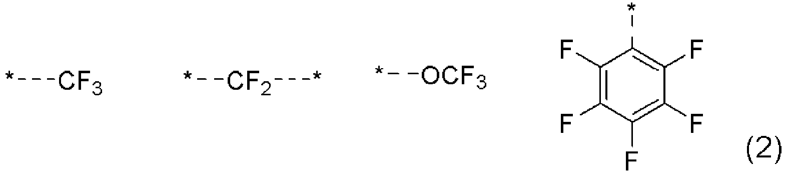
   wherein "*" represents an attachment point in the organic group represented by the R₁, the organic group R₁ optionally having two or more kinds among the structures represented by the formulae (2), or optionally having two or more identical structures.

Hereinafter, the present invention will be described in detail, but the present invention is not limited thereto.

### [Composition for Forming Organic Film]

The inventive composition for forming an organic film contains: (A) a resin or compound for forming an organic film; (B) a fluorine-containing compound represented by the general formula (1); and (C) a solvent. The inventive composition for forming an organic film is, for example, for forming: an organic film for a multilayer resist for fine processing in manufacturing semiconductor devices or the like; and organic films for planarization in manufacturing semiconductor devices or the like.

Note that, in the inventive composition for forming an organic film, as each of the fluorine-containing compound (B), the resin or compound (A) for forming an organic film, and the solvent (C), one kind may be contained or a combination of two or more kinds may be contained.

In the following, the fluorine-containing compound (B), which is a feature of the inventive composition for forming an organic film, will be described in more detail first. Subsequently, other components of the inventive composition for forming an organic film will be described.

### [Fluorine-Containing Compound (B)]

The fluorine-containing compound (B) contained in the inventive composition for forming an organic film is a compound represented by the following general formula (1).

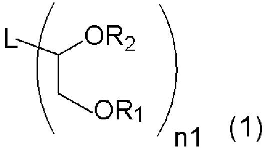

In the formula, L represents a single bond or an n1-valent organic group having 1 to 50 carbon atoms, R₁ represents a saturated or unsaturated monovalent organic group having 1 to 20 carbon atoms, the organic group R₁ having at least one structure including fluorine represented by any of the following formulae (2), R₂ represents a hydrogen atom or a monovalent organic group having 1 to 30 carbon atoms, and "n1" represents an integer of 2 to 8. 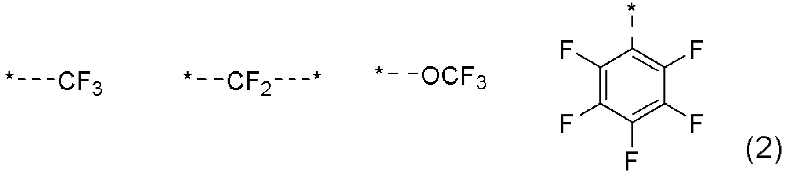 "*" represents an attachment point in the organic group represented by the R₁, the organic group R₁ optionally having two or more kinds among the structures represented by the formulae (2), or optionally having two or more identical structures.

The fluorine-containing compound (B) contained in the inventive composition for forming an organic film is a compound having a low-molecular-weight structure and having multiple fluorine-substituted groups, and becomes a volatilized product by decomposing or subliming due to heat or the like. For example, if a high-molecular-weight polymer is used, such a polymer generally has lower volatility and sublimability than low-molecular-weight compounds, and therefore, the polymer or the decomposed product remains in the film or on the surface of the film at the time of baking. If such a polymer is used as a material for forming an organic underlayer film, the polymer affects etching resistance, the coating property of a silicon-containing middle layer film to be formed on the organic underlayer film, etc. The fluorine-containing compound (B) contained in the inventive composition for forming an organic film has been designed not to affect physical properties of the film by virtue of sublimability or decomposition caused by heat. This is achieved by designing the terminal substituent structure appropriately by introducing an appropriate fluorine structure to reduce the intermolecular force between the compounds so that the compound does not remain on the film surface or in the film due to a heat treatment.

Furthermore, the fluorine-containing compound (B) contained in the inventive composition for forming an organic film has a function as a surfactant, and by introducing multiple substituents each including an appropriate fluorine-containing structure into a terminal structure of the compound, it is possible to impart a function as a surfactant that has the ability to reduce surface tension and brings about excellent uniform coatability (leveling property) of an organic film. Accordingly, the inventive composition for forming an organic film, containing such a fluorine-containing compound (B), can be used suitably not only for organic underlayer films, but also for common organic film materials, for example, coating materials for photolithography in general (photosensitive resist materials, materials for forming a top coat to be formed on a resist film, etc.). Furthermore, such a fluorine-containing compound (B) is applicable not only to materials for forming an organic film, but also to silicon-containing resist underlayer films, and can be used as a surfactant suitable for realizing film-formability that is highly versatile and is applicable to various materials for forming a film.

That is, in the inventive composition for forming an organic film, the fluorine-containing compound (B) functions as a surfactant that imparts excellent film-formability and high leveling property. Uses of the compound are not limited to organic underlayer films, and the compound can be used for coating materials for photolithography in general. Examples of uses include photosensitive resist materials and materials for forming a top coat to be formed on a resist film.

Note that, in the inventive composition for forming an organic film, one kind of the fluorine-containing compound (B) may be used, or two or more kinds thereof may be used in combination. These compounds are preferably contained in such an amount that the fluorine-containing compound (B) is contained in an amount of 0.01 parts by mass to 5 parts by mass based on 100 parts by mass of the resin or compound (A) for forming an organic film. When the contained amount is as described, the formed organic film can achieve better in-plane uniformity.

Examples of the fluorine-containing compound (B) of the general formula (1) include the following. In the following formulae, R₁ and R₂ are as defined above.

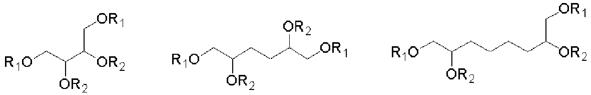

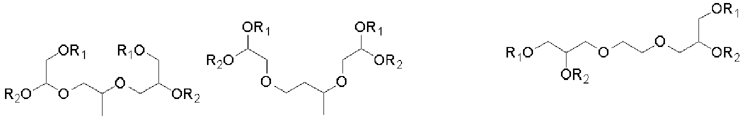

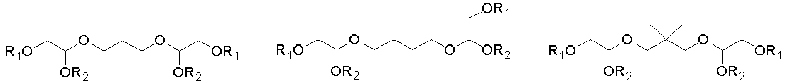

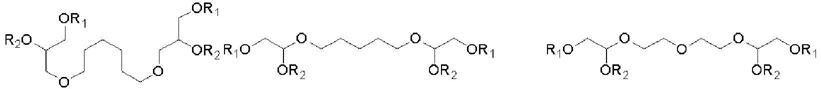

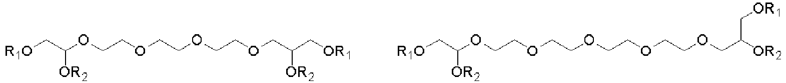

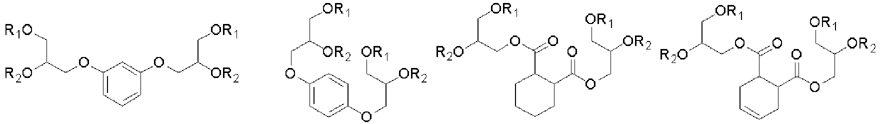

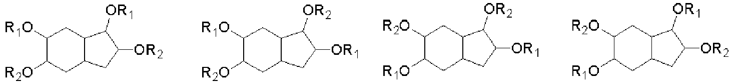

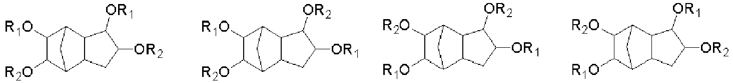

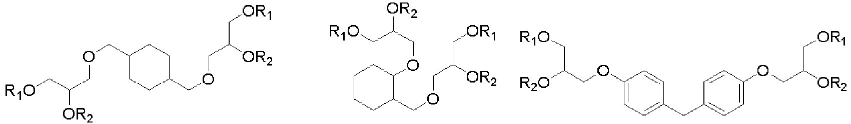

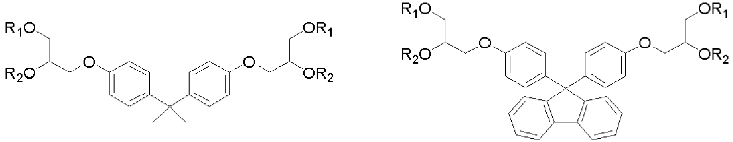

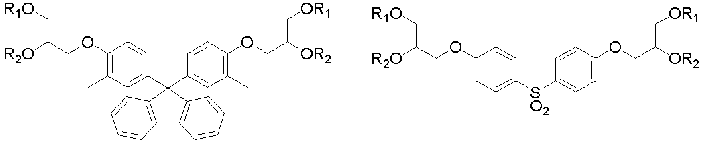

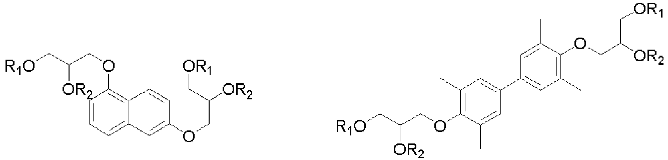

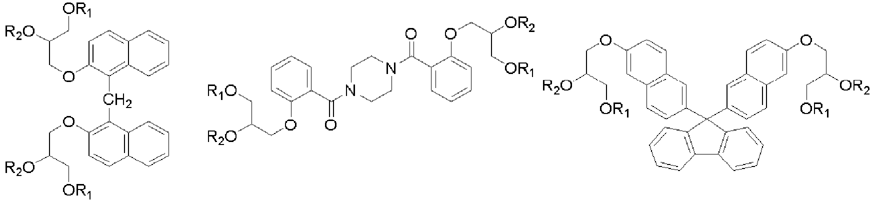

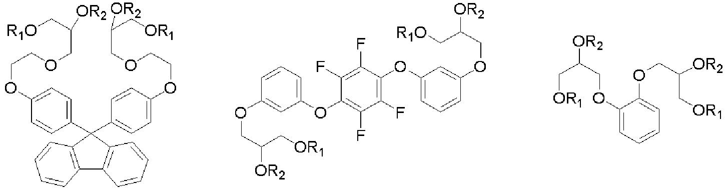

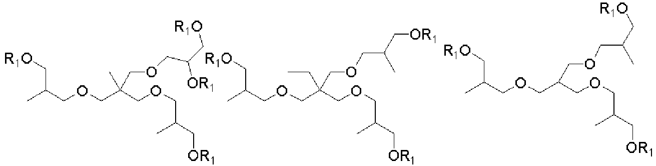

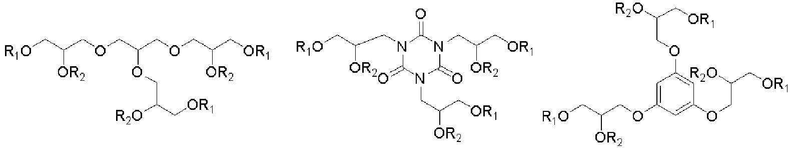

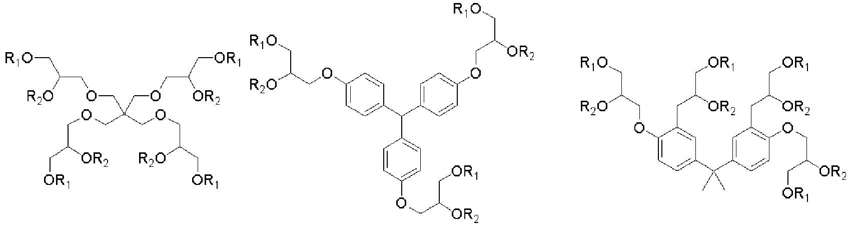

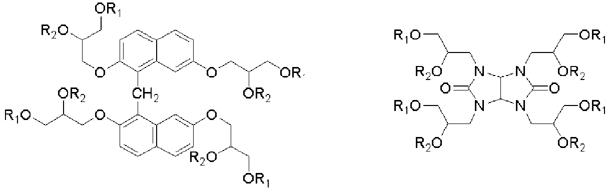

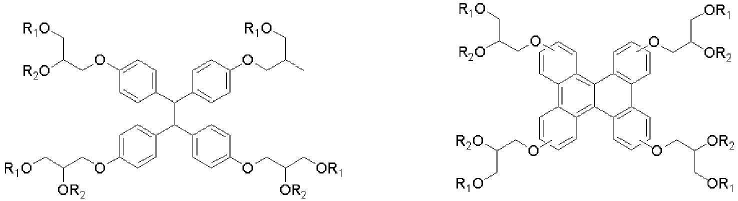

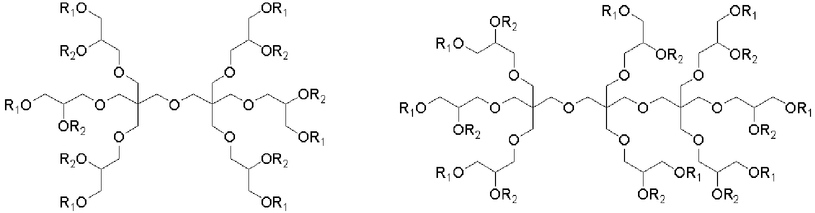

Among the examples, the structures in which the organic group L does not contain an aromatic ring are preferable from the viewpoint of enhancing thermal decomposability, and structures not having nitrogen are preferable from the viewpoint of surface active property. As examples that satisfy these conditions, those having a structure linked by a glyme chain of the following general formulae (4) or an alkylene group as the organic group (linking group) L and so forth are preferable. 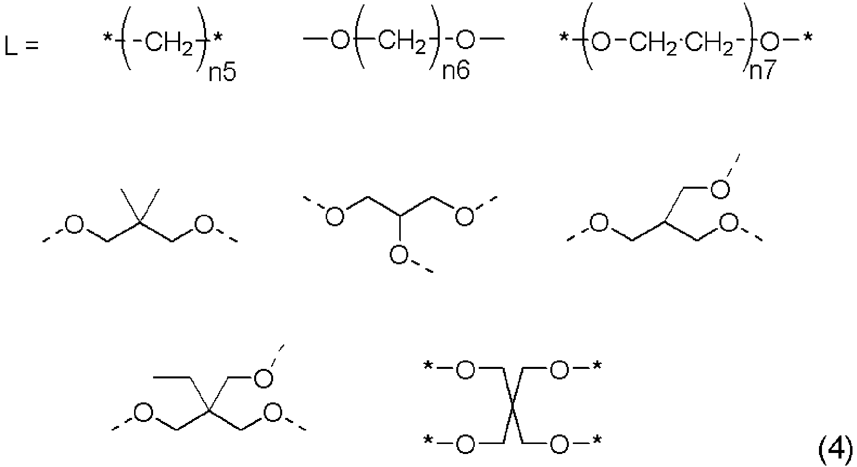 "*" represents an attachment point to a terminal structure including the OR₁ and the OR₂; and "n5", "n6", and "n7" each represent an integer of 1 to 10.

The R₁ in the general formula (1) represents a saturated or unsaturated monovalent organic group having 1 to 20 carbon atoms, the organic group R₁ having at least one fluorine-containing structure represented by any of the formulae (2). Specific examples of substituents having at least one structure represented by any of the general formulae (2) include the following. "n1" represents an integer of 2 to 8, and "n2", "n3", and "n6" to "n9" each represent an integer of 1 to 10.

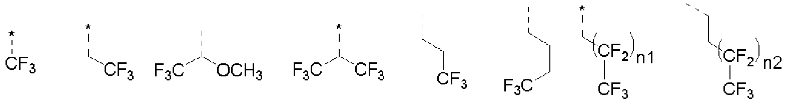

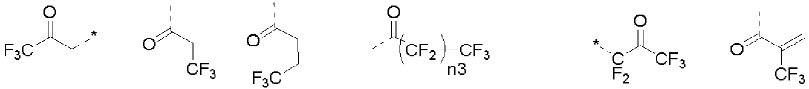

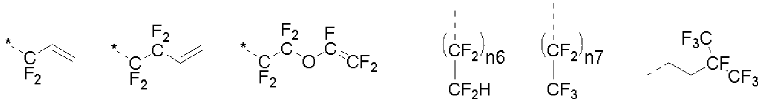

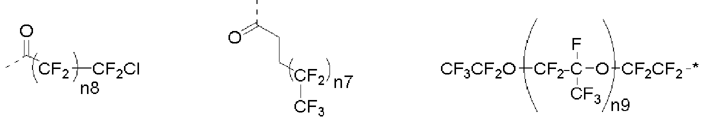

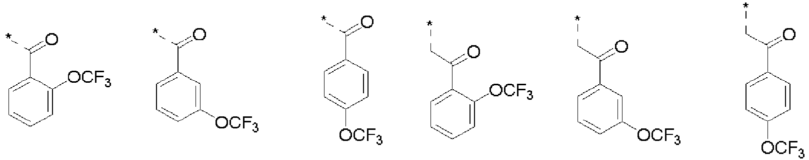

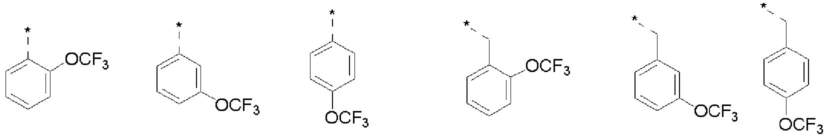

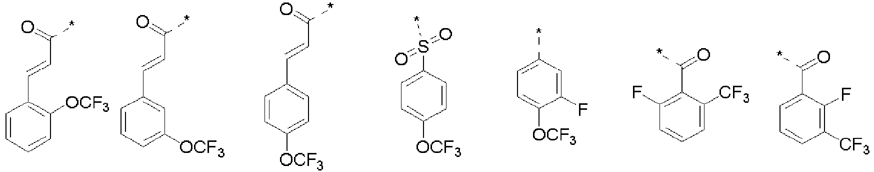

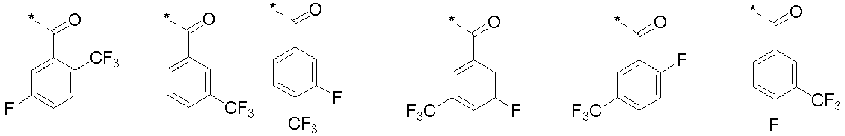

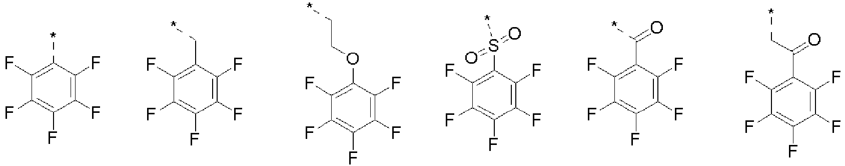

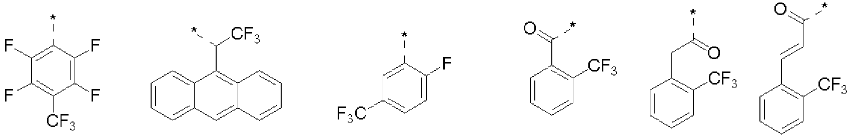

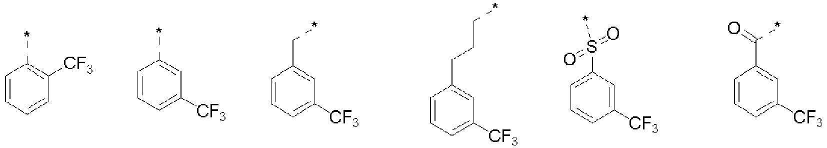

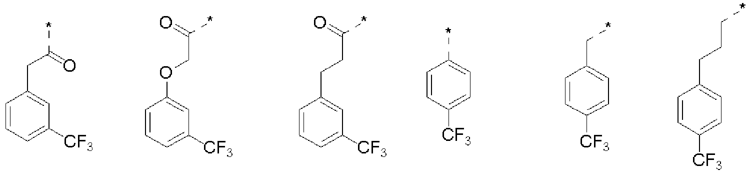

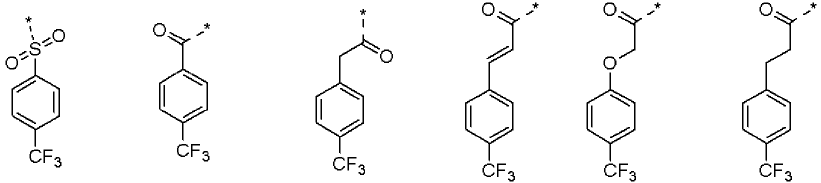

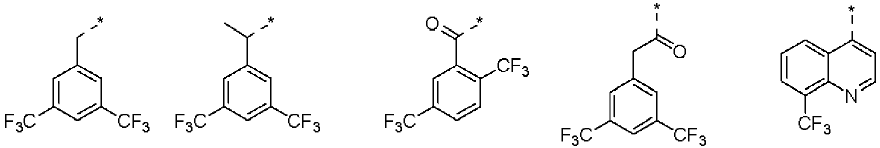

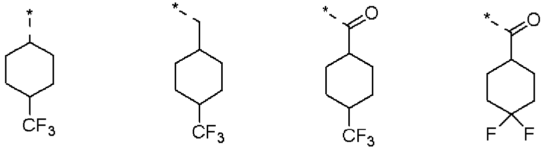

Among the examples, those in which the R₁ has a structure represented by any of the following general formulae (3) are preferable from the viewpoint of surface active property. When a compound (B) having any of these structures is contained, enhancement of film-formability can be expected by virtue of a fluorine structure being introduced with an appropriate fluorine content. In particular, those having trifluoromethoxy benzene are more preferable from the viewpoint of not only surface active effect, but also reducing the environmental impact of the compound having a fluorine structure. 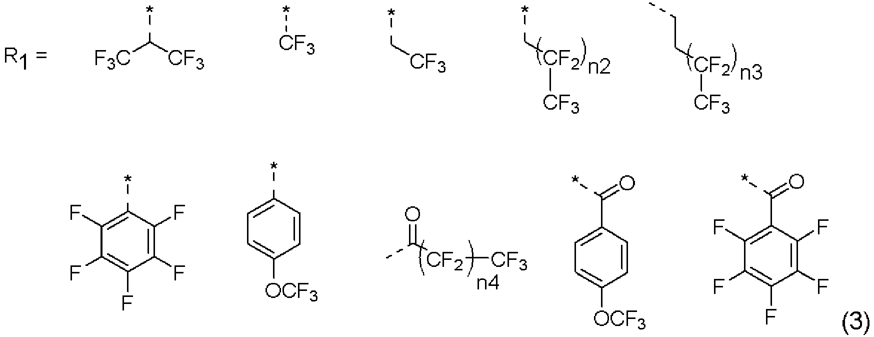 "*" represents an attachment point in the organic group represented by the R₁; and "n2", "n3", and "n4" each represent an integer of 1 to 10.

A composition for forming an organic film containing a fluorine-containing compound (B) including such a partial structure has an appropriate fluorine content, and therefore, makes it possible to improve film-formability at the time of application and control the volatility during baking in an appropriate temperature range.

The R₂ in the general formula (1) represents a hydrogen atom or a monovalent organic group having 1 to 30 carbon atoms, and specific examples include the following. In the following formulae, "n3" represents an integer of 0 to 28, "n7" represents an integer of 0 to 26, "n8" represents an integer of 0 to 28, "n10" represents an integer of 0 to 28, and "n11" represents an integer of 0 to 24.

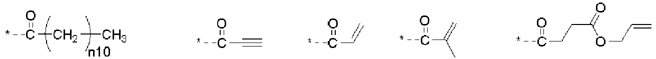

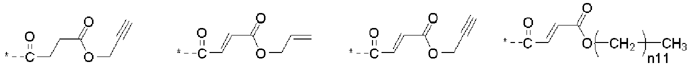

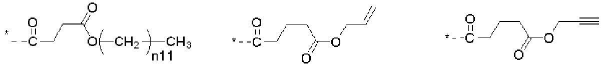

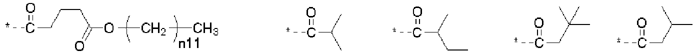

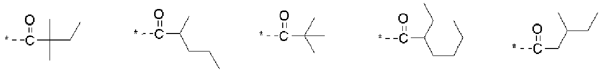

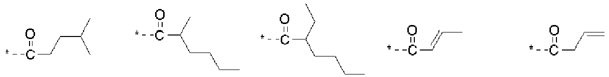

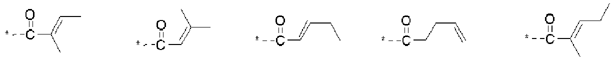

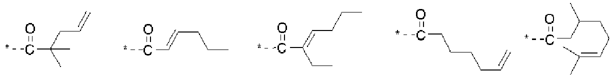

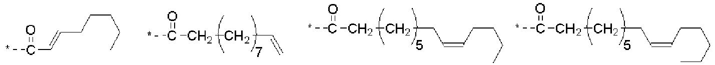

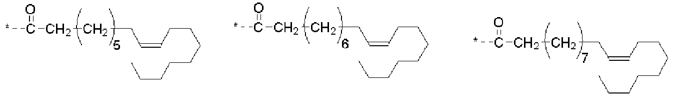

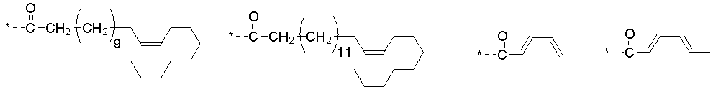

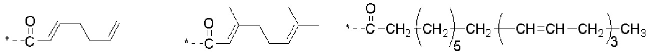

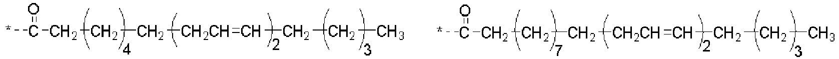

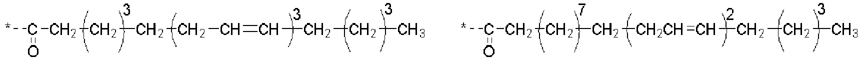

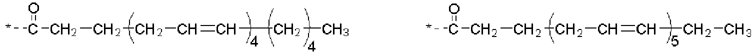

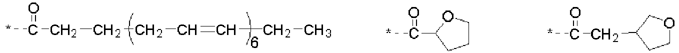

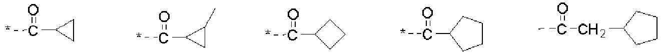

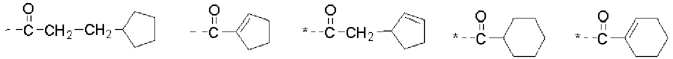

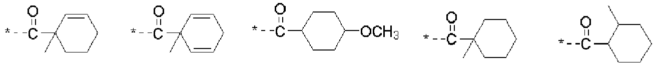

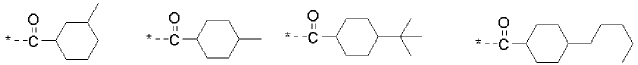

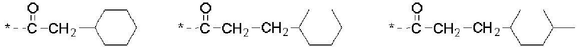

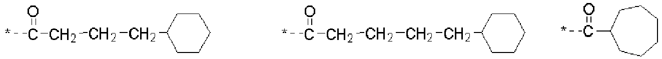

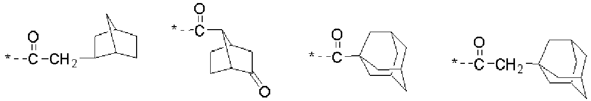

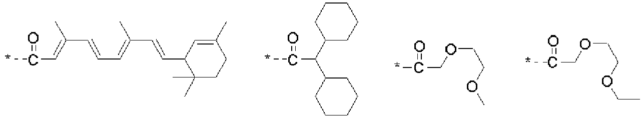

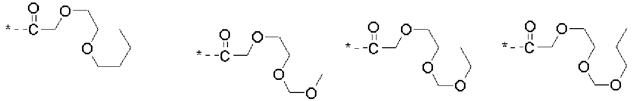

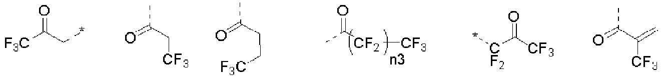

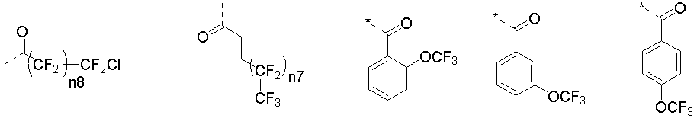

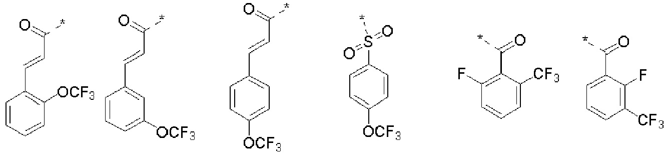

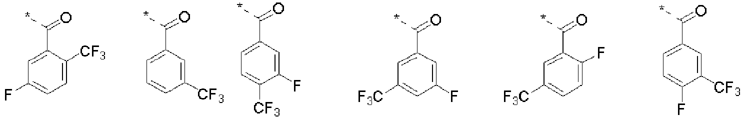

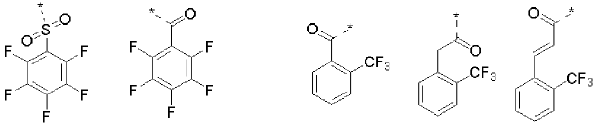

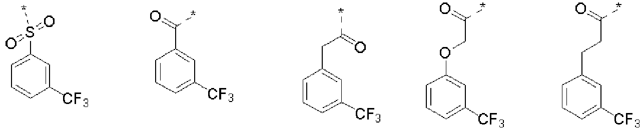

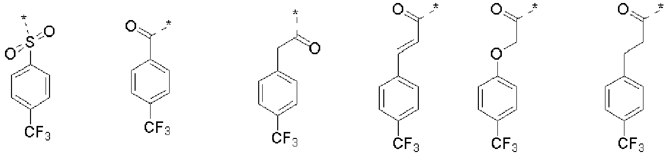

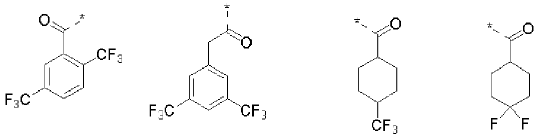

"*" represents an attachment point in the organic group represented by the R₂.

Among the above, those in which the R₂ is a hydrogen atom or has a partial structure shown below is preferable from the viewpoint of imparting a surface active effect, and the R₂ is more preferably a hydrogen atom from the viewpoint of affinity to an organic solvent.

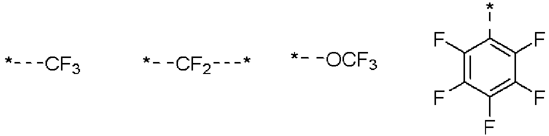

When a fluorine-containing compound (B) having a structure shown above is contained, thermal decomposability, sublimability, surface active effect, and flowability can be adjusted, and a composition having excellent film-formability, high filling property, etc. can be achieved.

The fluorine-containing compound (B) preferably has a weight-average molecular weight of 300 to 1500. When the weight-average molecular weight is 300 or more, it is possible to suppress the degradation of a blending effect due to volatilization or the like, and a sufficient blending effect can be achieved. Meanwhile, when the weight-average molecular weight is 1500 or less, the compound can be prevented from remaining in the film, and an organic film having an even better process margin can be formed. Furthermore, the weight-average molecular weight is preferably 1000 or less. When the weight-average molecular weight is 1000 or less, it is possible further to reduce the risk of the surfactant remaining in the film.

The fluorine-containing compound (B) preferably satisfies 1.00 ≤ Mw/Mn ≤ 1.10, where Mw is a weight-average molecular weight and Mn is a number-average molecular weight measured by gel permeation chromatography in terms of polystyrene.

Normally, in the case of a single compound, the ratio Mw/Mn is 1.00 in theory. However, taking into consideration the fact that, for example, multiple kinds of structures of the organic group R₁ and multiple kinds of structures of the group R₂ may be contained in combination in the fluorine-containing compound (B) contained in the inventive composition for forming an organic film, and that physical properties, such as the polarity, of the compound and errors in measurement conditions, such as the temperature and pressure of the column, in gel permeation chromatography have an effect on the separation performance of the compound, it is difficult strictly to achieve Mw/Mn of 1.00 even in the case of a single compound. Therefore, for distinction from a compound having a distribution in the ratio Mw/Mn, the above-described range is defined as an index indicating monomerism.

### [Method for Manufacturing Fluorine-Containing Compound (B)]

The fluorine-containing compound (B), having the structure represented by the general formula (1), can be manufactured by selecting the optimum method depending on the structure. For example, when the group R₂ is a hydrogen atom, the fluorine-containing compound (B) can be obtained by an addition reaction (STEP 1) between: an epoxy compound having the organic group L as a partial structure; and a compound having an organic group R₁ as a partial structure and having a hydroxy group. Alternatively, when the group R₂ is not a hydrogen atom, the fluorine-containing compound (B) can be obtained by performing, after the addition reaction (STEP 1), an acylation reaction (STEP 2) by an acylating agent, corresponding to the subsequent introduction of the organic group R₂. Examples of the compound having a hydroxy group include carboxylic acids, alcohols, and phenols. Meanwhile, examples of the acylating agent include acid anhydrides and acid chlorides.

The R₁ and the R₂ in the following formulae are each as defined above.

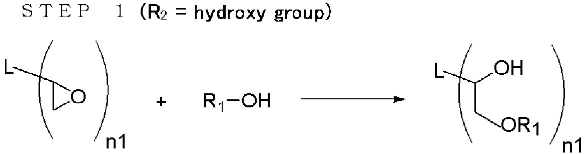

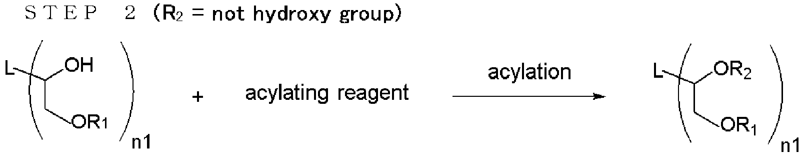

In the reaction between an epoxy compound and a compound having a hydroxy group shown in the above-described STEP 1, the amount of the compound having a hydroxy group to be charged is preferably 0.3 to 4.0 mol, more preferably 0.5 to 2.0 mol, and further preferably 0.75 to 1.25 mol when the molar quantity of the epoxy in the epoxy compound is considered as 1 mol. When the charged amount of the compound having a hydroxy group relative to that of the epoxy unit is within the above-described preferable ranges, unreacted epoxy groups can be prevented from remaining, and storage stability can be guaranteed. In addition, when the charged amount of the compound having a hydroxy group relative to that of the epoxy unit is within the above-described preferable ranges, unreacted compounds having hydroxy groups can be prevented from remaining in the system, and the problem of outgassing can be avoided.

Furthermore, it is also possible to use another compound having, as a light-absorbing group of ultraviolet light, a hydroxy group and a group other than the organic group R₁ for improving antireflective performance and improving solvent solubility. Examples of such other compounds include: aliphatic carboxylic acids, such as formic acid, acetic acid, propionic acid, palmitic acid, and stearic acid; alicyclic carboxylic acids, such as cyclohexanecarboxylic acid and norbornenecarboxylic acid; aromatic carboxylic acids, such as benzoic acid, naphthalenecarboxylic acid, and anthracenecarboxylic acid; alcohols, such as methanol, ethanol, and benzyl alcohol; and phenols, such as phenol and naphthol. The charged amount of the other compounds is preferably 0.1 to 50 mol%, more preferably 1 to 30 mol% relative to the total amount of compounds having a hydroxy group charged.

A compound synthesized from the above-described starting materials can normally be obtained by allowing a reaction between an epoxy compound and a compound having a hydroxy group in a solvent or in a solvent in the presence of a reaction catalyst at room temperature or, as necessary, under cooling or heating.

Examples of the solvent used include: alcohols, such as methanol, ethanol, isopropyl alcohol, butanol, ethylene glycol, propylene glycol, diethylene glycol, glycerol, methyl cellosolve, ethyl cellosolve, butyl cellosolve, propylene glycol monomethyl ether, and diacetone alcohol; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; lactones, such as γ-butyrolactone; and aprotic polar solvents, such as dimethyl sulfoxide, N,N-dimethylformamide, and hexamethylphosphoric triamide. One of these solvents may be used, or a mixture of two
or more kinds thereof may be used. These solvents can be used, for example, in an amount of 0 to 2000 parts by mass based on 100 parts by mass of the reaction starting materials.

Examples of the reaction catalyst include quaternary ammonium salts, such as benzyltriethylammonium chloride, benzyltriethylammonium bromide, benzyltrimethylammonium chloride, tetramethylammonium chloride, tetramethylammonium bromide, tetramethylammonium iodide, tetramethylammonium hydroxide, tetraethylammonium bromide, tetrabutylammonium chloride, tetrabutylammonium bromide, tetrabutylammonium iodide, tetrabutylammonium hydrogen sulfate, trioctylmethylammonium chloride, tributylbenzylammonium chloride, trimethylbenzylammonium chloride, trimethylbenzylammonium hydroxide, N-laurylpyridinium chloride, N-lauryl-4-picolinium chloride, N-laurylpicolinium chloride, trimethylphenylammonium bromide, and N-benzylpicolinium chloride; quaternary phosphonium salts, such as tetrabutylphosphonium chloride, tetrabutylphosphonium bromide, and tetraphenylphosphonium chloride; tertiary amines, such as tris[2-(2-methoxyethoxy)ethyl]amine, tris(3,6-dioxaheptyl)amine, and tris(3,6-dioxaoctyl)amine; potassium tert-butoxide; sodium hydride; etc. The amount of the catalyst to be used can be in a range of 0.001 to 100 weight%, preferably 0.005 to 50 weight%, with respect to the raw materials. The reaction temperature is preferably about -50°C to the boiling point of the solvent, more preferably room temperature to 150°C. The reaction time is appropriately selected within a range of 0.1 to 100 hours.

The reaction method is not limited, and examples include: a method in which an epoxy compound, a compound having a hydroxy group, and a catalyst are charged at once; a method in which an epoxy compound and a compound having a hydroxy group are dispersed or dissolved in a solvent, and then a catalyst is added at once thereto or diluted with a solvent and added dropwise thereto; and a method in which a catalyst is disepersed or dissolved in a solvent, and then an epoxy compound and a compound having a hydroxy group are added at once thereto or diluted with a solvent and added dropwise thereto. After completion of the reaction, the reaction product may be directly used without purification etc., or the reaction product may be diluted with an organic solvent and then subjected to liquid-liquid separation washing to remove unreacted raw materials, the catalyst, and so forth present in the system, and thus, a high-purity product can be collected.

The organic solvent used in the purification is not particularly limited, as long as it is capable of dissolving the reaction product and being separated, when mixed with water, into two layers. Examples of the organic solvent include hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; etc. As water used for washing in this event, generally, what is called deionized water or ultrapure water may be used. The washing may be performed at least once, preferably once to approximately five times, because washing ten times or more does not always produce the full washing effects thereof.

In the liquid-liquid separation washing, washing with a basic aqueous solution may be performed to remove unreacted compounds having hydroxy groups or acidic components. Examples of the base include hydroxides of alkaline metals, carbonates of alkaline metals, hydroxides of alkali earth metals, carbonates of alkali earth metals, ammonia, organic ammonium, etc.

Further, in the liquid-liquid separation washing, washing with an acidic aqueous solution may be performed to remove metal impurities or basic components in the system. Examples of the acid include inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; etc.

The liquid-liquid separation and water washing may be performed with any one of the basic aqueous solution and the acidic aqueous solution, or can be performed with a combination of the two. The liquid-liquid separation and water washing is preferably performed with the basic aqueous solution and the acidic aqueous solution in this order from the viewpoint of removing metal impurities.

After the liquid-liquid separation and water washing with the basic aqueous solution and acidic aqueous solution, washing with neutral water may be successively performed. The washing may be performed at least once, preferably once to approximately five times. As the neutral water, deionized water, ultrapure water, or the like mentioned above may be used. The washing may be performed once or more, but if the washing is not performed sufficiently, basic and acidic components cannot be removed in some cases. The washing is preferably performed approximately once to five times because washing ten times or more does not always produce the full washing effects.

Further, after the liquid-liquid separation operation, the reaction product can also be collected as a powder by concentrating and drying the solvent or crystallizing the reaction product under reduced pressure or normal pressure. Alternatively, the reaction product can be retained in a solution state with an appropriate concentration to improve the workability in preparing the composition for forming an organic film. The concentration in this case is preferably 0.1 to 50 mass%, further preferably 0.5 to 30 weight%. When the concentration is as described, the viscosity is hardly high, so that the workability can be prevented from being impaired, and the amount of the solvent is not excessive, so that the solution can be prepared economically.

The solvent used in this event is not particularly limited, as long as it is capable of dissolving the obtained compound. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. As the solvent, one of these or a mixture of two or more thereof can be used.

The reaction shown in STEP 2 progresses easily by a known method, and as the acylating agent, an acid chloride or an acid anhydride corresponding to the partial structure of the organic group R₂ is preferable. In an case where an acid chloride is used, it is preferable to mix the compound obtained in STEP 1 with an acid chloride and a base, such as triethylamine, pyridine, and 4-dimethylaminopyridine, successively or simultaneously without a solvent or in a solvent, such as methylene chloride, acetonitrile, toluene, and hexane, and perform the reaction under cooling or heating and so forth as necessary. Meanwhile, in a case where an acid anhydride is used, it is preferable to mix the compound obtained in STEP 1 with a base, such as triethylamine, pyridine, and 4-dimethylaminopyridine, successively or simultaneously in a solvent, such as toluene, and perform the reaction under, as necessary, cooling or heating and so forth. The obtained reaction product can be subjected to a purification operation, such as washing with water, and collected as a powder or a solution. Examples of the solvent in this event include those mentioned above, and the concentration in this event is preferably 0.1 to 50 mass%, further preferably 0.5 to 30 mass%.

For the preparation of the fluorine-containing compound (B), obtained by these methods, to be contained in a composition for forming an organic film, various compounds having hydroxy groups can be used to adjust appropriately the structure of the compound and the proportions of terminal-group-structures in accordance with the required performance. For example, it is possible optionally to use in combination a compound having a side-chain structure that contributes to the enhancement of planarizing property, a fluorine-containing substituent for controlling surface tension and so forth to change the surface activating ability, etc. Therefore, when a composition for forming an organic film containing such a compound is used for an organic underlayer film, it is possible to achieve high levels of various properties such as film-formability and filling property.

### [Resin or Compound (A) for Forming Organic Film]

The resin or compound (A) for forming an organic film contained in the inventive composition for forming an organic film is not particularly limited as long as the material is a resin or compound that has sufficient film-formability in spin-coating and curability. From the viewpoints of etching resistance, optical characteristics, heat resistance, etc., a resin or compound including an aromatic skeleton (different from the fluorine-containing compound (B)) is preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. Among these, benzene, naphthalene, fluorene, and carbazole are particularly preferable.

The resin or compound (A) for forming an organic film contained in the inventive composition for forming an organic film is not limited to a resin or compound for forming an organic underlayer film, and may be, for example, a resin or compound for forming a resist upper layer film.

Examples of the resin or compound (A) for forming an organic film used in the present invention include resins containing the following structures, disclosed in JP 2012-001687 A and JP 2012-077295 A.

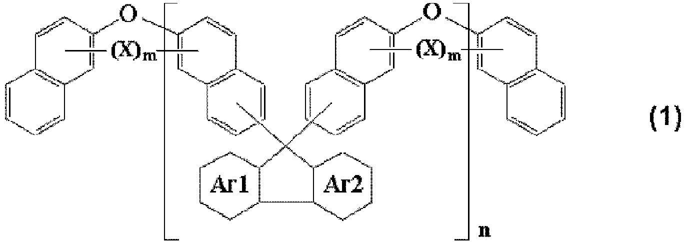

In the formula (1), the cyclic structures Ar1 and Ar2 each independently represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the definitions of the symbols in the formula apply only in this formula.

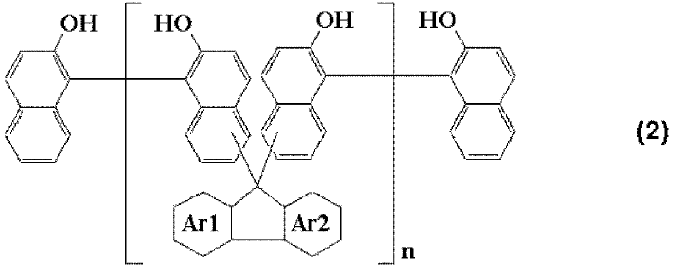

In the formula (2), the cyclic structures Ar1 and Ar2 each independently represent a benzene ring or a naphthalene ring. "n" represents any natural number that provides a weight-average molecular weight of 100,000 or less as measured by gel permeation chromatography in terms of polystyrene. Note that the definitions of the symbols in the formula apply only in this formula.

Further examples of the resin or compound (A) for forming an organic film used in the present invention include resins containing the following structures, disclosed in JP 2004-264710 A, JP 2005-043471 A, JP 2005-250434 A, JP 2007-293294 A, and JP 2008-065303 A.

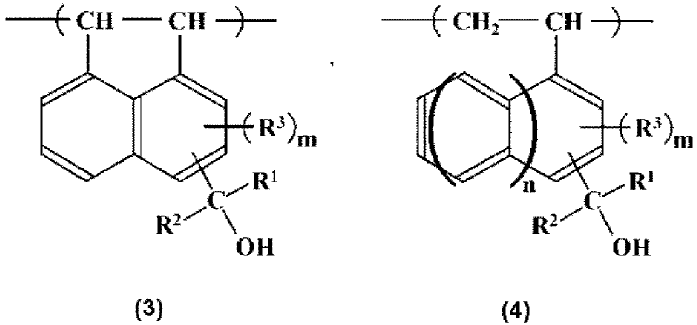

In the formula (3) and the formula (4), R¹ and R² each independently represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1; and "m" represents 0, 1, or 2. Note that the definitions of the symbols in the formulae apply only in these formulae.

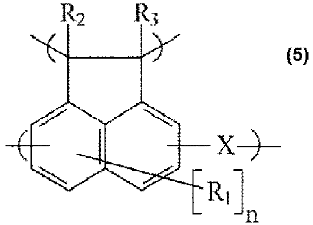

In the formula (5), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the definitions of the symbols in the formula apply only in this formula.

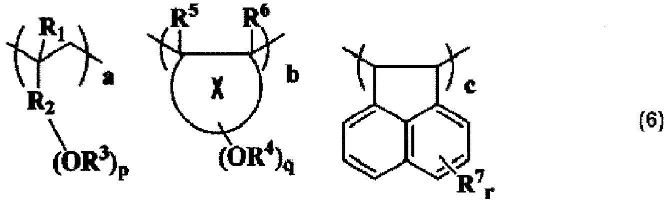

In the formula (6), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of any of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the definitions of the symbols in the formula apply only in this formula. 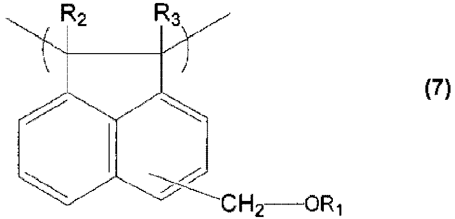 In the formula (7), R₁ represents a hydrogen atom or a monovalent organic group; and R₂ and R₃ each independently represent a monovalent atom or a monovalent organic group. Note that the definitions of the symbols in the formula apply only in this formula.

Further specific examples of the resin or compound (A) for forming an organic film used in the present invention include resins containing the following structures, disclosed in JP 2004-205685 A, JP 2007-171895 A, and JP 2009-014816 A.

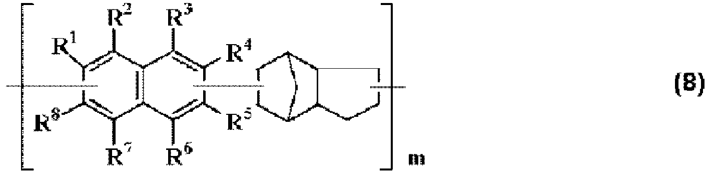

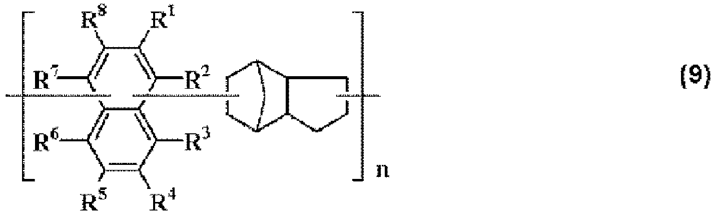

In the formula (8) and the formula (9), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the definitions of the symbols in the formulae apply only in these formulae.

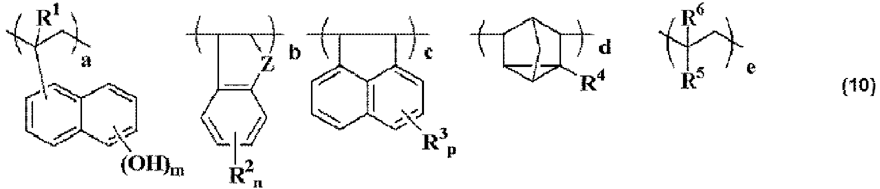

In the formula (10), R¹ and R⁶ each independently represent a hydrogen atom or a methyl group. R², R³, and R⁴ each independently represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the definitions of the symbols in the formula apply only in this formula.

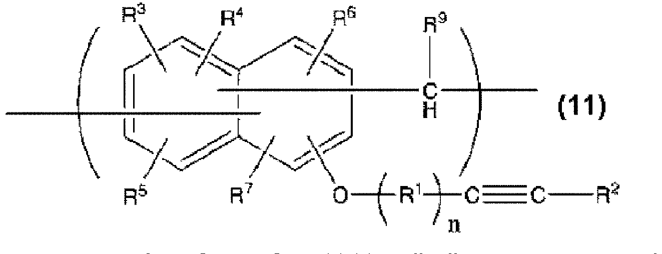

In the formula (11), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each independently represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the definitions of the symbols in the formula apply only in this formula.

Examples of the resin represented by the formula (11) include the following resins.

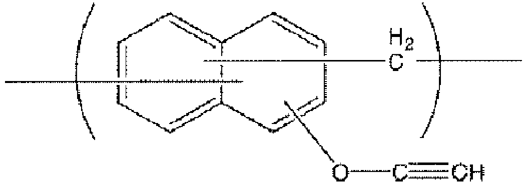

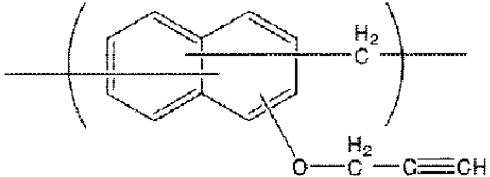

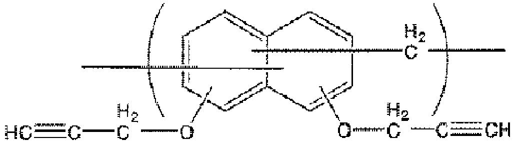

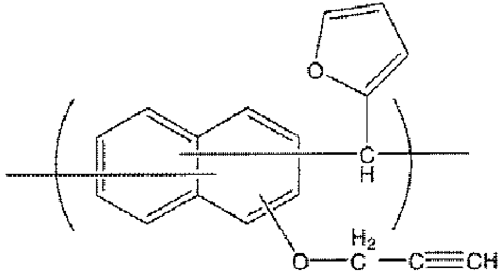

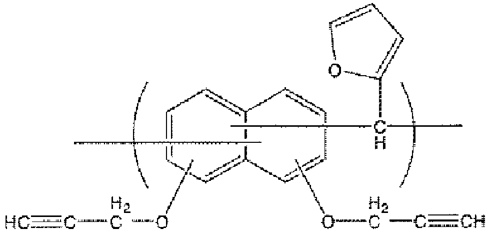

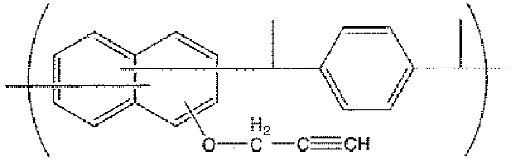

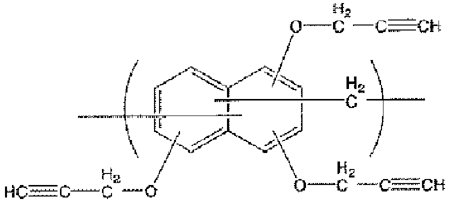

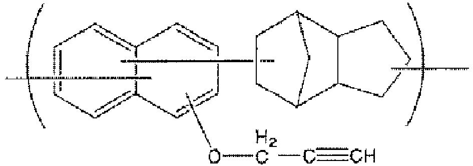

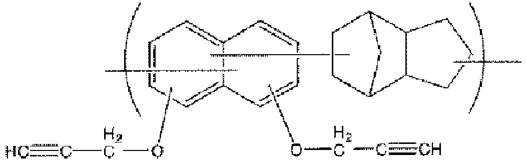

Further examples of the resin or compound (A) for forming an organic film used in the present invention include resins containing the following structures, disclosed in JP 2007-199653 A, JP 2008-274250 A, and JP 2010-122656 A.

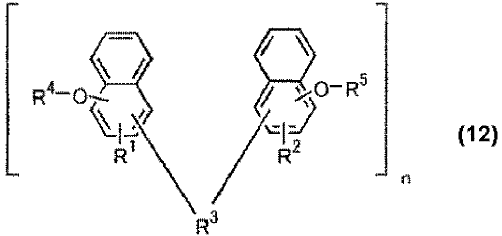

In the formula (12), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the definitions of the symbols in the formula apply only in this formula.

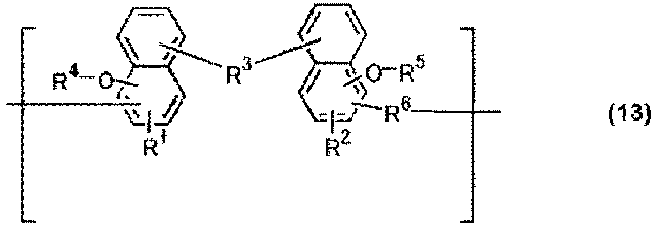

In the formula (13), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the definitions of the symbols in the formula apply only in this formula.

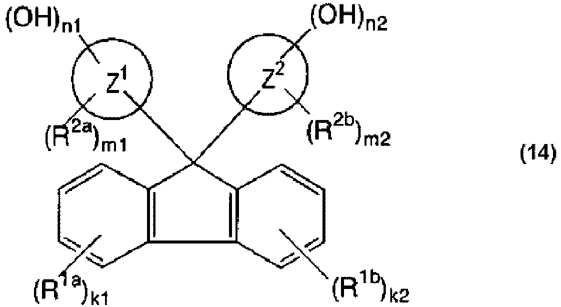

In the formula (14), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" may be identical to or different from each other and each represent 0 or an integer of 1 to 4; "m1" and "m2" each represent 0 or an integer of 1 or more; and "n1" and "n2" each independently represent 0 or an integer of 1 or more. Here, n1+n2 ≥ 1. Note that the definitions of the symbols in the formula apply only in this formula.

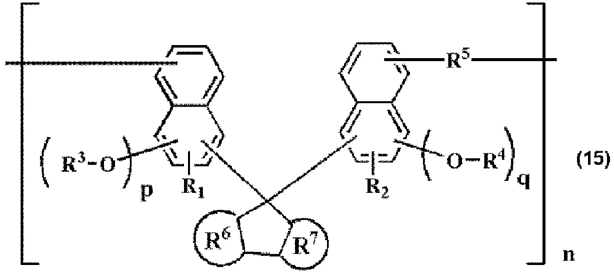

In the formula (15), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each independently represent a hydrogen atom or a glycidyl group; R⁵ represents a single bond or a linear or branched alkylene group having 1 to 10 carbon atoms; and R⁶ and R⁷ each independently represent a benzene ring or a naphthalene ring. "p" and "q" each represent 1 or 2. "n" satisfies 0 < n ≤ 1. Note that the definitions of the symbols in the formula apply only in this formula.

Examples of the resin represented by the formula (15) include the following resins.

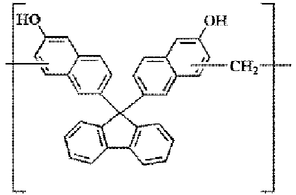

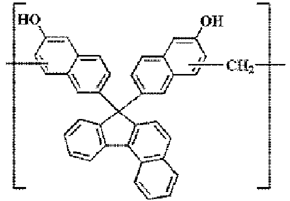

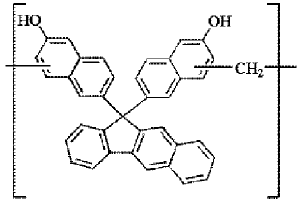

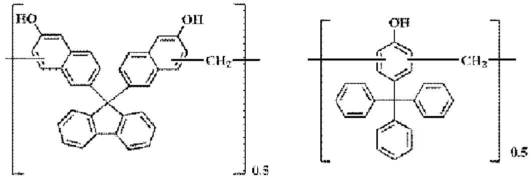

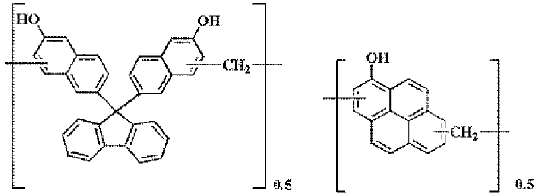

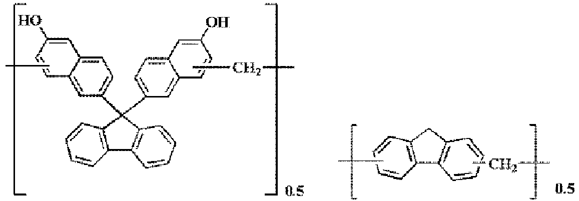

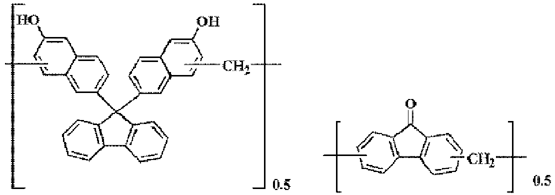

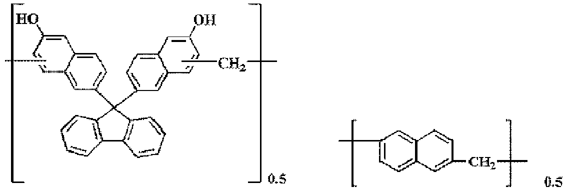

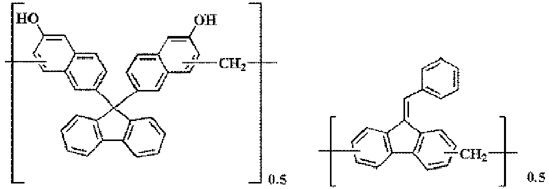

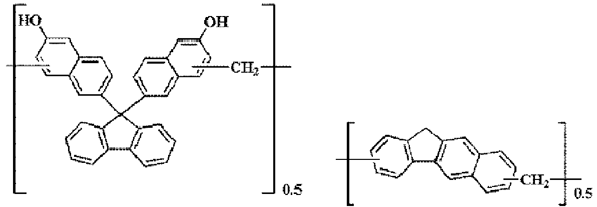

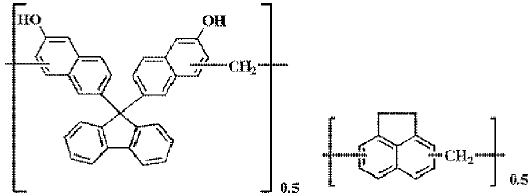

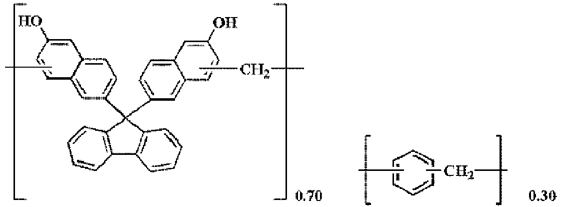

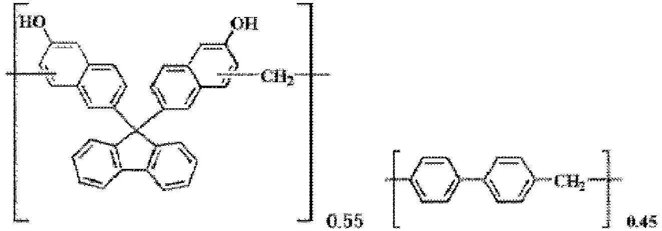

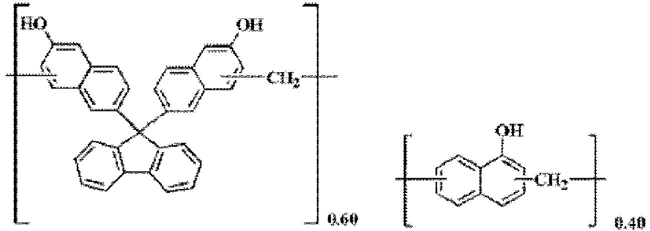

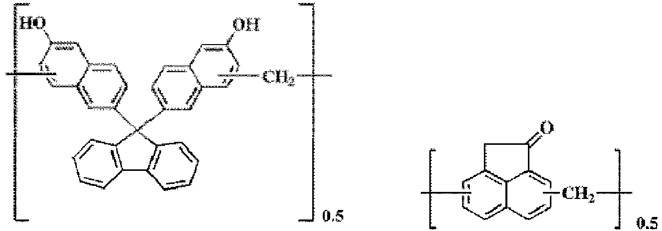

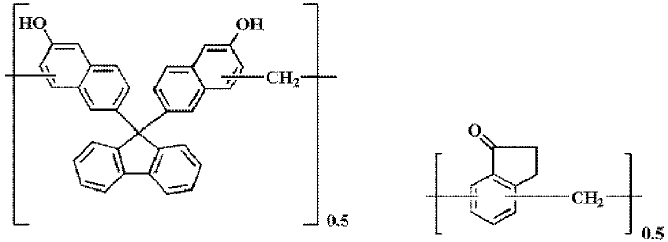

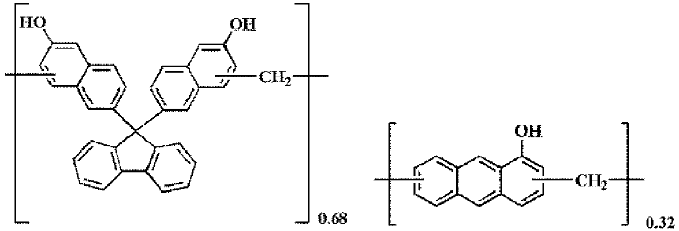

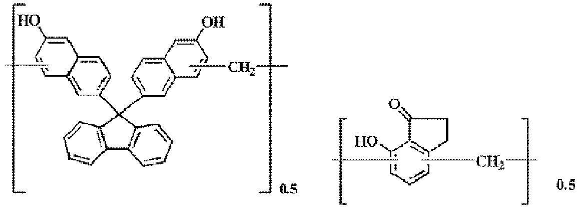

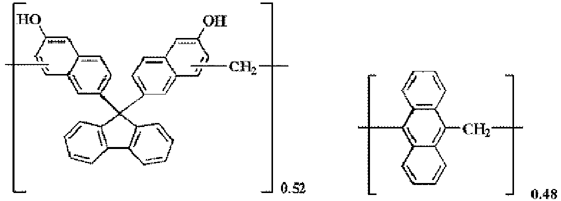

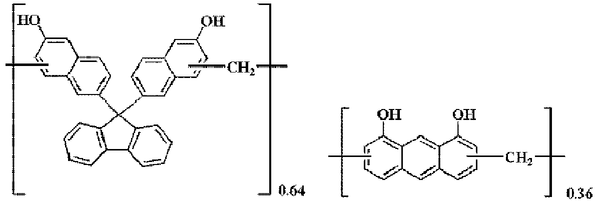

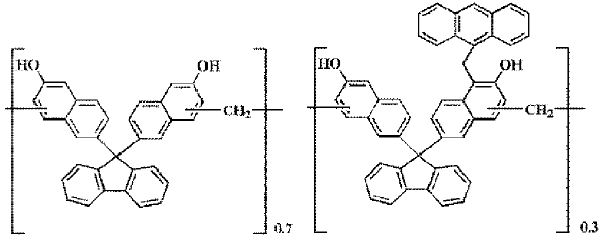

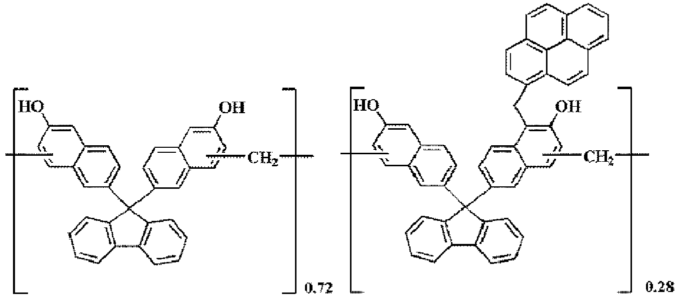

Further examples of the resin or compound (A) for forming an organic film used in the present invention include resins containing the following structure, disclosed in JP 2012-214720 A.

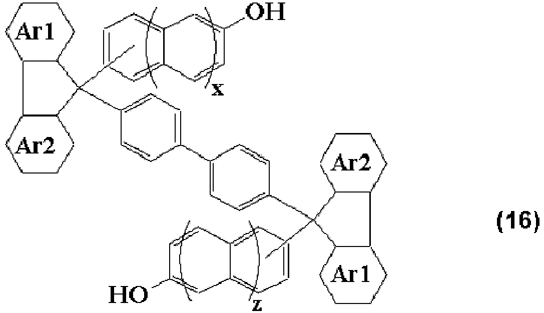

In the formula (16), the cyclic structures Ar1 and Ar2 each independently represent a benzene ring or a naphthalene ring. "x" and "z" each independently represent 0 or 1. Note that the definitions of the symbols in the formula apply only in this formula.

Examples of the resin or compound (A) for forming an organic film used in the present invention include resins disclosed in JP 2014-029435 A.

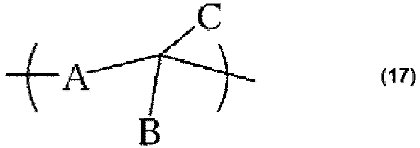

In the formula (17), A represents a structure having carbazole, B represents a structure having an aromatic ring, and C represents a hydrogen atom, an alkyl group, or a structure having an aromatic ring, B and C optionally constituting a ring with each other. One to four carboxyl groups, a salt thereof, or a carboxylic acid ester group is contained in the combined structure of A, B, and C. Note that the definitions of the symbols in the formula apply only in this formula.

Further examples of the resin or compound (A) for forming an organic film used in the present invention include polymers disclosed in WO 2012/077640 A1, the polymers containing a unit structure represented by the following formula (18) and a unit structure represented by the following formula (19), where the ratio of the unit structure represented by the formula (18) to the unit structure represented by the formula (19) is 3 to 97 : 97 to 3 by molar ratio.

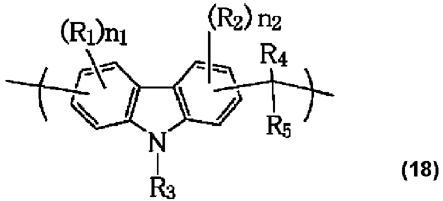

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms optionally substituted with a halogen atom, a nitro group, an amino group or a hydroxy group, aryl group having 6 to 40 carbon atoms optionally substituted with a halogen atom, a nitro group, an amino group or a hydroxy group, or heterocyclic group optionally substituted with a halogen atom, a nitro group, an amino group or a hydroxy group; and R₄ and R₅ may form a ring with each other. "n1" and "n2" each represent an integer of 1 to 3. Note that the definitions of the symbols in the formula apply only in this formula.

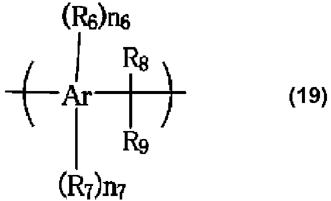

In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms optionally substituted with a halogen atom, a nitro group, an amino group, or a hydroxy group, an aryl group having 6 to 40 carbon atoms optionally substituted with a halogen atom, a nitro group, an amino group, or a hydroxy group, or a heterocyclic group optionally substituted with a halogen atom, a nitro group, an amino group, or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the definitions of the symbols in the formula apply only in this formula.

Further examples of the resin or compound (A) for forming an organic film used in the present invention include polymers containing a unit structure represented by the following formula (20), disclosed in WO 2010/147155 A1.

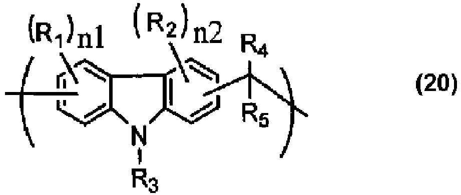

In the formula (20), R₁ and R₂ are each independently selected from the group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from the group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms, the aryl group or the heterocyclic group optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms, the alkyl group, the aryl group or the heterocyclic group optionally substituted with a halogen group, a nitro group, an amino group, or a hydroxy group; R₄ and R₅ optionally form a ring together with the carbon atom bonded to R₄ and R₅; and "n1" and "n2" each represent an integer of 1 to 3. Note that the definitions of the symbols in the formula apply only in this formula.

Further examples of the resin or compound (A) for forming an organic film used in the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21), disclosed in WO 2012/176767 A1.

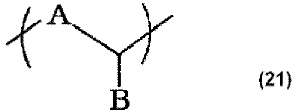

In the formula (21), A represents a hydroxy group-substituted phenylene group derived from polyhydroxybenzene; and B represents a monovalent condensed aromatic hydrocarbon ring group in which two to six benzene rings are condensed. Note that the definitions of the symbols in the formula apply only in this formula.

Further examples of the resin or compound (A) for forming an organic film used in the present invention include novolak resins having a fluorene or tetrahydrospirobiindene structure, disclosed in JP 2005-128509 A, JP 2006-259249 A, JP 2006-259482 A, JP 2006-293298 A, and JP 2007-316282 A, the novolak resins containing a repeating unit structure represented by the following formula (22-1) or (22-2).

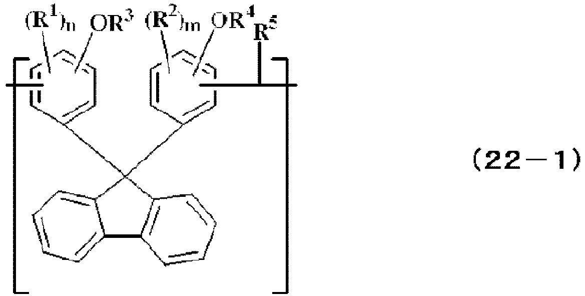

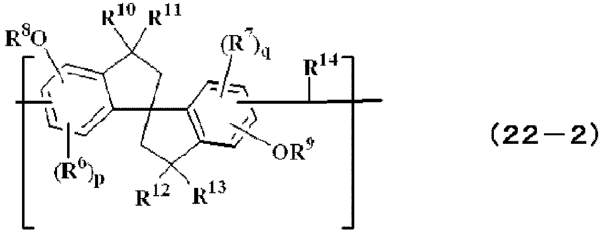

In the formula (22-1) and the formula (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the definitions of the symbols in the formulae apply only in these formulae.

Further examples of the resin or compound (A) for forming an organic film used in the present invention include reaction products obtained by a method disclosed in JP 2012-145897 A. More specific examples include polymers obtained by condensing one or more compounds represented by the following general formula (23-1) and/or (23-2) and one or more compounds represented by the following general formula (24-1) and/or (24-2) and/or an equivalent thereof.

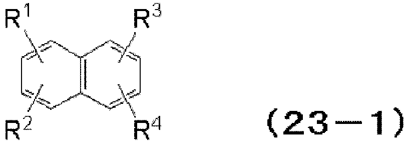

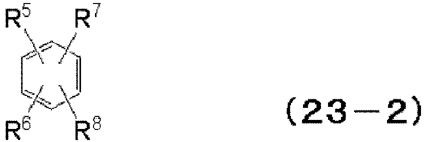

In the general formula (23-1) and the general formula (23-2), R¹ to R⁸ each independently represent a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms and optionally being substituted. Furthermore, any two substituents selected from each of R¹ to R⁴ or R⁵ to R⁸ may be bonded to each other within a molecule to form a cyclic substituent. Note that the definitions of the symbols in the formulae apply only in these formulae.

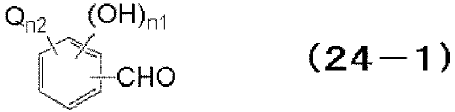

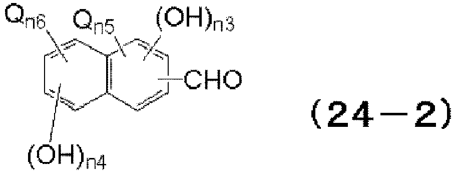

In the general formula (24-1) and the general formula (24-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each independently 0, 1, or 2, and in the formula (24-1), hydroxybenzaldehyde is excluded. Meanwhile, in the formula (24-2), the relationships 0 ≤ n3+n5 ≤ 3, 0 ≤ n4+n6 ≤ 4, and 1 ≤ n3+n4 ≤ 4 are satisfied. Note that the definitions of the symbols in the formulae apply only in these formulae.

Further examples also include polymers obtained by condensing one or more compounds represented by the general formula (23-1) and/or (23-2), one or more compounds represented by the general formula (24-1) and/or (24-2) and/or an equivalent thereof, and one or more compounds represented by the following general formula (25) and/or an equivalent thereof.

Y-CHO (25)

In the formula (25), Y represents a hydrogen atom or a monovalent organic group having 30 or fewer carbon atoms and optionally having a substituent, and the formula (25) is different from the general formula (24-1) and the general formula (24-2). Note that the definition of the symbol in the formula applies only in this formula.

Further examples of the resin or compound (A) for forming an organic film used in the present invention include compounds containing the following structure, disclosed in JP 2017-119671 A.

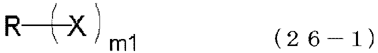

In the formula (26-1), R represents a single bond or an organic group having 1 to 50 carbon atoms; X represents a group represented by any of the following general formulae (26-2); and "m1" represents an integer that satisfies 2 ≤ m1 ≤ 10. Note that the definitions of the symbols in the formula apply only in this formula.

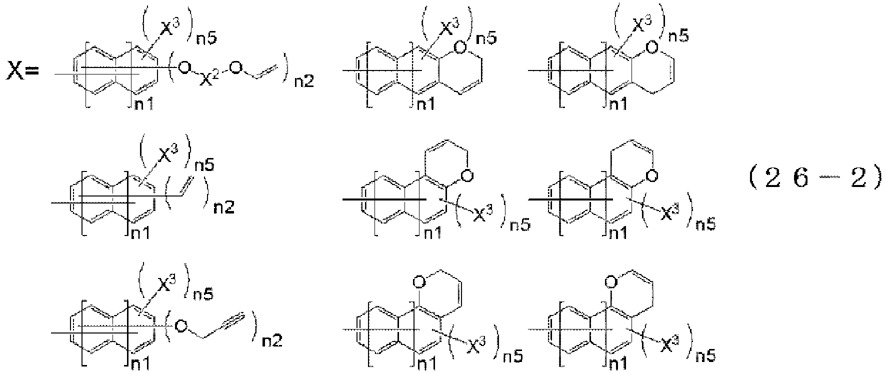

In the formulae, X² represents a divalent organic group having 1 to 10 carbon atoms; "n1" represents 0 or 1; "n2" represents 1 or 2; X³ represents a group represented by the following general formula (26-3); and "n5" represents 0, 1, or 2. Note that the definitions of the symbols in the formulae apply only in these formulae.

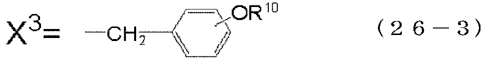

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the definition of the symbol in the formula applies only in this formula.

Examples of the compounds containing the above-described structures include the following compounds.

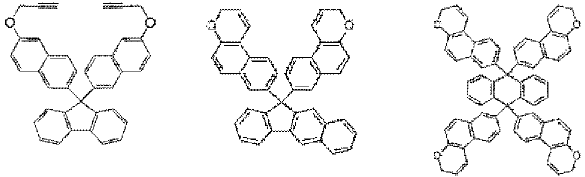

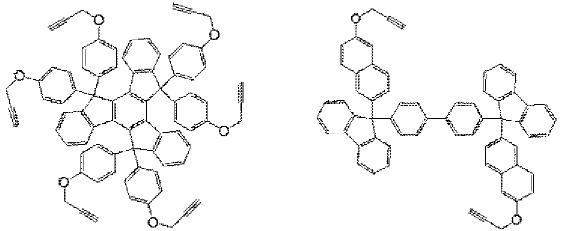

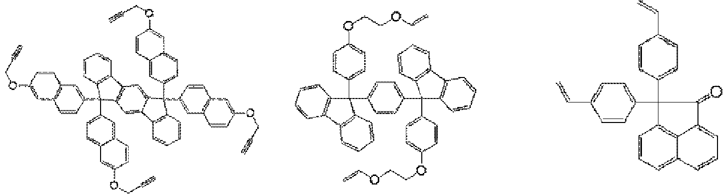

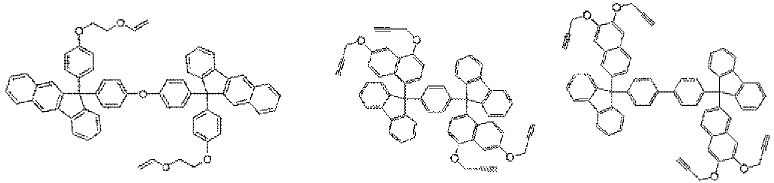

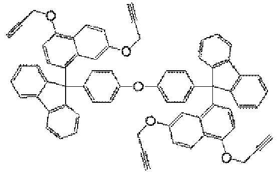

Further examples of the resin or compound (A) for forming an organic film used in the present invention include polymers having a repeating unit represented by the following general formula (27-1), disclosed in JP 2019-044022 A.

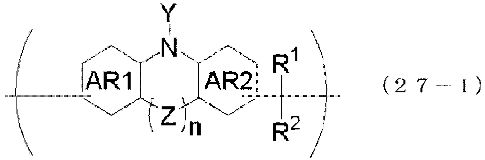

In the formula (27-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or one of the following formulae (27-2). Y represents a group represented by the following formula (27-3). Note that the definitions of the symbols in the formula apply only in this formula.

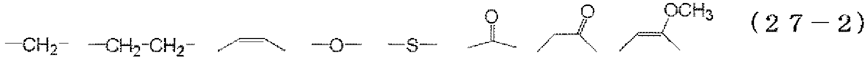

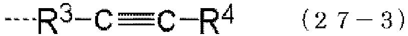

In the formula (27-3), R³ represents a single bond or a divalent organic group having 1 to 20 carbon atoms; R⁴ represents a hydrogen atom or a monovalent organic group having 1 to 20 carbon atoms; and a broken line represents an attachment point. Note that the definitions of the symbols in the formula apply only in this formula.

Examples of the polymers having a repeating unit represented by the general formula (27-1) include the following polymers.

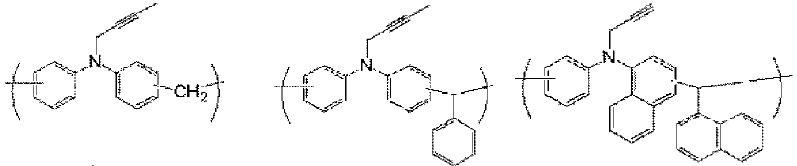

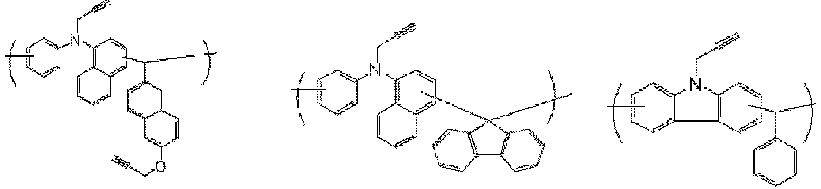

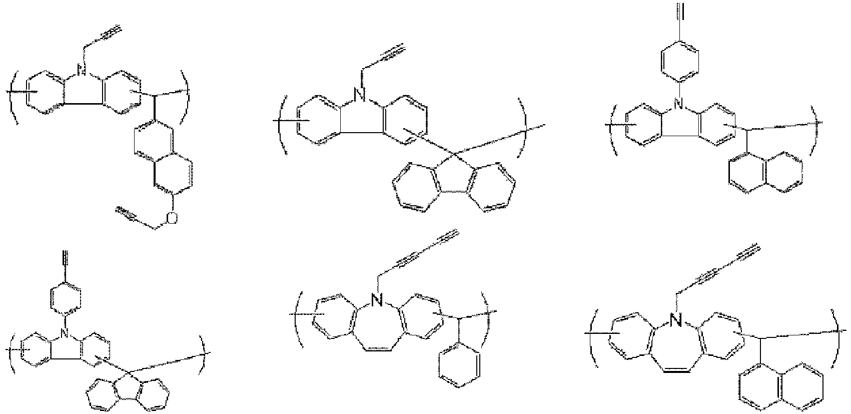

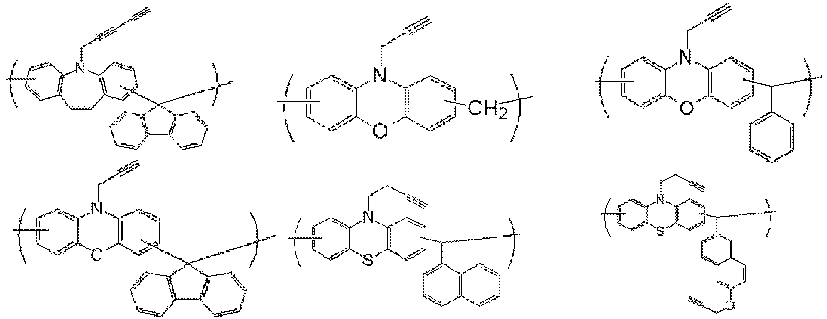

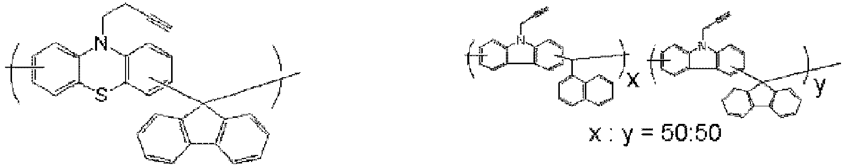

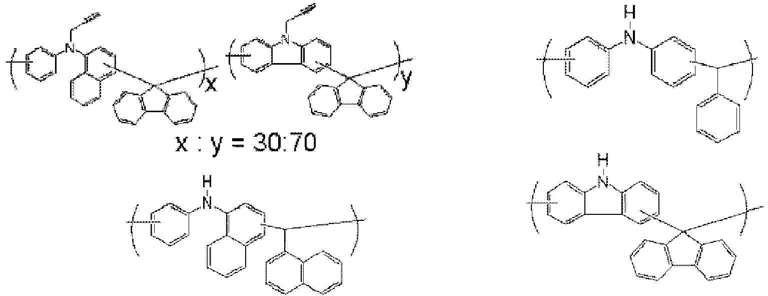

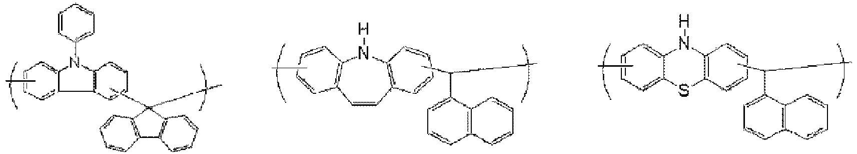

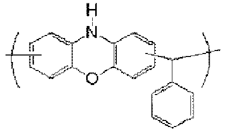

The resin or compound (A) for forming an organic film may be synthesized by a known method, and a commercially available product may be used.

The amount of the resin or compound (A) for forming an organic film to be contained is not particularly limited as long as sufficient film-formability can be achieved on spin-coating with the composition for forming an organic film, but the resin or compound (A) for forming an organic film is preferably contained in an amount of 10 to 40 parts by mass, more preferably 10 to 30 parts by mass, and further preferably 10 to 25 parts by mass, based on 100 parts by mass of the composition for forming an organic film. For example, when a hole or trench, having a very high aspect ratio, of a 3D NAND memory architecture is to be filled with the composition for forming an organic film, the contained amount of the resin for forming an organic film needs to be large. However, on the other hand, such a composition for forming an organic film is highly viscous, and in-plane uniformity after spin-coating and filling property are degraded. Even when the resin or compound (A) for forming an organic film is contained in such a proportion, the inventive composition for forming an organic film makes it possible to form an organic film having excellent in-plane uniformity and excellent filling property, and can therefore be applied suitably.

Meanwhile, the fluorine-containing compound (B) is preferably contained in an amount of 0.01 parts by mass to 5 parts by mass based on 100 parts by mass of the resin or compound (A) for forming an organic film. A composition for forming an organic film containing the compound in such an amount makes it possible to form an organic film with better in-plane uniformity.

### [Solvent (C)]

The solvent (C) usable for the inventive composition for forming an organic film is not particularly limited as long as the solvent can dissolve the resin or compound (A) for forming an organic film and the fluorine-containing compound (B), and the solvent can preferably also dissolve the acid generator, crosslinking agent, a further surfactant, etc. described later. Specifically, it is possible to use a solvent having a boiling point lower than 180°C, such as the solvents disclosed in paragraphs (0091) and (0092) of JP 2007-199653 A. In particular, preferable solvents are propylene glycol monomethyl ether acetate, propylene glycol monomethyl ether, 2-heptanone, cyclopentanone, cyclohexanone, and mixtures of two or more thereof.

The solvent (C) is preferably contained in an amount of 200 to 10,000 parts by mass, more preferably 300 to 5,000 parts based on 100 parts by mass of the resin or compound (A) for forming an organic film. When the amount is in such a range, the concentration is adjustable in accordance with the desired film thickness.

Furthermore, the inventive composition for forming an organic film may also contain, as an organic solvent, being the solvent (C), a high-boiling-point solvent, having a boiling point of 180°C or higher, in addition to the above-described solvent having a boiling point of lower than 180°C (a mixture of a solvent having a boiling point of lower than 180°C and a solvent having a boiling point of 180°C or higher). Note that the boiling point herein is a boiling point at standard atmosphere (1013 hPa). The high-boiling-point organic solvent is not particularly limited to hydrocarbons, alcohols, ketones, esters, ethers, or chlorine-based solvents as long as the solvent is capable of dissolving the resin or compound (A) for forming an organic film and the fluorine-containing compound (B). Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The boiling point of the high-boiling-point solvent can be selected appropriately in accordance with the temperature at which the resin or compound (A) for forming an organic film is heated, and the boiling point of the high-boiling-point solvent to be contained is preferably 180°C to 300°C, further preferably 200°C to 300°C. When the boiling point is as described, sufficient thermal flowability can be achieved, since there is no risk of excessive evaporation rate at the baking (heating) due to the boiling point being too low. Moreover, a solvent having such a boiling point does not remain in the film without evaporating even after the baking due to the boiling point being too high. Therefore, there is no risk of the solvent adversely affecting the physical properties, such as etching resistance, of the film.

Furthermore, when the high-boiling-point solvent is used, the amount to be blended is preferably 1 to 30 parts by mass per 100 parts by mass of the solvent having a boiling point of lower than 180°C. When the contained amount is as described, sufficient thermal flowability can be imparted at the time of baking, and there is no risk that the solvent remains in the film and leads to degradation of physical properties, such as etching resistance, of the film.

The above-described composition for forming an organic film is provided with both high filling property and excellent planarizing property by thermal flowability being imparted to the resin or compound (A) for forming an organic film by virtue of the high-boiling-point solvent being contained.

### [Other Components]

In addition, the inventive composition for forming an organic film can contain an acid generator or a crosslinking agent for further promoting the crosslinking reaction.

Acid generators include materials that generate an acid by thermal decomposition and materials that generate an acid by light irradiation, and any acid generator can be contained. Specific examples of the acid generator include those disclosed in paragraphs [0061] to [0085] of JP 2007-199653 A. One kind of the acid generator may be used, or two or more kinds thereof may be used in combination. When the acid generator is contained, the contained amount is preferably 0.05 to 50 parts by mass, more preferably 0.1 to 10 parts by mass based on 100 parts by mass of the resin or compound (A) for forming an organic film. When the amount is as described, it is possible to promote the crosslinking reaction and form a dense film.

Specific examples of the crosslinking agent include those disclosed in paragraphs [0055] to [0060] of JP 2007-199653 A. One kind of the crosslinking agent may be used, or two or more kinds thereof may be used in combination. The crosslinking agent is preferably contained in an amount of 1 to 100 parts by mass, more preferably 5 to 50 parts by mass based on 100 parts by mass of the resin or compound (A) for forming an organic film. When the amount is as described, it is possible to enhance curability and further suppress intermixing with an upper layer film.

The inventive composition for forming an organic film can also contain an additional surfactant other than the fluorine-containing compound (B) of the present invention, in order to further improve in-plane uniformity in spin-coating. Specific examples of the additional surfactant include those disclosed in paragraphs [0142] to [0147] of JP 2009-269953 A. One kind of the additional surfactant may be used, or two or more kinds thereof may be used in combination. When the additional surfactant is contained, the contained amount is preferably 0.01 to 10 parts by mass, more preferably 0.05 to 5 parts by mass based on 100 parts by mass of the resin or compound (A) for forming an organic film. When the amount is as described, it is possible to form an organic film excellent in in-plane uniformity.

The inventive composition for forming an organic film can further contain a basic compound for enhancing storage stability. The basic compound serves as a quencher to an acid to prevent a very small amount of acid generated by the acid generator from promoting the crosslinking reaction. Specific examples of such a basic compound include those disclosed in paragraphs [0086] to [0090] of JP 2007-199653 A. One kind of the basic compound may be used, or two or more kinds thereof may be used in combination. When the basic compound is contained, the contained amount is preferably 0.05 to 50 parts by mass, more preferably 0.1 to 10 parts by mass based on 100 parts by mass of the resin or compound (A) for forming an organic film. When the amount is as described, it is possible to improve the storage stability of the composition for forming an organic film.

Such a composition for forming an organic film is excellent in in-plane uniformity and filling property and makes it possible to form an organic film in which the formation of a hump due to the effect of a remover in an EBR process has been suppressed. Furthermore, by introducing, as a partial structure, a structure having multiple fluorine atoms into the fluorine-containing compound (B), the fluorine-containing compound (B) volatilizes from the surface of the organic film by virtue of the baking at the time of cured-film formation in a case where an organic underlayer film is formed, and the compound is removed from within the film. Therefore, the composition for forming an organic film makes it possible to form an organic film excellent in the coating property of a silicon-containing middle layer film on the organic film and has an excellent process margin.

In particular, as described above, the inventive composition for forming an organic film is excellent in hump suppression at the time of an EBR process. Accordingly, the inventive composition for forming an organic film is extremely useful as a resist underlayer film material (organic film material) for multilayer resist processes such as two-layer resist processes, three-layer resist processes using a silicon-containing resist middle layer film or a silicon-containing inorganic hard mask middle layer film, and four-layer resist processes using a silicon-containing resist middle layer film or silicon-containing inorganic hard mask middle layer film and an organic antireflective film or adhesive film.

### [Method for Forming Organic Film]

The present invention provides a method for forming an organic film to be used in a manufacturing process of a semiconductor device, the method including:
spin-coating a substrate to be processed with the inventive composition for forming an organic film to obtain a coating film; and
forming a cured film by heating the coating film at a temperature of 100°C or higher and 600°C or lower for 10 to 600 seconds.

In this method for forming an organic film, firstly, the inventive composition for forming an organic film described above is applied onto a substrate to be processed by spin-coating. An excellent filling property can be obtained by using a spin-coating method. After removing a film on an edge portion in an EBR process, baking (heating) is performed in order to promote the crosslinking reaction. Incidentally, the solvent in the composition can be evaporated by this baking, and therefore, mixing can be prevented even when a resist upper layer film or a silicon-containing resist middle layer film is formed on the organic film.

The baking is performed at a temperature of 100°C or higher and 600°C or lower for 10 to 600 seconds, preferably at a temperature of 200°C or higher and 500°C or lower for 10 to 300 seconds. Considering influence on device damage and wafer deformation, the upper limit of the heating temperature in a wafer process of lithography is preferably 600°C or lower, more preferably 500°C or lower. By performing the heat treatment under such conditions, the crosslinking reaction can be promoted, and it is possible to form an organic film that does not mix with a film formed thereon.

### [Patterning Process]

In the following, patterning processes using the inventive composition for forming an organic film will be described.

### [Three-Layer Resist Process Using Silicon-Containing Resist Middle Layer Film]

The present invention provides a patterning process including:
forming an organic underlayer film on a body to be processed by using the inventive composition for forming an organic film;
forming a resist middle layer film on the organic underlayer film by using a resist middle layer film material containing a silicon atom;
forming a resist upper layer film on the resist middle layer film by using a resist upper layer film material containing a photoresist composition;
forming a circuit pattern in the resist upper layer film;
transferring the pattern to the resist middle layer film by etching while using the resist upper layer film having the formed circuit pattern as a mask;
transferring the pattern to the organic underlayer film by etching while using the resist middle layer film having the transferred pattern as a mask; and
further transferring the pattern to the body to be processed by etching while using the organic underlayer film having the transferred pattern as a mask.

The body to be processed is preferably a semiconductor device substrate or the semiconductor device substrate coated with any of a metal film, a metal carbide film, a metal oxide film, a metal nitride film, a metal oxycarbide film, and a metal oxynitride film, for example. The body to be processed is not particularly limited, but more specifically, may be a substrate made of Si, α-Si, p-Si, SiO₂, SiN, SiON, W, TiN, Al, etc.; the substrate coated with the above-mentioned metal film or the like as a layer to be processed; etc.

Examples of the layer to be processed include various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, particularly preferably 100 to 5,000 nm. Note that when the layer to be processed is formed, the substrate and the layer to be processed are formed from different materials.

Incidentally, the metal constituting the body to be processed preferably contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed by using the inventive composition for forming an organic film, the inventive method for forming an organic film described above can be adopted, for example, although the method is not limited thereto.

Subsequently, a resist middle layer film (silicon-containing resist middle layer film) is formed on the organic underlayer film by using a resist middle layer film material containing a silicon atom. As the resist middle layer film material containing a silicon atom, a polysiloxane-based middle layer film material is preferable. By imparting an antireflective effect to the silicon-containing resist middle layer film, reflection can be suppressed. Particularly, for 193-nm light exposure, when a material containing many aromatic groups and having high etching selectivity relative to the substrate is used as a composition for forming an organic film, the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has an anthryl group for 248-nm or 157-nm light exposure, or a phenyl group or a light-absorbing group having a silicon-silicon bond for 193-nm light exposure in a pendant structure, and which is to be crosslinked by an acid or heat.

Subsequently, a resist upper layer film is formed on the silicon-containing resist middle layer film by using a resist upper layer film material containing a photoresist composition. The resist upper layer film material may be a positive type or a negative type, and a photoresist composition that is normally used can be used. After the spin-coating with the resist upper layer film material, pre-baking is preferably performed at 60 to 180°C for 10 to 300 seconds. Then, light exposure, post-exposure baking (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Subsequently, a circuit pattern (resist upper layer film pattern) is formed in the resist upper layer film. The circuit pattern is preferably formed by a lithography using light having a wavelength of 10 nm or more and 300 nm or less, a direct writing with electron beam, nanoimprinting, or a combination thereof.

Examples of exposure light include high-energy beams having a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) of 3 to 20 nm, electron beam (EB), ion beam, X-ray, etc.

Furthermore, the circuit pattern is preferably developed with an alkaline development or an organic solvent.

Subsequently, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed by using a fluorocarbon-based gas. Thus, the pattern (silicon-containing resist middle layer film pattern) is transferred to the silicon-containing resist middle layer film.

Subsequently, the pattern is transferred to the organic underlayer film by etching while using the silicon-containing resist middle layer film having the transferred pattern (silicon-containing resist middle layer film pattern) as a mask. The silicon-containing resist middle layer film exhibits etching resistance to oxygen gas or hydrogen gas, and therefore, the etching of the organic film performed while using the silicon-containing resist middle layer film pattern as a mask is preferably performed by using an etching gas mainly containing oxygen gas or hydrogen gas. Thus, the pattern (organic film pattern) is transferred to the organic underlayer film.

Subsequently, the pattern is formed in the body to be processed by etching while using the organic underlayer film having the transferred pattern (organic underlayer film pattern) as a mask.

This etching of the body to be processed (layer to be processed) can be performed by a conventional method. For example, a body to be processed made of SiO₂, SiN, or silica low-dielectric insulating film is etched mainly with a fluorocarbon-based gas; and a body to be processed made of p-Si, Al, or W is etched mainly with a chlorine- or bromine-based gas. When the substrate is processed by etching with a fluorocarbon-based gas, the silicon-containing resist middle layer film pattern is removed when the body to be processed is processed. Meanwhile, when the body to be processed is processed by etching with a chlorine- or bromine-based gas, the silicon-containing resist middle layer film pattern needs to be removed by additional dry etching with a fluorocarbon-based gas after the processing of the body to be processed.

The organic underlayer film obtained by using the inventive composition for forming an organic film can be provided with excellent etching resistance when the body to be processed is etched as described above.

### [Four-Layer Resist Process Using Silicon-Containing Resist Middle Layer Film and Organic Antireflective Film or Adhesive Film]

The present invention also provides a patterning process including:
forming an organic underlayer film on a body to be processed by using the inventive composition for forming an organic film;
forming a resist middle layer film on the organic underlayer film by using a resist middle layer film material containing a silicon atom;
forming an organic antireflective film or an adhesive film on the resist middle layer film;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the resist middle layer film by etching while using the resist upper layer film having the formed circuit pattern as a mask;
transferring the pattern to the organic underlayer film by etching while using the resist middle layer film having the transferred pattern as a mask; and
further transferring the pattern to the body to be processed by etching while using the organic underlayer film having the transferred pattern as a mask.

This method can be performed in the same manner as the three-layer resist process using the silicon-containing resist middle layer film, except that the organic antireflective film (BARC) or the adhesive film is formed between the silicon-containing resist middle layer film and the resist upper layer film.

The organic antireflective film and the adhesive film can be formed by spin-coating by using a known organic antireflective film material.

### [Three-Layer Resist Process Using Inorganic Hard Mask Middle Layer Film]

The present invention also provides a patterning process including:
forming an organic underlayer film on a body to be processed by using the inventive composition for forming an organic film;
forming an inorganic hard mask selected from the group consisting of a silicon oxide film, a silicon nitride film, and a silicon oxynitride film on the organic underlayer film;
forming a resist upper layer film on the inorganic hard mask by using a resist upper layer film material containing a photoresist composition;
forming a circuit pattern in the resist upper layer film;
transferring the pattern to the inorganic hard mask by etching while using the resist upper layer film having the formed circuit pattern as a mask;
transferring the pattern to the organic underlayer film by etching while using the inorganic hard mask having the transferred pattern as a mask; and
further transferring the pattern to the body to be processed by etching while using the organic underlayer film having the transferred pattern as a mask.

This method can be performed in the same manner as the three-layer resist process using the silicon-containing resist middle layer film, except that the inorganic hard mask middle layer film is formed instead of the silicon-containing resist middle layer film on the organic underlayer film.

The inorganic hard mask middle layer film selected from the group consisting of a silicon oxide film, a silicon nitride film, and a silicon oxynitride film (SiON film) can be formed, for example, by a CVD method, an ALD method, etc. Examples of methods for forming the silicon nitride film are disclosed in JP 2002-334869 A, WO 2004/066377 A1, etc. The inorganic hard mask middle layer film preferably has a thickness of 5 to 200 nm, more preferably 10 to 100 nm. As the inorganic hard mask middle layer film, a SiON film, which has a high function as an antireflective film, is the most preferably used.

### [Four-Layer Resist Process Using Inorganic Hard Mask Middle Layer Film and Organic Antireflective Film or Adhesive Film]

The present invention also provides a patterning process including:
forming an organic underlayer film on a body to be processed by using the inventive composition for forming an organic film;
forming an inorganic hard mask selected from the group consisting of a silicon oxide film, a silicon nitride film, and a silicon oxynitride film on the organic underlayer film;
forming an organic antireflective film or an adhesive film on the inorganic hard mask;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic underlayer film by etching while using the inorganic hard mask having the transferred pattern as a mask; and
further transferring the pattern to the body to be processed by etching while using the organic underlayer film having the transferred pattern as a mask.

This method can be performed in the same manner as the three-layer resist process using the inorganic hard mask middle layer film, except that the organic antireflective film (BARC) or the adhesive film is formed between the inorganic hard mask middle layer film and the resist upper layer film.

Particularly, when a SiON film is used as the inorganic hard mask middle layer film, two antireflective films including the SiON film and the BARC make it possible to suppress the reflection even in liquid immersion exposure at a high NA exceeding 1.0. Another merit of forming the BARC is having an effect of reducing trailing of the resist upper layer film pattern immediately above the SiON film.

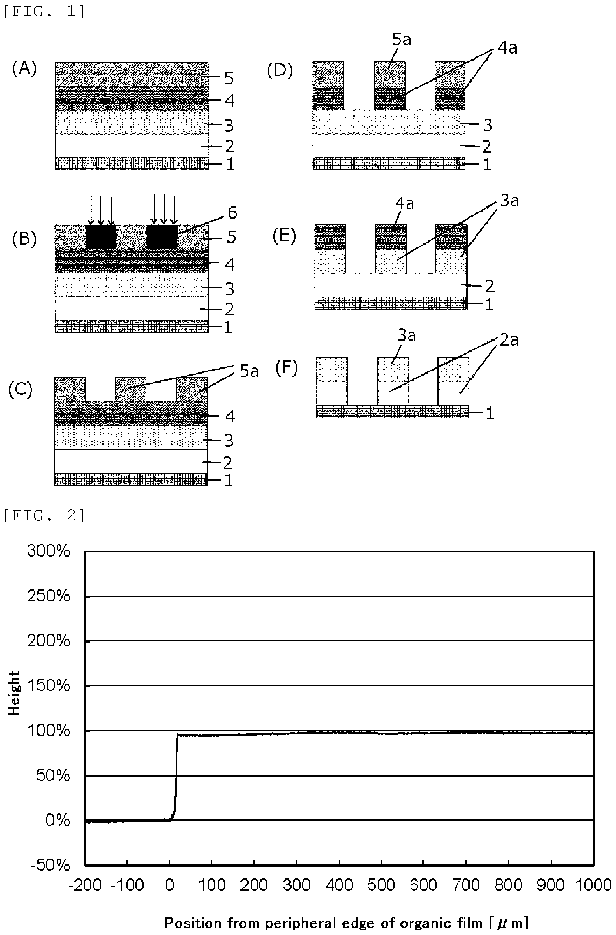

Here, an example of the inventive patterning processes according to a three-layer resist process is shown in FIG. 1 (A) to (F). In the case of a three-layer resist process, as shown in FIG. 1 (A), an organic underlayer film 3 is formed by using the inventive composition for forming an organic film on a layer 2 to be processed (body to be processed) formed on a substrate 1; then, a silicon-containing resist middle layer film 4 is formed on the organic underlayer film 3; and a resist upper layer film 5 is formed thereon. Next, as shown in FIG. 1 (B), an exposure portion 6 of the resist upper layer film 5 is exposed, and then PEB (post-exposure baking) is performed. Next, as shown in FIG. 1 (C), development is performed to form a resist upper layer film pattern 5a. Next, as shown in FIG. 1 (D), the silicon-containing resist middle layer film 4 is dry-etched by using a fluorocarbon-based gas while using the resist upper layer film pattern 5a as a mask, and thus, a silicon-containing resist middle layer film pattern 4a is formed. Next, the resist upper layer film pattern 5a is removed, then, as shown in FIG. 1 (E), the organic underlayer film 3 is etched with oxygen plasma while using the silicon-containing resist middle layer film pattern 4a as a mask, and thus, an organic underlayer film pattern 3a is formed. Furthermore, as shown in FIG. 1 (F), the silicon-containing resist middle layer film pattern 4a is removed, then the layer 2 to be processed is etched while using the organic underlayer film pattern 3a as a mask, and thus, a pattern 2a is formed.

In the patterning process of this example, by humps being suppressed when the organic underlayer film 3 is formed, during the dry etching of FIG. 1 (D), (E), and (F), it is possible to reduce defects that are generated due to humps of the organic underlayer film.

In a case where an inorganic hard mask middle layer film is formed, the silicon-containing resist middle layer film 4 can be changed to an inorganic hard mask middle layer film, and in a case where a BARC or an adhesive film is formed, the BARC or the adhesive film can be formed between the silicon-containing resist middle layer film 4 and the resist upper layer film 5. The etching of the BARC or the adhesive film may be performed continuously before the etching of the silicon-containing resist middle layer film 4; alternatively, after the BARC or the adhesive film alone is etched, the etching apparatus may be changed and so forth, and then the etching of the silicon-containing resist middle layer film 4 may be performed.

As described above, the inventive patterning processes make it possible to form a fine pattern in a body to be processed with high precision according to a multilayer resist process, and to suppress hump formation on an organic film, thus reducing defects derived from humps of the organic underlayer film.

### EXAMPLES

Hereinafter, the present invention will be further specifically described with reference to Synthesis Examples, Comparative Synthesis Examples, Examples, and Comparative Examples. However, the present invention is not limited thereto. Note that, specifically, the molecular weight was measured in the following manner. Weight-average molecular weight (Mw) and number-average molecular weight (Mn) on polystyrene basis were measured by gel permeation chromatography (GPC) using tetrahydrofuran as an eluent (solvent), and dispersity (Mw/Mn) was calculated therefrom.

### [Synthesis of Compounds (B1) to (B29)]

For the synthesis of fluorine-containing compounds (B1) to (B29), used for the preparation of compositions (UDL-1 to UDL-56) for forming an organic film in the Examples of the present invention, the epoxy compounds (E1) to (E9) and hydroxy group-containing compounds (alcohol compounds and carboxylic acid compounds) (F1) to (F13) shown below were used. Regarding methods for synthesizing the fluorine-containing compounds (B1 to B27), the synthesis method differs depending on whether the compound is a fluorine-containing compound (B1), (B2), (B4) to (B13), (B15) to (B18), (B20), (B22), (B25), and (B26), containing an ether structure, or a fluorine-containing compound (B3), (B14), (B19), (B21), (B23), (B24), and (B27), containing an ester structure, and the methods are each shown later.

### Epoxy Compound

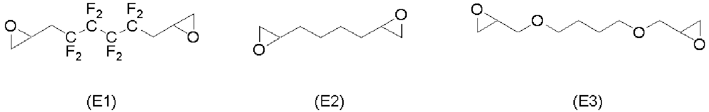

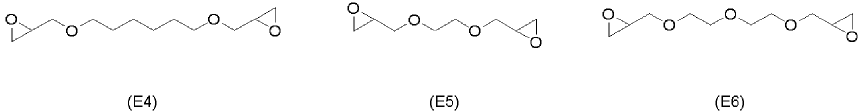

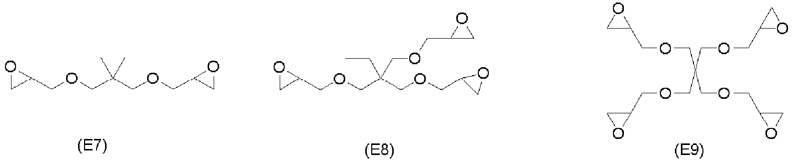

### Hydroxy Group-Containing Compound (Alcohol Compound or Carboxylic Acid Compound)

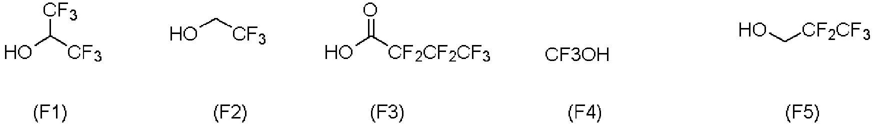

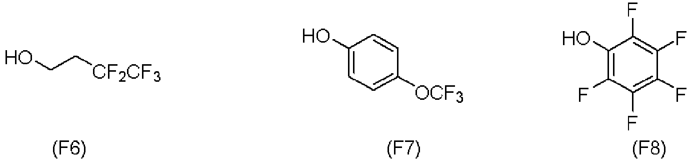

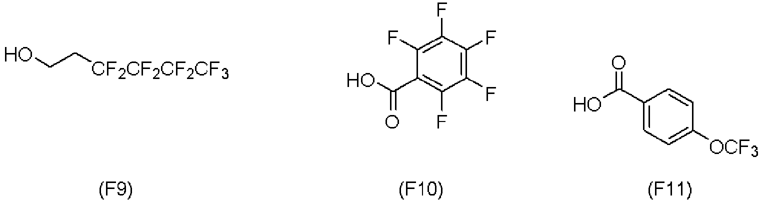

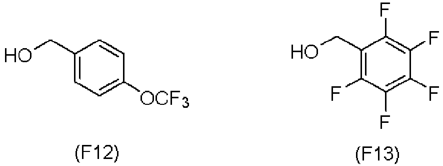

### [Synthesis Example 1] Synthesis of Fluorine-Containing Diol Compound (B1) Containing Ether Structure

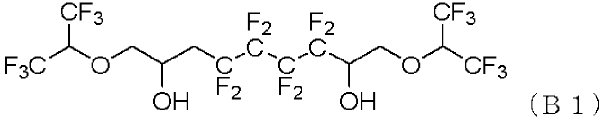

Under a nitrogen atmosphere, 100.0 g of THF (tetrahydrofuran) and 32.1 g (190.9 mmol) of the alcohol compound (F1) were mixed and stirred in an ice bath to form a homogeneous solution. To the homogeneous solution, 21.4 g (190.9 mmol) of potassium t-butoxide was added, and the mixture was stirred to form a homogeneous solution. After that, a mixed solution of 20.0 g (63.6 mmol) of the epoxy compound (E1) and 20.0 g of THF was added dropwise to the homogeneous solution over 30 minutes, and then a reaction was allowed to take place at an internal temperature of 60°C for 24 hours. The reaction solution was cooled to room temperature, and then the reaction was quenched with 100 ml of ultrapure water. Subsequently, the reaction solution was diluted with 300 ml of toluene, and the separated lower layer was removed. The residue was washed twice with 100 g of a 5% aqueous solution of potassium hydroxide, twice with 100 ml of ultrapure water and 100 ml of a 3.0% aqueous solution of nitric acid, and five times with 100 g of ultrapure water in this order. After that, the organic layer was evaporated under reduced pressure to dryness. Thus, a compound (B1) was obtained.

### [Synthesis Example 2] Synthesis of Fluorine-Containing Diol Compound (B3) Containing Ester Structure

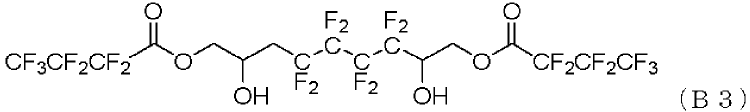

Under a nitrogen atmosphere, 20.0 g (63.6 mmol) of the epoxy compound (E1), 28.6 g (133.6 mmol) of the carboxylic acid compound (F4), 1.5 g (6.4 mmol) of benzyltriethylammonium chloride, and 100 g of 2-methoxy-1-propanol were mixed to form a homogeneous solution at an internal temperature of 80°C. The homogeneous solution was further stirred at an internal temperature of 100°C for 24 hours. The homogeneous solution was cooled to room temperature, and then 200 ml of toluene was added thereto. After that, the homogeneous solution was washed twice with 100 g of a 3% aqueous solution of NaHCO₃, twice with 100 g of ultrapure water and 100 g of a 3% aqueous solution of nitric acid, and five times with 100 g of ultrapure water in this order. After that, the organic layer was evaporated under reduced pressure to dryness. Thus, a compound (B3) was obtained.

The fluorine-containing diol compounds (B2), (B4), and (B5) to (B27) were obtained as products under the same reaction conditions as in Synthesis Example 1 or Synthesis Example 2, except that the epoxy compounds and hydroxy group-containing compounds shown in Table 1 were used. The synthesis method (Synthesis Example 1 or 2) used for the synthesis of the compound is also shown in the table.

**[Table 1]**

| Compound | Epoxy compound | | Hydroxy group-containing compound | | Used synthesis method |
|---|---|---|---|---|---|
| | Type | Charged amount (g) | Type | Charged amount (g) | |
| B1 | E1 | 20.0 | F1 | 32.1 | Synthesis Example 1 |
| B2 | E1 | 20.0 | F2 | 19.1 | Synthesis Example 1 |
| B3 | E1 | 20.0 | F3 | 28.6 | Synthesis Example 2 |
| B4 | E2 | 9.1 | F4 | 16.4 | Synthesis Example 1 |
| B5 | E2 | 9.1 | F1 | 32.1 | Synthesis Example 1 |
| B6 | E2 | 9.1 | F6 | 31.3 | Synthesis Example 1 |
| B7 | E2 | 9.1 | F7 | 34.0 | Synthesis Example 1 |
| B8 | E2 | 9.1 | F8 | 35.2 | Synthesis Example 1 |
| B9 | E3 | 12.9 | F2 | 19.1 | Synthesis Example 1 |
| B10 | E3 | 12.9 | F5 | 28.7 | Synthesis Example 1 |
| B11 | E3 | 12.9 | F8 | 35.2 | Synthesis Example 1 |
| B12 | E4 | 14.7 | F1 | 32.1 | Synthesis Example 1 |
| B13 | E4 | 14.7 | F9 | 50.4 | Synthesis Example 1 |
| B14 | E4 | 14.7 | F10 | 28.3 | Synthesis Example 2 |
| B15 | E5 | 11.1 | F5 | 28.7 | Synthesis Example 1 |
| B16 | E5 | 11.1 | F7 | 34.0 | Synthesis Example 1 |
| B17 | E5 | 11.1 | F11 | 39.4 | Synthesis Example 1 |
| B18 | E6 | 13.9 | F12 | 36.7 | Synthesis Example 1 |
| B19 | E6 | 13.9 | F11 | 27.5 | Synthesis Example 2 |
| B20 | E6 | 13.9 | F13 | 37.8 | Synthesis Example 1 |
| B21 | E6 | 13.9 | F10 | 28.3 | Synthesis Example 2 |
| B22 | E7 | 13.8 | F5 | 28.7 | Synthesis Example 1 |
| B23 | E7 | 13.8 | F11 | 27.5 | Synthesis Example 2 |
| B24 | E8 | 12.8 | F3 | 28.6 | Synthesis Example 2 |
| B25 | E8 | 12.8 | F12 | 32.1 | Synthesis Example 1 |
| B26 | E9 | 11.5 | F1 | 36.7 | Synthesis Example 1 |
| B27 | E9 | 11.5 | F10 | 28.4 | Synthesis Example 2 |

### [Synthesis Example 3]

### Synthesis of Fluorine-Containing Compound (B28)

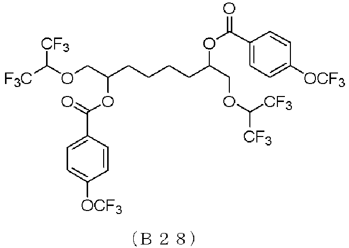

10.0 g of the fluorine-containing compound (B5), 5.8 g of pyridine, and 50 g of N-methylpyrrolidone were mixed to obtain, under a nitrogen atmosphere, a homogeneous solution in an ice bath. To the homogeneous solution, 14.1 g of 4-(trifluoromethoxy)benzoyl chloride was slowly added dropwise. After that, the mixture was stirred in an ice bath for 1 hour. After that, the temperature was raised to 40°C in an oil bath, and a reaction was allowed to take place for 12 hours. After the reaction was completed, 100 ml of IPE (diisopropyl ether) was added to the reaction solution, and then, while cooling in an ice bath, 50 g of ultrapure water was slowly added to quench the reaction. After the quenching, the reaction solution was transferred to a separating funnel, the aqueous layer was removed, and the organic layer was washed twice with 50 g of a 2% aqueous solution of NaHCO₃, twice with 50 g of a 3% aqueous solution of nitric acid, and six times with 50 g of pure water. After that, the organic layer was evaporated under reduced pressure to dryness. Thus, a fluorine-containing compound (B28) was obtained.

### Synthesis Example 4

### Synthesis of Fluorine-Containing Compound (B29)

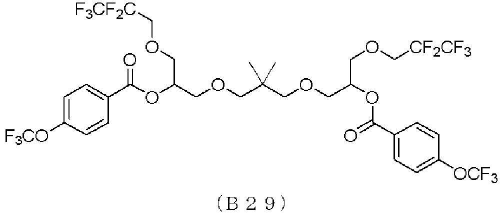

10.0 g of the fluorine-containing compound (B22), 5.4 g of pyridine, and 50 g of tetrahydrofuran were mixed to obtain, under a nitrogen atmosphere, a homogeneous solution in an ice bath. To the homogeneous solution, 13.0 g of 4-(trifluoromethoxy)benzoyl chloride was slowly added dropwise. After that, the mixture was stirred in an ice bath for 1 hour. After that, the temperature was raised to 50°C in an oil bath, and a reaction was allowed to take place for 12 hours. After the reaction was completed, 100 ml of IPE (diisopropyl ether) was added to the reaction solution, and then, while cooling in an ice bath, 50 g of ultrapure water was slowly added to quench the reaction. After the quenching, the reaction solution was transferred to a separating funnel, and the aqueous layer was removed. Subsequently, the organic layer was washed twice with 50 g of a 2% aqueous solution of NaHCO₃, twice with 50 g of a 3% aqueous solution of nitric acid, and six times with 50 g of pure water. After that, the organic layer was evaporated under reduced pressure to dryness. Thus, a fluorine-containing compound (B29) was obtained.

The structural formulae of the fluorine-containing compounds (B1) to (B29) obtained in the Synthesis Examples described above are shown below. In addition, the Mw and the ratio Mw/Mn of the obtained fluorine-containing compounds (B1) to (B29) are shown together in Table 2.

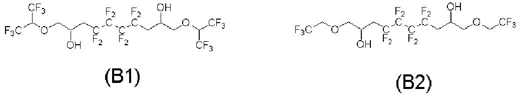

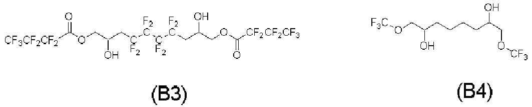

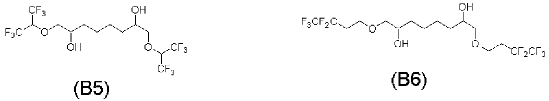

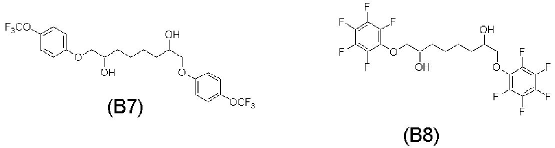

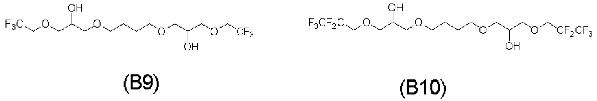

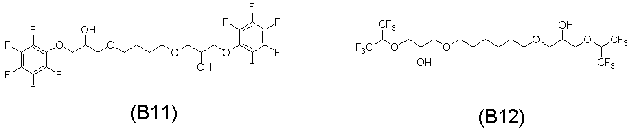

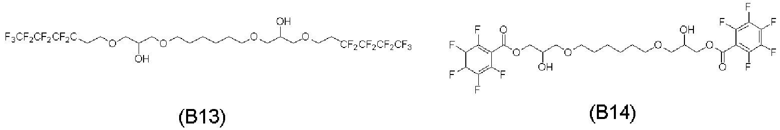

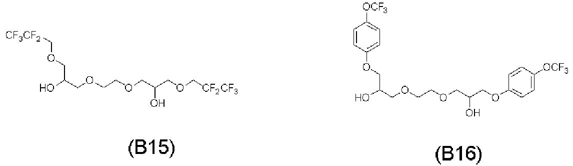

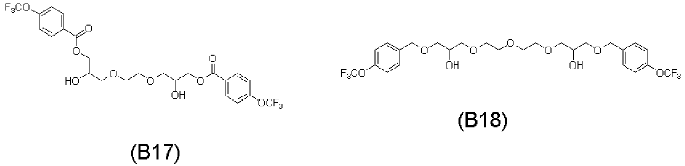

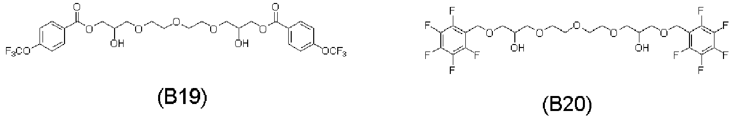

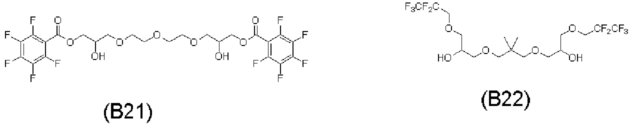

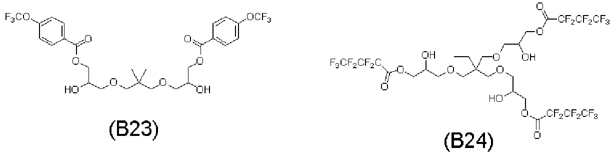

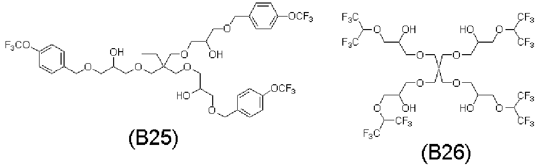

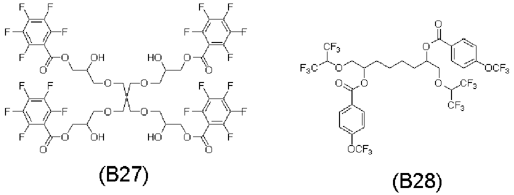

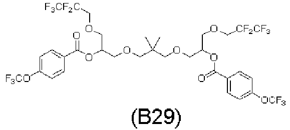

**[Table 2]**

| Fluorine-containing compound | Mw | Mw/Mn |
|---|---|---|
| (B1) | 660 | 1.01 |
| (B2) | 500 | 1.02 |
| (B3) | 780 | 1.03 |
| (B4) | 310 | 1.01 |
| (B5) | 530 | 1.00 |
| (B6) | 480 | 1.00 |
| (B7) | 560 | 1.04 |
| (B8) | 580 | 1.05 |
| (B9) | 400 | 1.00 |
| (B10) | 520 | 1.00 |
| (B11) | 600 | 1.02 |
| (B12) | 580 | 1.01 |
| (B13) | 800 | 1.00 |
| (B14) | 710 | 1.04 |
| (B15) | 470 | 1.00 |
| (B16) | 590 | 1.05 |
| (B17) | 610 | 1.01 |
| (B18) | 630 | 1.05 |
| (B19) | 650 | 1.03 |
| (B20) | 640 | 1.04 |
| (B21) | 650 | 1.02 |
| (B22) | 530 | 1.01 |
| (B23) | 650 | 1.02 |
| (B24) | 990 | 1.03 |
| (B25) | 940 | 1.02 |
| (B26) | 1000 | 1.01 |
| (B27) | 1300 | 1.03 |
| (B28) | 910 | 1.03 |
| (B29) | 940 | 1.03 |

### [Synthesis of Comparative Polymers (R1) to (R5)]

For the synthesis of comparative polymers (R1) to (R5), used for the preparation of comparative compositions (comparative UDL-1 to -10) for forming an organic film, the following monomers (b1) to (b6) were used.

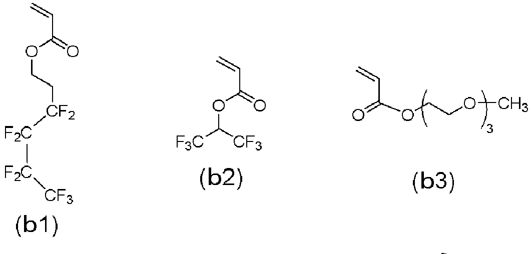

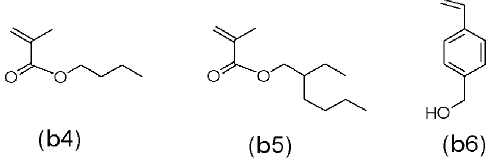

### [Comparative Synthesis Example 1] Synthesis of Comparative Polymer (R1)

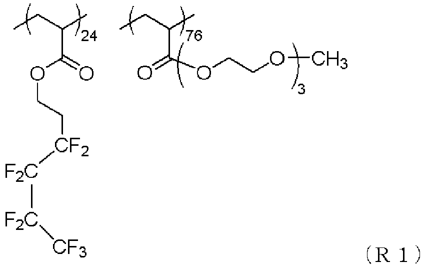

Under a nitrogen atmosphere, 6.0 g of propylene glycol monomethyl ether acetate (PGMEA) was heated and stirred at 80°C. A mixture of 3.44 g (0.011 mol) of the monomer (b1), 7.46 g (0.034 mol) of the monomer (b3), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R1) in PGMEA was obtained.

The weight-average molecular weight (Mw) and the dispersity (Mw/Mn) were determined by GPC, and the following results were obtained.
(R1): Mw=9500, Mw/Mn=1.20

### [Comparative Synthesis Example 2] Synthesis of Comparative Polymer (R2)

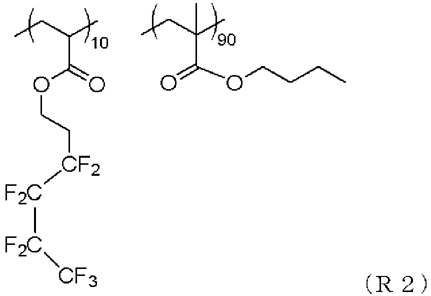

Under a nitrogen atmosphere, 6.0 g of propylene glycol monomethyl ether acetate (PGMEA) was heated and stirred at 80°C. A mixture of 1.43 g (0.005 mol) of the monomer (b1), 5.76 g (0.041 mol) of the monomer (b4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R2) in PGMEA was obtained.

The weight-average molecular weight (Mw) and the dispersity (Mw/Mn) were determined by GPC, and the following results were obtained.
(R2): Mw=5800, Mw/Mn=1.42

### [Comparative Synthesis Example 3] Synthesis of Comparative Polymer (R3)

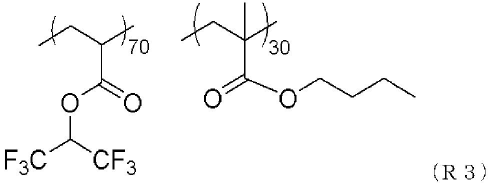

Under a nitrogen atmosphere, 6.0 g of propylene glycol monomethyl ether acetate (PGMEA) was heated and stirred at 80°C. A mixture of 7.00 g (0.032 mol) of the monomer (b2), 1.92 g (0.014 mol) of the monomer (b4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R3) in PGMEA was obtained.

The weight-average molecular weight (Mw) and the dispersity (Mw/Mn) were determined by GPC, and the following results were obtained.
(R3): Mw=6200, Mw/Mn=1.33

### [Comparative Synthesis Example 4] Synthesis of Comparative Polymer (R4)

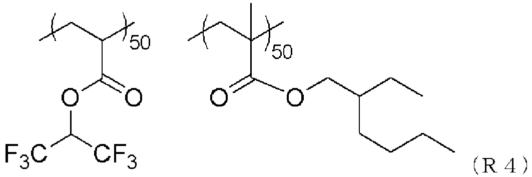

Under a nitrogen atmosphere, 6.0 g of propylene glycol monomethyl ether acetate (PGMEA) was heated and stirred at 80°C. A mixture of 5.00 g (0.023 mol) of the monomer (b2), 3.20 g (0.023 mol) of the monomer (b5), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R4) in PGMEA was obtained.

The weight-average molecular weight (Mw) and the dispersity (Mw/Mn) were determined by GPC, and the following results were obtained.
(R4): Mw=8300, Mw/Mn=1.33

### [Comparative Synthesis Example 5] Synthesis of Comparative Polymer (R5)

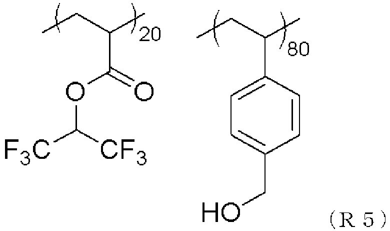

Under a nitrogen atmosphere, 6.0 g of propylene glycol monomethyl ether acetate (PGMEA) was heated and stirred at 80°C. A mixture of 2.00 g (0.009 mol) of the monomer (b2), 5.41 g (0.036 mol) of the monomer (b6), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R5) in PGMEA was obtained.

The weight-average molecular weight (Mw) and the dispersity (Mw/Mn) were determined by GPC, and the following results were obtained.
(R5): Mw=3800, Mw/Mn=1.44

### [Resin or Compound (A) for Forming Organic Film]

A1: a resin represented by the following formula (A1)
A2: a resin represented by the following formula (A2)
A3: a compound represented by the following formula (A3)
A4: a compound represented by the following formula (A4)
A5: a resin represented by the following formula (A5)
A6: a resin represented by the following formula (A6)

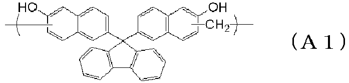

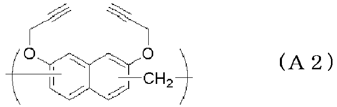

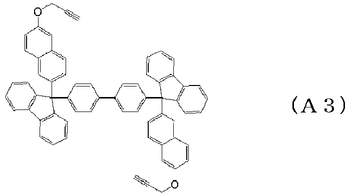

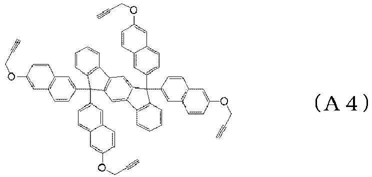

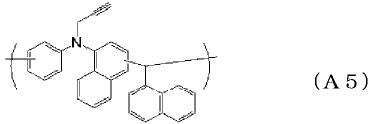

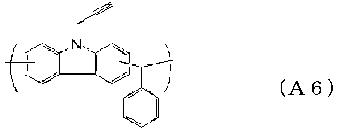

### [Solvent]

(Cl): propylene glycol monomethyl ether acetate
(C2): propylene glycol monoethyl ether

### [Preparation of Compositions (UDL-1 to -56 and Comparative UDL-1 to -16) for Forming Organic Film]

One of the fluorine-containing compounds (B1) to (B29) and comparative polymers (R1) to (R5) and one of the resins and compounds (A1) to (A6) for forming an organic film were dissolved in the solvent (C1) and/or (C2) in the proportions shown in Table 3 and Table 4, and the mixture was filtered through a 0.1-µm filter made of a fluorinated resin to prepare each of compositions (resist underlayer film materials: UDL-1 to -56 and comparative UDL-1 to -10) for forming an organic film. Meanwhile, one of the resins and compounds (A1) to (A6) for forming an organic film was dissolved in the solvent (C1) in the proportions shown in Table 4, and the mixture was filtered through a 0.1-µm filter made of a fluorinated resin to prepare each of compositions (resist underlayer film materials: comparative UDL-11 to -16) for forming an organic film.

**[Table 3]**

| Composition for forming organic film | Resin or compound for forming organic film | | Fluorine-containing compound | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (A1) | 10.00 | (B1) | 0.10 | (C1) | 89.90 | | |
| UDL-2 | (A1) | 10.00 | (B2) | 0.10 | (C1) | 89.90 | | |
| UDL-3 | (A1) | 10.00 | (B3) | 0.10 | (C1) | 89.90 | | |
| UDL-4 | (A1) | 10.00 | (B4) | 0.10 | (C1) | 89.90 | | |
| UDL-5 | (A1) | 10.00 | (B5) | 0.10 | (C1) | 89.90 | | |
| UDL-6 | (A1) | 10.00 | (B6) | 0.10 | (C1) | 89.90 | | |
| UDL-7 | (A1) | 10.00 | (B7) | 0.10 | (C1) | 89.90 | | |
| UDL-8 | (A1) | 10.00 | (B8) | 0.10 | (C1) | 89.90 | | |
| UDL-9 | (A1) | 10.00 | (B9) | 0.10 | (C1) | 89.90 | | |
| UDL-10 | (A1) | 10.00 | (B10) | 0.10 | (C1) | 89.90 | | |
| UDL-11 | (A1) | 10.00 | (B11) | 0.10 | (C1) | 89.90 | | |
| UDL-12 | (A1) | 10.00 | (B12) | 0.10 | (C1) | 89.90 | | |
| UDL-13 | (A1) | 10.00 | (B13) | 0.10 | (C1) | 89.90 | | |
| UDL-14 | (A1) | 10.00 | (B14) | 0.10 | (C1) | 89.90 | | |
| UDL-15 | (A1) | 10.00 | (B15) | 0.10 | (C1) | 89.90 | | |
| UDL-16 | (A1) | 10.00 | (B16) | 0.10 | (C1) | 89.90 | | |
| UDL-17 | (A1) | 10.00 | (B17) | 0.10 | (C1) | 89.90 | | |
| UDL-18 | (A1) | 10.00 | (B18) | 0.10 | (C1) | 89.90 | | |
| UDL-19 | (A1) | 10.000 | (B19) | 0.10 | (C1) | 89.90 | | |
| UDL-20 | (A1) | 10.00 | (B20) | 0.10 | (C1) | 89.90 | | |
| UDL-21 | (A1) | 10.00 | (B21) | 0.10 | (C1) | 89.90 | | |
| UDL-22 | (A1) | 10.00 | (B22) | 0.10 | (C1) | 89.90 | | |
| UDL-23 | (A1) | 10.00 | (B23) | 0.10 | (C1) | 89.90 | | |
| UDL-24 | (A1) | 10.00 | (B24) | 0.10 | (C1) | 89.90 | | |
| UDL-25 | (A1) | 10.00 | (B25) | 0.10 | (C1) | 89.90 | | |
| UDL-26 | (A1) | 10.00 | (B26) | 0.10 | (C1) | 89.90 | | |
| UDL-27 | (A1) | 10.00 | (B27) | 0.10 | (C1) | 89.90 | | |
| UDL-28 | (A1) | 10.00 | (B28) | 0.10 | (C1) | 89.90 | | |
| UDL-29 | (A1) | 10.00 | (B29) | 0.10 | (C1) | 89.90 | | |
| UDL-30 | (A1) | 10.00 | (B6) | 0.10 | (C1) | 62.93 | (C2) | 26.97 |
| UDL-31 | (A1) | 10.00 | (B11) | 0.10 | (C1) | 62.93 | (C2) | 26.97 |
| UDL-32 | (A1) | 10.00 | (B16) | 0.10 | (C1) | 62.93 | (C2) | 26.97 |
| UDL-33 | (A1) | 10.00 | (B25) | 0.10 | (C1) | 62.93 | (C2) | 26.97 |
| UDL-34 | (A1) | 10.00 | (B16) | 1.000 | (C1) | 89.00 | | |
| UDL-35 | (A1) | 10.00 | (B16) | 0.500 | (C1) | 89.50 | | |

**[Table 4]**

| Composition for forming organic film | Resin or compound for forming organic film | | Fluorine-containing compound or comparative polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-36 | (A1) | 10.00 | (B16) | 0.001 | (C1) | 90.00 | | |
| UDL-37 | (A2) | 10.00 | (B6) | 0.10 | (C1) | 89.90 | | |
| UDL-38 | (A2) | 10.00 | (B11) | 0.10 | (C1) | 89.90 | | |
| UDL-39 | (A2) | 10.00 | (B12) | 0.10 | (C1) | 89.90 | | |
| UDL-40 | (A2) | 10.00 | (B25) | 0.10 | (C1) | 89.90 | | |
| UDL-41 | (A3) | 10.00 | (B6) | 0.10 | (C1) | 89.90 | | |
| UDL-42 | (A3) | 10.00 | (B11) | 0.10 | (C1) | 89.90 | | |
| UDL-43 | (A3) | 10.00 | (B12) | 0.10 | (C1) | 89.90 | | |
| UDL-44 | (A3) | 10.00 | (B25) | 0.10 | (C1) | 89.90 | | |
| UDL-45 | (A4) | 10.00 | (B6) | 0.10 | (C1) | 89.90 | | |
| UDL-46 | (A4) | 10.00 | (B11) | 0.10 | (C1) | 89.90 | | |
| UDL-47 | (A4) | 10.00 | (B12) | 0.10 | (C1) | 89.90 | | |
| UDL-48 | (A4) | 10.00 | (B25) | 0.10 | (C1) | 89.90 | | |
| UDL-49 | (A5) | 10.00 | (B6) | 0.10 | (C1) | 89.90 | | |
| UDL-50 | (A5) | 10.00 | (B11) | 0.10 | (C1) | 89.90 | | |
| UDL-51 | (A5) | 10.00 | (B12) | 0.10 | (C1) | 89.90 | | |
| UDL-52 | (A5) | 10.00 | (B25) | 0.10 | (C1) | 89.90 | | |
| UDL-53 | (A6) | 10.00 | (B6) | 0.10 | (C1) | 89.90 | | |
| UDL-54 | (A6) | 10.00 | (B11) | 0.10 | (C1) | 89.90 | | |
| UDL-55 | (A6) | 10.00 | (B12) | 0.10 | (C1) | 89.90 | | |
| UDL-56 | (A6) | 10.00 | (B25) | 0.10 | (C1) | 89.90 | | |
| Comparative UDL-1 | (A1) | 10.00 | (R1) | 0.10 | (C1) | 89.90 | | |
| Comparative UDL-2 | (A2) | 10.00 | (R1) | 0.10 | (C1) | 89.90 | | |
| Comparative UDL-3 | (A3) | 10.00 | (R1) | 0.10 | (C1) | 89.90 | | |
| Comparative UDL-4 | (A4) | 10.00 | (R1) | 0.10 | (C1) | 89.90 | | |
| Comparative UDL-5 | (A5) | 10.00 | (R1) | 0.10 | (C1) | 89.90 | | |
| Comparative UDL-6 | (A6) | 10.00 | (R1) | 0.10 | (C1) | 89.90 | | |
| Comparative UDL-7 | (A1) | 10.00 | (R2) | 0.10 | (C1) | 89.90 | | |
| Comparative UDL-8 | (A1) | 10.00 | (R3) | 0.10 | (C1) | 89.90 | | |
| Comparative UDL-9 | (A1) | 10.00 | (R4) | 0.10 | (C1) | 89.90 | | |
| Comparative UDL-10 | (A1) | 10.00 | (R5) | 0.10 | (C1) | 89.90 | | |
| Comparative UDL-11 | (A1) | 10.00 | | | (C1) | 90.00 | | |
| Comparative UDL-12 | (A2) | 10.00 | | | (C1) | 90.00 | | |
| Comparative UDL-13 | (A3) | 10.00 | | | (C1) | 90.00 | | |
| Comparative UDL-14 | (A4) | 10.00 | | | (C1) | 90.00 | | |
| Comparative UDL-15 | (A5) | 10.00 | | | (C1) | 90.00 | | |
| Comparative UDL-16 | (A6) | 10.00 | | | (C1) | 90.00 | | |

### [Preparation of Silicon Wafers Having Organic Underlayer Film Formed Thereon By Using Compositions (UDL-1 to -56 and Comparative UDL-1 to -16) for Forming Organic Film]

Using a coater/developer "CLEAN TRACK LITHIUS Pro AP" of Tokyo Electron Ltd., each of the compositions (UDL-1 to -56 and comparative UDL-1 to -16) for forming an organic film prepared above was respectively discharged in an amount of 2 ml onto a silicon wafer at the center. Then, the wafer was rotated at a rotational rate to achieve, after baking, the average film thickness shown in Tables 5 and 6 to spread the composition. Thus, a coating film of the composition for forming an organic film was formed. While rotating the silicon wafer at a rate of 1000 rpm, the remover-discharging nozzle was moved at a speed of 5 mm/s from the periphery of the silicon wafer to a position 3 mm from the center while discharging a remover (mixed solution of propylene glycol monomethyl ether acetate and propylene glycol monomethyl ether (30:70, mass ratio)) at a discharge rate of 2 ml/s, and the remover was further discharged at that position for 5 seconds at a discharge rate of 2 ml/s. After that, the discharging of the discharged liquid was terminated, and the silicon wafer was further rotated at a rate of 1000 rpm for 30 seconds. Next, the silicon wafer was heated at 350°C for 60 seconds. Thus, silicon wafers having an organic underlayer film (organic cured film) of each example formed were obtained.

### [Solvent Resistance Evaluation: Examples 1-1 to 1-56 and Comparative Examples 1-1 to 1-16]

An organic underlayer film was formed on a silicon wafer according to the above-described method by using each of the compositions (UDL-1 to -56 and comparative UDL-1 to -16) for forming an organic film, and the film thickness of the organic underlayer film was measured. Subsequently, a PGMEA solvent was dispensed on each organic underlayer film, left to stand for 30 seconds, spin-dried, and baked at 100°C for 60 seconds to evaporate the PGMEA, and then the film thickness of the organic underlayer film was measured. The absolute value of the value determined by (X₁-X)/X × 100 was obtained as a film thickness change rate (%), where X is the film thickness before dispensing the PGMEA solvent, and X₁ is the film thickness after the PGMEA solvent was dispensed. When the film thickness change rate was lower than 0.5%, the composition was evaluated as "Good", and when 0.5% or higher, "Poor". Tables 5 and 6 below show the results.

### [In-Plane Uniformity Evaluation: Examples 1-1 to 1-56 and Comparative Examples 1-1 to 1-16]

An organic underlayer film was formed on a silicon wafer according to the above-described method by using each of the compositions (UDL-1 to -56 and comparative UDL-1 to -16) for forming an organic film, and the film thickness within a radius of 145 mm from the center of the organic underlayer film was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 2%, the composition was evaluated as A (good), when 2% or more to less than 3%, B, and when 3% or more, C (poor). Tables 5 and 6 below show the results.

### [Contact Angle Evaluation: Examples 1-1 to 1-56 and Comparative Examples 1-1 to 1-16]

An organic underlayer film was formed respectively on a silicon wafer by using each of the compositions (UDL-1 to -56 and comparative UDL-1 to -16) for forming an organic film according to the above-described method, and the contact angle of each organic underlayer film with pure water was measured. Note that, regarding comparative UDL-11 to -16, the measurement was not carried out, since in-plane uniformity was poor. Tables 5 and 6 below show the results.

**[Table 5]**

| | Composition for forming organic film | Average film thickness | Solvent resistance | In-plane uniformity | Contact angle |
|---|---|---|---|---|---|
| Example 1-1 | UDL-1 | 500 nm | Good | B | 66° |
| Example 1-2 | UDL-2 | 500 nm | Good | B | 66° |
| Example 1-3 | UDL-3 | 500 nm | Good | B | 67° |
| Example 1-4 | UDL-4 | 500 nm | Good | A | 61° |
| Example 1-5 | UDL-5 | 500 nm | Good | A | 61° |
| Example 1-6 | UDL-6 | 500 nm | Good | A | 62° |
| Example 1-7 | UDL-7 | 500 nm | Good | A | 62° |
| Example 1-8 | UDL-8 | 500 nm | Good | B | 61° |
| Example 1-9 | UDL-9 | 500 nm | Good | A | 63° |
| Example 1-10 | UDL-10 | 500 nm | Good | A | 63° |
| Example 1-11 | UDL-11 | 500 nm | Good | B | 62° |
| Example 1-12 | UDL-12 | 500 nm | Good | A | 62° |
| Example 1-13 | UDL-13 | 500 nm | Good | A | 63° |
| Example 1-14 | UDL-14 | 500 nm | Good | B | 62° |
| Example 1-15 | UDL-15 | 500 nm | Good | A | 62° |
| Example 1-16 | UDL-16 | 500 nm | Good | A | 61° |
| Example 1-17 | UDL-17 | 500 nm | Good | A | 61° |
| Example 1-18 | UDL-18 | 500 nm | Good | A | 62° |
| Example 1-19 | UDL-19 | 500 nm | Good | A | 63° |
| Example 1-20 | UDL-20 | 500 nm | Good | B | 62° |
| Example 1-21 | UDL-21 | 500 nm | Good | B | 61° |
| Example 1-22 | UDL-22 | 500 nm | Good | A | 63° |
| Example 1-23 | UDL-23 | 500 nm | Good | A | 61° |
| Example 1-24 | UDL-24 | 500 nm | Good | A | 63° |
| Example 1-25 | UDL-25 | 500 nm | Good | A | 63° |
| Example 1-26 | UDL-26 | 500 nm | Good | A | 62° |
| Example 1-27 | UDL-27 | 500 nm | Good | B | 63° |
| Example 1-28 | UDL-28 | 500 nm | Good | A | 66° |
| Example 1-29 | UDL-29 | 500 nm | Good | A | 66° |
| Example 1-30 | UDL-30 | 500 nm | Good | A | 62° |
| Example 1-31 | UDL-31 | 500 nm | Good | B | 62° |
| Example 1-32 | UDL-32 | 500 nm | Good | A | 61° |
| Example 1-33 | UDL-33 | 500 nm | Good | A | 63° |
| Example 1-34 | UDL-34 | 500 nm | Good | A | 63° |
| Example 1-35 | UDL-35 | 500 nm | Good | A | 62° |

**[Table 6]**

| | Composition for forming organic film | Average film thickness | Solvent resistance | In-plane uniformity | Contact angle |
|---|---|---|---|---|---|
| Example 1-36 | UDL-36 | 500 nm | Good | A | 60° |
| Example 1-37 | UDL-37 | 500 nm | Good | A | 63° |
| Example 1-38 | UDL-38 | 500 nm | Good | B | 63° |
| Example 1-39 | UDL-39 | 500 nm | Good | A | 61° |
| Example 1-40 | UDL-40 | 500 nm | Good | A | 62° |
| Example 1-41 | UDL-41 | 500 nm | Good | A | 63° |
| Example 1-42 | UDL-42 | 500 nm | Good | B | 63° |
| Example 1-43 | UDL-43 | 500 nm | Good | A | 62° |
| Example 1-44 | UDL-44 | 500 nm | Good | A | 63° |
| Example 1-45 | UDL-45 | 500 nm | Good | A | 61° |
| Example 1-46 | UDL-46 | 500 nm | Good | B | 63° |
| Example 1-47 | UDL-47 | 500 nm | Good | A | 63° |
| Example 1-48 | UDL-48 | 500 nm | Good | A | 62° |
| Example 1-49 | UDL-49 | 500 nm | Good | A | 61° |
| Example 1-50 | UDL-50 | 500 nm | Good | B | 61° |
| Example 1-51 | UDL-51 | 500 nm | Good | A | 62° |
| Example 1-52 | UDL-52 | 500 nm | Good | A | 63° |
| Example 1-53 | UDL-53 | 500 nm | Good | A | 61° |
| Example 1-54 | UDL-54 | 500 nm | Good | B | 61° |
| Example 1-55 | UDL-55 | 500 nm | Good | A | 63° |
| Example 1-56 | UDL-56 | 500 nm | Good | A | 64° |
| Comparative Example 1-1 | Comparative UDL-1 | 500 nm | Good | A | 75° |
| Comparative Example 1-2 | Comparative UDL-2 | 500 nm | Good | A | 75° |
| Comparative Example 1-3 | Comparative UDL-3 | 500 nm | Good | A | 75° |
| Comparative Example 1-4 | Comparative UDL-4 | 500 nm | Good | A | 75° |
| Comparative Example 1-5 | Comparative UDL-5 | 500 nm | Good | A | 75° |
| Comparative Example 1-6 | Comparative UDL-6 | 500 nm | Good | A | 75° |
| Comparative Example 1-7 | Comparative UDL-7 | 500 nm | Good | A | 90° |
| Comparative Example 1-8 | Comparative UDL-8 | 500 nm | Good | A | 93° |
| Comparative Example 1-9 | Comparative UDL-9 | 500 nm | Good | A | 95° |
| Comparative Example 1-10 | Comparative UDL-10 | 500 nm | Good | A | 74° |
| Comparative Example 1-11 | Comparative UDL-11 | 500 nm | Good | C | - |
| Comparative Example 1-12 | Comparative UDL-12 | 500 nm | Good | C | - |
| Comparative Example 1-13 | Comparative UDL-13 | 500 nm | Good | C | - |
| Comparative Example 1-14 | Comparative UDL-14 | 500 nm | Good | C | - |
| Comparative Example 1-15 | Comparative UDL-15 | 500 nm | Good | C | - |
| Comparative Example 1-16 | Comparative UDL-16 | 500 nm | Good | C | - |

As shown in Tables 5 and 6, in Examples 1-1 to 1-56, where the inventive compositions for forming an organic film were used, organic underlayer films excellent in both solvent resistance and in-plane uniformity and having a contact angle of 60° or higher and 67° or lower with pure water were obtained. An organic underlayer film that exhibits such a contact angle is excellent in the coating property of a silicon-containing resist middle layer film thereon. On the other hand, in Comparative Examples 1-11 to 1-16 out of Comparative Examples 1-1 to 1-16, where compositions not containing a fluorine-containing compound, contained in the inventive compositions for forming an organic film, were used, in-plane uniformity was poor. Therefore, in the following evaluations, UDL-1 to -56 and comparative UDL-1 to -10, which were excellent in both solvent resistance and in-plane uniformity, were considered. Meanwhile, the organic underlayer films of Comparative Examples 1-1 to 1-10 had a contact angle of 74° or higher with pure water, and since the contact angle was high and hydrophobicity was strong, the coating property of the silicon-containing resist middle layer film was poor. By controlling the condition of the film surface to have a suitable contact angle as described above, it is possible to form an organic underlayer film excellent in the film-formability of a silicon-containing middle layer film on the organic underlayer film.

### [Hump Suppression Property Evaluation: Examples 2-1 to 2-56 and Comparative Examples 2-1 to 2-10]

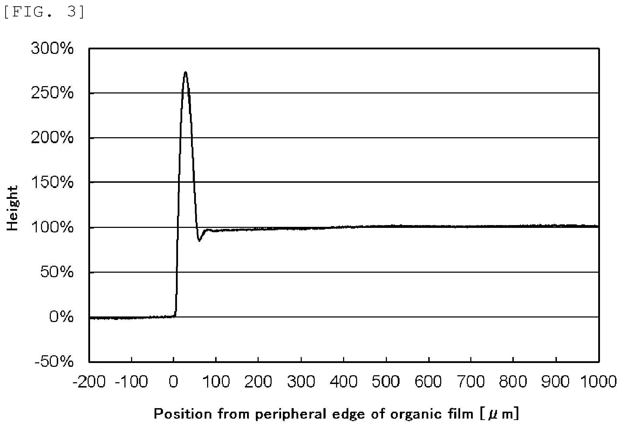

An organic underlayer film was formed on a silicon wafer according to the above-described method by using each of the compositions (UDL-1 to -56 and comparative UDL-1 to -10) for forming an organic film, and the variation in height from the peripheral edge of the organic underlayer film towards the center of the silicon wafer to a position of 1000 µm was measured by using Alpha-Step D-600 (a stylus profiler) manufactured by KLA corporation. The height of the silicon wafer was regarded as 0, and when the maximum height was less than 110% of the film thickness as shown in FIG. 2, the composition was evaluated as A (good), when the maximum height was 110% or more to less than 150%, B, and when a region where the height was 150% or more occurred as shown in FIG. 3, C (poor).

### [Filling Property Evaluation: Examples 2-1 to 2-56 and Comparative Examples 2-1 to 2-10]

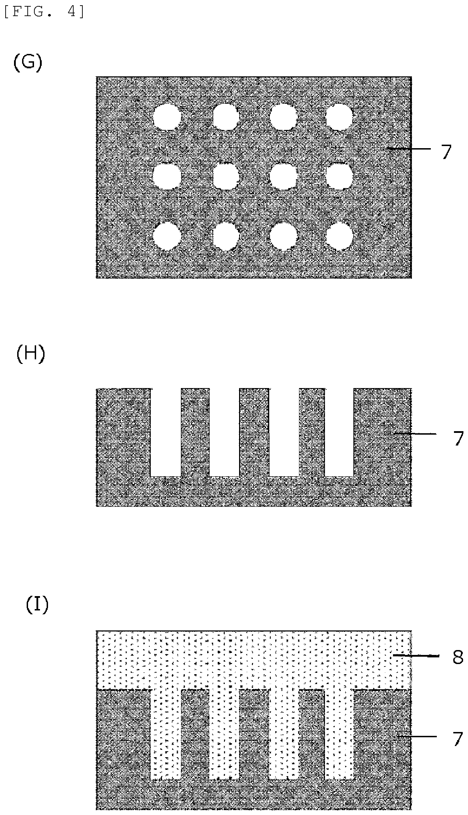

As shown in FIG. 4, a resist underlayer film (organic underlayer film) 8 was formed on an SiO₂ wafer substrate having a dense hole pattern (hole diameter 0.2 µm, hole depth 1.0 µm, distance between the centers of two adjacent holes 0.4 µm) by using each of the compositions (UDL-1 to -56 and comparative UDL-1 to -10) for forming an organic film respectively according to the above-described method. The substrate used was a base substrate (SiO₂ wafer substrate) 7 having the dense hole pattern shown in FIG. 4 (G) (downward view) and (H) (cross-sectional view). The cross-sectional shape of each of the obtained wafer substrates was observed using a scanning electron microscope (SEM), and it was observed whether or not the inside of the holes was filled with the resist underlayer film without gaps. When a composition for forming an organic film having poor filling property is used, gaps are generated inside the holes. When a composition for forming an organic film having a desirable filling property is used in the present evaluation, the inside of the holes is filled with the organic underlayer film without gaps, as shown in FIG. 4 (I). The composition was evaluated as "Good" when no gaps were generated, and when gaps were generated, as "Poor".

### [Silicon-Containing Resist Middle Layer Film Coating Property Evaluation: Examples 2-1 to 2-56 and Comparative Examples 2-1 to 2-10]

An organic underlayer film was formed respectively on a silicon wafer substrate by using each of the compositions (UDL-1 to -56 and comparative UDL-1 to -10) for forming an organic film according to the above-described method. The silicon-containing resist middle layer film material (SOG1) described below was applied to the formed organic underlayer film, and baking was performed at 200°C for 60 seconds to form a silicon-containing resist middle layer film. Then, the condition of the coating film of the silicon-containing resist middle layer film was visually observed and evaluated.

When the condition of the coating film of the silicon-containing resist middle layer film was good, the composition was evaluated as "Good", and when dewetting had occurred, as "Poor". Tables 8 and 9 below show the results.

Note that, in this evaluation, to evaluate whether the coatability of the silicon-containing resist middle layer film is excellent or not, the thickness of the silicon-containing resist middle layer film was set to 5 nm, and this is a special, severe evaluation condition.

The silicon-containing resist middle layer film material (SOG1) was prepared by dissolving a polymer (SP1), a crosslinking catalyst, and an acid in an organic solvent and water in the proportions of Table 7, and filtering the mixture through a 0.1-µm filter made of a fluororesin.

**[Table 7]**

| | Polymer (parts by mass) | Crosslinking catalyst (parts by mass) | Acid (parts by mass) | Organic solvent (parts by mass) | Water (parts by mass) |
|---|---|---|---|---|---|
| SOG1 | SP1 (100) | TMPANO₃ (1) | Maleic acid (1) | PGEE (44100) | Water (4900) |

The polymer (SP1) is shown below. 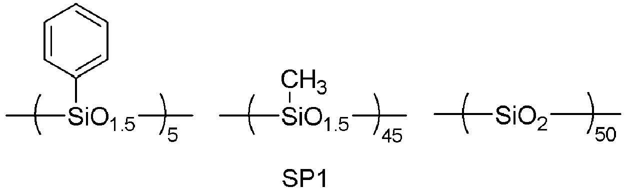
TMPANO₃: trimethylphenylammonium nitrate
PGEE: propylene glycol ethyl ether

**[Table 8]**

| | Composition for forming organic film | Hump suppression property | Filling property | Silicon-containing resist middle layer film coating property |
|---|---|---|---|---|
| Example 2-1 | UDL-1 | Good | B | Good |
| Example 2-2 | UDL-2 | Good | B | Good |
| Example 2-3 | UDL-3 | Good | B | Good |
| Example 2-4 | UDL-4 | Good | A | Good |
| Example 2-5 | UDL-5 | Good | A | Good |
| Example 2-6 | UDL-6 | Good | A | Good |
| Example 2-7 | UDL-7 | Good | A | Good |
| Example 2-8 | UDL-8 | Good | A | Good |
| Example 2-9 | UDL-9 | Good | A | Good |
| Example 2-10 | UDL-10 | Good | A | Good |
| Example 2-11 | UDL-11 | Good | A | Good |
| Example 2-12 | UDL-12 | Good | A | Good |
| Example 2-13 | UDL-13 | Good | A | Good |
| Example 2-14 | UDL-14 | Good | A | Good |
| Example 2-15 | UDL-15 | Good | A | Good |
| Example 2-16 | UDL-16 | Good | A | Good |
| Example 2-17 | UDL-17 | Good | A | Good |
| Example 2-18 | UDL-18 | Good | A | Good |
| Example 2-19 | UDL-19 | Good | A | Good |
| Example 2-20 | UDL-20 | Good | A | Good |
| Example 2-21 | UDL-21 | Good | A | Good |
| Example 2-22 | UDL-22 | Good | A | Good |
| Example 2-23 | UDL-23 | Good | A | Good |
| Example 2-24 | UDL-24 | Good | A | Good |
| Example 2-25 | UDL-25 | Good | A | Good |
| Example 2-26 | UDL-26 | Good | A | Good |
| Example 2-27 | UDL-27 | Good | A | Good |
| Example 2-28 | UDL-28 | Good | B | Good |
| Example 2-29 | UDL-29 | Good | B | Good |
| Example 2-30 | UDL-30 | Good | A | Good |
| Example 2-31 | UDL-31 | Good | A | Good |
| Example 2-32 | UDL-32 | Good | A | Good |
| Example 2-33 | UDL-33 | Good | A | Good |
| Example 2-34 | UDL-34 | Good | A | Good |
| Example 2-35 | UDL-35 | Good | A | Good |

**[Table 9]**

| | Composition for forming organic film | Hump suppression property | Filling property | Silicon-containing resist middle layer film coating property |
|---|---|---|---|---|
| Example 2-36 | UDL-36 | Good | A | Good |
| Example 2-37 | UDL-37 | Good | A | Good |
| Example 2-38 | UDL-38 | Good | A | Good |
| Example 2-39 | UDL-39 | Good | A | Good |
| Example 2-40 | UDL-40 | Good | A | Good |
| Example 2-41 | UDL-41 | Good | A | Good |
| Example 2-42 | UDL-42 | Good | A | Good |
| Example 2-43 | UDL-43 | Good | A | Good |
| Example 2-44 | UDL-44 | Good | A | Good |
| Example 2-45 | UDL-45 | Good | A | Good |
| Example 2-46 | UDL-46 | Good | A | Good |
| Example 2-47 | UDL-47 | Good | A | Good |
| Example 2-48 | UDL-48 | Good | A | Good |
| Example 2-49 | UDL-49 | Good | A | Good |
| Example 2-50 | UDL-50 | Good | A | Good |
| Example 2-51 | UDL-51 | Good | A | Good |
| Example 2-52 | UDL-52 | Good | A | Good |
| Example 2-53 | UDL-53 | Good | A | Good |
| Example 2-54 | UDL-54 | Good | A | Good |
| Example 2-55 | UDL-55 | Good | A | Good |
| Example 2-56 | UDL-56 | Good | A | Good |
| Comparative Example 2-1 | Comparative UDL-1 | Poor | C | Poor |
| Comparative Example 2-2 | Comparative UDL-2 | Poor | C | Poor |
| Comparative Example 2-3 | Comparative UDL-3 | Poor | C | Poor |
| Comparative Example 2-4 | Comparative UDL-4 | Poor | C | Poor |
| Comparative Example 2-5 | Comparative UDL-5 | Poor | C | Poor |
| Comparative Example 2-6 | Comparative UDL-6 | Poor | C | Poor |
| Comparative Example 2-7 | Comparative UDL-7 | Poor | C | Poor |
| Comparative Example 2-8 | Comparative UDL-8 | Poor | C | Poor |
| Comparative Example 2-9 | Comparative UDL-9 | Poor | C | Poor |
| Comparative Example 2-10 | Comparative UDL-10 | Poor | A | Poor |

As shown in Tables 8 and 9, it was confirmed that the compositions (UDL-1 to -56) for forming an organic film, which are Examples of the present invention, were excellent in solvent resistance, in-plane uniformity, hump suppression property, filling property, and the coating property of the silicon-containing resist middle layer film.

### [Patterning Test: Examples 3-1 to 3-56]

An organic underlayer film was formed respectively on an SiO₂ wafer substrate by using each of the compositions (UDL-1 to -56) for forming an organic film according to the above-described method. Subsequently, the silicon-containing resist middle layer film material (SOG2) described below was applied to the organic underlayer film, and baking was performed at 200°C for 60 seconds to form a 35-nm thick silicon-containing resist middle layer film. Subsequently, the monolayer resist for ArF described below was applied to the silicon-containing resist middle layer film as a resist upper layer film material and baked at 105°C for 60 seconds to form a 100-nm thick photoresist film. Subsequently, the liquid immersion top coat composition (TC-1) described below was applied to the photoresist film and baked at 90°C for 60 seconds to form a 50-nm thick top coat.

As the silicon-containing resist underlayer film material (SOG2), used was a material prepared by dissolving a polymer (SP1), a crosslinking catalyst, and an acid in an organic solvent and water in the proportions of Table 10, and filtering the mixture through a 0.1-µm filter made of a fluororesin.

**[Table 10]**

| | Polymer (parts by mass) | Crosslinking catalyst (parts by mass) | Acid (parts by mass) | Organic solvent (parts by mass) | Water (parts by mass) |
|---|---|---|---|---|---|
| SOG2 | SP1 (100) | TMPANO₃ (1) | Maleic acid (1) | PGEE (4410) | Water (490) |

As the resist upper layer film material (monolayer resist for ArF), used was a material prepared by dissolving a polymer (RP1), an acid generator (PAG1), and a basic compound (Amine1), each in the proportion shown in Table 11, in a solvent containing 0.1% by mass of FC-430 (manufactured by Sumitomo 3M Limited), and filtering the obtained mixture through a 0.1-µm filter made of a fluororesin.

**[Table 11]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) are shown below.

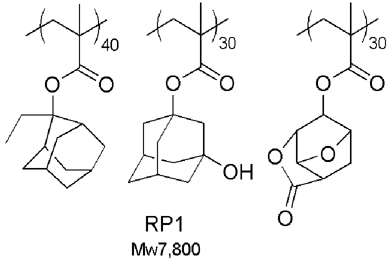

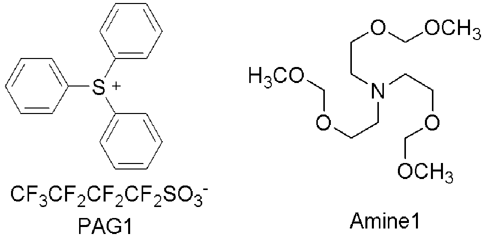

As the liquid immersion top coat composition (TC-1), used was a composition prepared by dissolving a polymer (PP1) in an organic solvent at the proportion shown in Table 12, and filtering the obtained mixture through a 0.1-µm filter made of a fluororesin.

**[Table 12]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) is shown below.

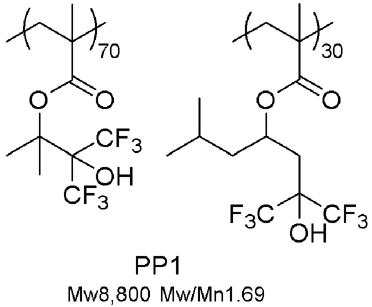

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern) .

Subsequently, using an etching apparatus Telius manufactured by Tokyo Electron Ltd., the silicon-containing resist middle layer film was dry-etched (the pattern was transferred) while using the resist upper layer film pattern as a mask to obtain a silicon-containing resist middle layer film pattern; the organic film was dry-etched (the pattern was transferred) while using the obtained silicon-containing resist middle layer film pattern as a mask to obtain an organic underlayer film pattern; and the SiO₂ wafer substrate (SiO₂ film) was dry-etched (the pattern was transferred) while using the obtained organic underlayer film pattern as a mask. The etching conditions were as follows.
Conditions in transferring resist upper layer film pattern to silicon-containing resist middle layer film
   Chamber pressure: 10.0 Pa
   RF-power: 1,500 W
   CF₄ gas flow rate: 75 mL/min
   O₂ gas flow rate: 15 mL/min
   Time: 15 sec
Conditions in transferring silicon-containing resist middle layer film pattern to organic underlayer film
   Chamber pressure: 2.0 Pa
   RF-power: 500 W
   Ar gas flow rate: 75 mL/min
   O₂ gas flow rate: 45 mL/min
   Time: 120 sec
Conditions in transferring organic underlayer film pattern to SiO₂ wafer substrate
   Chamber pressure: 2.0 Pa
   RF-power: 2,200 W
   C₅F₁₂ gas flow rate: 20 mL/min
   C₂F₆ gas flow rate: 10 mL/min
   Ar gas flow rate: 300 mL/min
   O₂ gas flow rate: 60 mL/min
   Time: 90 sec

The cross section of the obtained pattern was observed with an electron microscope (S-4700) manufactured by Hitachi, Ltd. Tables 13 and 14 show the results.

**[Table 13]**

| | Composition for forming organic film | Profile after etching for transferring to substrate |
|---|---|---|
| Example3-1 | UDL-1 | Good |
| Example3-2 | UDL-2 | Good |
| Example3-3 | UDL-3 | Good |
| Example3-4 | UDL-4 | Good |
| Example3-5 | UDL-5 | Good |
| Example3-6 | UDL-6 | Good |
| Example3-7 | UDL-7 | Good |
| Example3-8 | UDL-8 | Good |
| Example3-9 | UDL-9 | Good |
| Example3-10 | UDL-10 | Good |
| Example3-11 | UDL-11 | Good |
| Example3-12 | UDL-12 | Good |
| Example3-13 | UDL-13 | Good |
| Example3-14 | UDL-14 | Good |
| Example3-15 | UDL-15 | Good |
| Example3-16 | UDL-16 | Good |
| Example3-17 | UDL-17 | Good |
| Example3-18 | UDL-18 | Good |
| Example3-19 | UDL-19 | Good |
| Example3-20 | UDL-20 | Good |
| Example3-21 | UDL-21 | Good |
| Example3-22 | UDL-22 | Good |
| Example3-23 | UDL-23 | Good |
| Example3-24 | UDL-24 | Good |
| Example3-25 | UDL-25 | Good |
| Example3-26 | UDL-26 | Good |
| Example3-27 | UDL-27 | Good |
| Example3-28 | UDL-28 | Good |
| Example3-29 | UDL-29 | Good |
| Example3-30 | UDL-30 | Good |
| Example3-31 | UDL-31 | Good |
| Example3-32 | UDL-32 | Good |
| Example3-33 | UDL-33 | Good |
| Example3-34 | UDL-34 | Good |
| Example3-35 | UDL-35 | Good |

**[Table 14]**

| | Composition for forming organic film | Profile after etching for transferring to substrate |
|---|---|---|
| Example3-36 | UDL-36 | Good |
| Example3-37 | UDL-37 | Good |
| Example3-38 | UDL-38 | Good |
| Example3-39 | UDL-39 | Good |
| Example3-40 | UDL-40 | Good |
| Example3-41 | UDL-41 | Good |
| Example3-42 | UDL-42 | Good |
| Example3-43 | UDL-43 | Good |
| Example3-44 | UDL-44 | Good |
| Example3-45 | UDL-45 | Good |
| Example3-46 | UDL-46 | Good |
| Example3-47 | UDL-47 | Good |
| Example3-48 | UDL-48 | Good |
| Example3-49 | UDL-49 | Good |
| Example3-50 | UDL-50 | Good |
| Example3-51 | UDL-51 | Good |
| Example3-52 | UDL-52 | Good |
| Example3-53 | UDL-53 | Good |
| Example3-54 | UDL-54 | Good |
| Example3-55 | UDL-55 | Good |
| Example3-56 | UDL-56 | Good |

As shown in Tables 13 and 14, in Examples 3-1 to 3-56, where the compositions (UDL-1 to -56) for forming an organic film, being examples of the present invention, were used, the resist upper layer film pattern was successfully transferred to the SiO₂ wafer substrate in the end in every case. Thus, it was confirmed that the inventive compositions for forming an organic film can be used suitably for fine processing using a multilayer resist method.

### [Preparation of Resist Upper Layer Film Materials (ArFPR1 to 29 and Comparative ArFPR)]

Resist upper layer film materials (ArFPR1 to 29) were respectively prepared by dissolving each of the above-described polymer (RP1: resin for forming an organic film), an acid generator (PAG1), a basic compound (Amine1), and one of the fluorine-containing compounds (B1 to B29) in a solvent in the proportions shown in Tables 15 and 16, and filtering the obtained mixture through a 0.1-µm filter made of a fluororesin. Meanwhile, a comparative resist upper layer film material (comparative ArFPR) was prepared in the same manner as the resist upper layer film material (ArFPR1), except that the fluorine-containing compound was not used.

**[Table 15]**

| Resist upper layer film material | Polymer (parts by mass) | Acid generator (parts by mass) | Basic compound (parts by mass) | Fluorine-containing compound (parts by mass) | Solvent (parts by mass) |
|---|---|---|---|---|---|
| ArFPR1 | RP1 (100) | PAG1 (6.6) | Amine1 (0.8) | (B1) (2.5) | PGMEA (2500) |
| ArFPR2 | RP1 (100) | PAG1 (6.6) | Amine1 (0.8) | (B2) (2.5) | PGMEA (2500) |
| ArFPR3 | RP1 (100) | PAG1 (6.6) | Amine1 (0.8) | (B3) (2.5) | PGMEA (2500) |
| ArFPR4 | RP1 (100) | PAG1 (6.6) | Amine1 (0.8) | (B4) (2.5) | PGMEA (2500) |
| ArFPR5 | RP1 (100) | PAG1 (6.6) | Amine1 (0.8) | (B5) (2.5) | PGMEA (2500) |
| ArFPR6 | RP1 (100) | PAG1 (6.6) | Amine1 (0.8) | (B6) (2.5) | PGMEA (2500) |
| ArFPR7 | RP1 (100) | PAG1 (6.6) | Amine1 (0.8) | (B7) (2.5) | PGMEA (2500) |
| ArFPR8 | RP1 (100) | PAG1 (6.6) | Amine1 (0.8) | (B8) (2.5) | PGMEA (2500) |
| ArFPR9 | RP1 (100) | PAG1 (6.6) | Amine1 (0.8) | (B9) (2.5) | PGMEA (2500) |
| ArFPR10 | RP1 (100) | PAG1 (6.6) | Amine1 (0.8) | (B10) (2.5) | PGMEA (2500) |
| ArFPR11 | RP1 (100) | PAG1 (6.6) | Amine1 (0.8) | (B11) (2.5) | PGMEA (2500) |
| ArFPR12 | RP1 (100) | PAG1 (6.6) | Amine1 (0.8) | (B12) (2.5) | PGMEA (2500) |
| ArFPR13 | RP1 (100) | PAG1 (6.6) | Amine1 (0.8) | (B13) (2.5) | PGMEA (2500) |
| ArFPR14 | RP1 (100) | PAG1 (6.6) | Amine1 (0.8) | (B14) (2.5) | PGMEA (2500) |
| ArFPR15 | RP1 (100) | PAG1 (6.6) | Amine1 (0.8) | (B15) (2.5) | PGMEA (2500) |
| ArFPR16 | RP1 (100) | PAG1 (6.6) | Amine1 (0.8) | (B16) (2.5) | PGMEA (2500) |
| ArFPR17 | RP1 (100) | PAG1 (6.6) | Amine1 (0.8) | (B17) (2.5) | PGMEA (2500) |
| ArFPR18 | RP1 (100) | PAG1 (6.6) | Amine1 (0.8) | (B18) (2.5) | PGMEA (2500) |
| ArFPR19 | RP1 (100) | PAG1 (6.6) | Amine1 (0.8) | (B19) (2.5) | PGMEA (2500) |
| ArFPR20 | RP1 (100) | PAG1 (6.6) | Amine1 (0.8) | (B20) (2.5) | PGMEA (2500) |

**[Table 16]**

| Resist upper layer film material | Polymer (parts by mass) | Acid generator (parts by mass) | Basic compound (parts by mass) | Fluorine-containing compound (parts by mass) | Solvent (parts by mass) |
|---|---|---|---|---|---|
| ArFPR21 | RP1 (100) | PAG1 (6.6) | Amine1 (0.8) | (B21) (2.5) | PGMEA (2500) |
| ArFPR22 | RP1 (100) | PAG1 (6.6) | Amine1 (0.8) | (B22) (2.5) | PGMEA (2500) |
| ArFPR23 | RP1 (100) | PAG1 (6.6) | Amine1 (0.8) | (B23) (2.5) | PGMEA (2500) |
| ArFPR24 | RP1 (100) | PAG1 (6.6) | Amine1 (0.8) | (B24) (2.5) | PGMEA (2500) |
| ArFPR25 | RP1 (100) | PAG1 (6.6) | Amine1 (0.8) | (B25) (2.5) | PGMEA (2500) |
| ArFPR26 | RP1 (100) | PAG1 (6.6) | Amine1 (0.8) | (B26) (2.5) | PGMEA (2500) |
| ArFPR27 | RP1 (100) | PAG1 (6.6) | Amine1 (0.8) | (B27) (2.5) | PGMEA (2500) |
| ArFPR28 | RP1 (100) | PAG1 (6.6) | Amine1 (0.8) | (B28) (2.5) | PGMEA (2500) |
| ArFPR29 | RP1 (100) | PAG1 (6.6) | Amine1 (0.8) | (B29) (2.5) | PGMEA (2500) |
| Comparative ArFPR | RP1 (100) | PAG1 (6.6) | Amine1 (0.8) | - | PGMEA (2500) |

### [Preparation of Silicon Wafers Having Resist Upper Layer Film Formed Thereon By Using Resist Upper Layer Film Materials (ArFPR1 to 29 and Comparative ArFPR)]

Using a coater/developer "CLEAN TRACK LITHIUS Pro AP" of Tokyo Electron Ltd., each of the resist upper layer film materials (ArFPR1 to 29 and comparative ArFPR) prepared above was respectively discharged in an amount of 2 ml onto a silicon wafer at the center and baked. Then, the coating film was spread by rotating the wafer at a rotational rate to achieve an average film thickness of 100 nm to form each resist upper layer film precursor. Next, the silicon wafer having the resist upper layer film precursor formed was heated at 105°C for 60 seconds to obtain a silicon wafer having a resist upper layer film formed thereon.

### [In-Plane Uniformity Evaluation of Resist Upper Layer Films: Examples 4-1 to 4-29]

The film thickness within a radius of 145 mm from the center of each of resist upper layer films (ArFPR1 to 29 and comparative ArFPR) respectively formed on a silicon wafer according to the above-described method was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 3%, the material was evaluated as "Good", and when 3% or more, "Poor". Table 17 below shows the results.

**[Table 17]**

| | Resist upper layer film material | In-plane uniformity |
|---|---|---|
| Example 4-1 | ArFPR1 | Good |
| Example 4-2 | ArFPR2 | Good |
| Example 4-3 | ArFPR3 | Good |
| Example 4-4 | ArFPR4 | Good |
| Example 4-5 | ArFPR5 | Good |
| Example 4-6 | ArFPR6 | Good |
| Example 4-7 | ArFPR7 | Good |
| Example 4-8 | ArFPR8 | Good |
| Example 4-9 | ArFPR9 | Good |
| Example 4-10 | ArFPR10 | Good |
| Example 4-11 | ArFPR11 | Good |
| Example 4-12 | ArFPR12 | Good |
| Example 4-13 | ArFPR13 | Good |
| Example 4-14 | ArFPR14 | Good |
| Example 4-15 | ArFPR15 | Good |
| Example 4-16 | ArFPR16 | Good |
| Example 4-17 | ArFPR17 | Good |
| Example 4-18 | ArFPR18 | Good |
| Example 4-19 | ArFPR19 | Good |
| Example 4-20 | ArFPR20 | Good |
| Example 4-21 | ArFPR21 | Good |
| Example 4-22 | ArFPR22 | Good |
| Example 4-23 | ArFPR23 | Good |
| Example 4-24 | ArFPR24 | Good |
| Example 4-25 | ArFPR25 | Good |
| Example 4-26 | ArFPR26 | Good |
| Example 4-27 | ArFPR27 | Good |
| Example 4-28 | ArFPR28 | Good |
| Example 4-29 | ArFPR29 | Good |
| Comparative Example 4-1 | Comparative ArFPR | Poor |

As shown in Table 17, it can be observed that, since the resist upper layer film materials (ArFPR1 to 29) in the examples of the present invention were excellent in in-plane uniformity, the fluorine-containing compound (B) of the present invention functions as a surfactant that can impart an excellent leveling property, and can be contained in various compositions for forming an organic film regardless of the type of the resin or compound (A) for forming an organic film to be combined with.

From the above, the inventive composition for forming an organic film has excellent film-formability, high filling property, hump suppression property, and an excellent coating property of silicon-containing resist middle layer films, that is, process margin, and therefore, is extremely useful as an organic film material used in a multilayer resist process. Furthermore, the inventive patterning processes, using the inventive composition for forming an organic film, make it possible to fill holes and trenches having very high aspect ratios without gaps, form a fine pattern with high precision, and form a hump-suppressed organic film (e.g. organic underlayer film or resist upper layer film), and therefore, make it possible to manufacture semiconductor devices and the like efficiently.

The present description includes the following embodiments.
[1] A composition for forming an organic film, comprising:
   (A) a resin or compound for forming an organic film;
   (B) a fluorine-containing compound represented by the following general formula (1); and
   (C) a solvent, 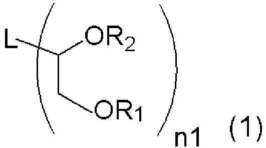
      wherein L represents a single bond or an nl-valent organic group having 1 to 50 carbon atoms, R₁ represents a saturated or unsaturated monovalent organic group having 1 to 20 carbon atoms, the organic group R₁ having at least one fluorine-containing structure represented by any of the following formulae (2), R₂ represents a hydrogen atom or a monovalent organic group having 1 to 30 carbon atoms, and "n1" represents an integer of 2 to 8, 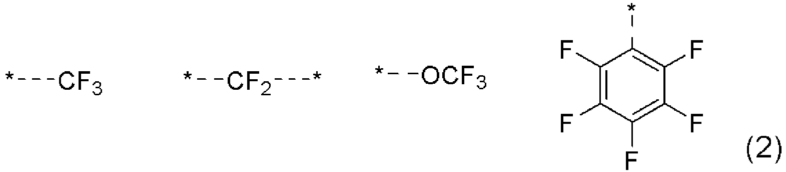
      wherein "*" represents an attachment point in the organic group represented by the R₁, the organic group R₁ optionally having two or more kinds among the structures represented by the formulae (2), or optionally having two or more identical structures.
[2] The composition for forming an organic film of [1], wherein the R₁ in the general formula (1) has a structure represented by any of the following general formulae (3), 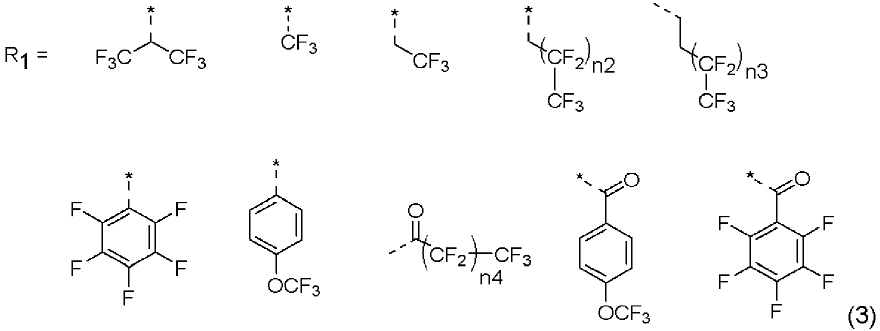 wherein "*" represents an attachment point in the organic group represented by the R₁; and "n2", "n3", and "n4" each represent an integer of 1 to 10.
[3] The composition for forming an organic film of [1] or [2], wherein the L in the general formula (1) is an organic group represented by any of the following general formulae (4), 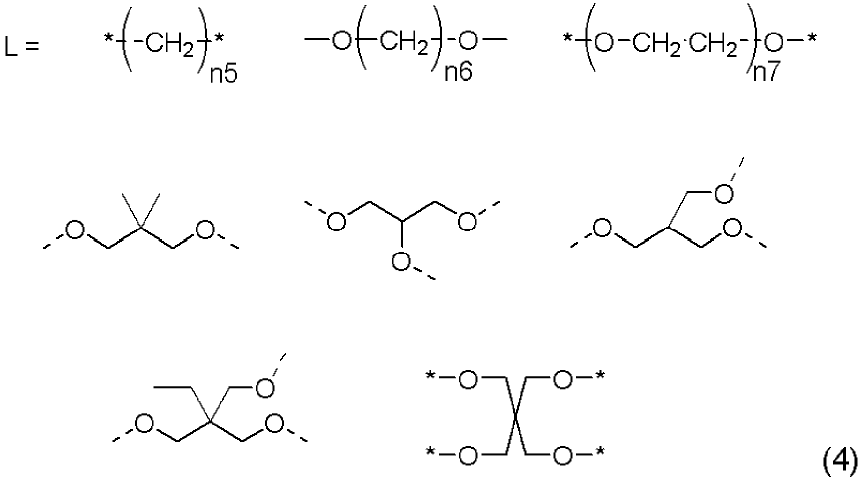 wherein "*" represents an attachment point to a terminal structure including the OR₁ and the OR₂; and "n5", "n6", and "n7" each represent an integer of 1 to 10.
[4] The composition for forming an organic film of any one of [1] to [3], wherein the R₂ in the general formula (1) is a hydrogen atom.
[5] The composition for forming an organic film of any one of [1] to [4], wherein the fluorine-containing compound (B) represented by the general formula (1) has a weight-average molecular weight of 300 to 1500.
[6] The composition for forming an organic film of any one of [1] to [5], wherein the fluorine-containing compound (B) represented by the general formula (1) satisfies 1.00 ≤ Mw/Mn ≤ 1.10, where Mw is a weight-average molecular weight and Mn is a number-average molecular weight measured by gel permeation chromatography in terms of polystyrene.
[7] The composition for forming an organic film of any one of [1] to [6], wherein the fluorine-containing compound (B) is contained in an amount of 0.01 parts by mass to 5 parts by mass based on 100 parts by mass of the resin or compound (A) for forming an organic film.
[8] A method for forming an organic film to be used in a manufacturing process of a semiconductor device, the method comprising:
   spin-coating a substrate to be processed with the composition for forming an organic film of any one of [1] to [7] to obtain a coating film; and
   forming a cured film by heating the coating film at a temperature of 100°C or higher and 600°C or lower for 10 to 600 seconds.
[9] A patterning process comprising:
   forming an organic underlayer film on a body to be processed by using the composition for forming an organic film of any one of [1] to [7];
   forming a resist middle layer film on the organic underlayer film by using a resist middle layer film material containing a silicon atom;
   forming a resist upper layer film on the resist middle layer film by using a resist upper layer film material comprising a photoresist composition;
   forming a circuit pattern in the resist upper layer film;
   transferring the pattern to the resist middle layer film by etching while using the resist upper layer film having the formed circuit pattern as a mask;
   transferring the pattern to the organic underlayer film by etching while using the resist middle layer film having the transferred pattern as a mask; and
   further transferring the pattern to the body to be processed by etching while using the organic underlayer film having the transferred pattern as a mask.
[10] A patterning process comprising:
   forming an organic underlayer film on a body to be processed by using the composition for forming an organic film of any one of [1] to [7];
   forming a resist middle layer film on the organic underlayer film by using a resist middle layer film material containing a silicon atom;
   forming an organic antireflective film or an adhesive film on the resist middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the resist middle layer film by etching while using the resist upper layer film having the formed circuit pattern as a mask;
   transferring the pattern to the organic underlayer film by etching while using the resist middle layer film having the transferred pattern as a mask; and
   further transferring the pattern to the body to be processed by etching while using the organic underlayer film having the transferred pattern as a mask.
[11] A patterning process comprising:
   forming an organic underlayer film on a body to be processed by using the composition for forming an organic film of any one of [1] to [7];
   forming an inorganic hard mask selected from the group consisting of a silicon oxide film, a silicon nitride film, and a silicon oxynitride film on the organic underlayer film;
   forming a resist upper layer film on the inorganic hard mask by using a resist upper layer film material comprising a photoresist composition;
   forming a circuit pattern in the resist upper layer film;
   transferring the pattern to the inorganic hard mask by etching while using the resist upper layer film having the formed circuit pattern as a mask;
   transferring the pattern to the organic underlayer film by etching while using the inorganic hard mask having the transferred pattern as a mask; and
   further transferring the pattern to the body to be processed by etching while using the organic underlayer film having the transferred pattern as a mask.
[12] A patterning process comprising:
   forming an organic underlayer film on a body to be processed by using the composition for forming an organic film of any one of [1] to [7];
   forming an inorganic hard mask selected from the group consisting of a silicon oxide film, a silicon nitride film, and a silicon oxynitride film on the organic underlayer film;
   forming an organic antireflective film or an adhesive film on the inorganic hard mask;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the inorganic hard mask by etching while using the resist upper layer film having the formed circuit pattern as a mask;
   transferring the pattern to the organic underlayer film by etching while using the inorganic hard mask having the transferred pattern as a mask; and
   further transferring the pattern to the body to be processed by etching while using the organic underlayer film having the transferred pattern as a mask.
[13] The patterning process of [11] or [12], wherein the inorganic hard mask is formed by a CVD method or an ALD method.
[14] The patterning process of any one of [9] to [13], wherein the circuit pattern is formed by a lithography using light having a wavelength of 10 nm or more and 300 nm or less, a direct writing with electron beam, nanoimprinting, or a combination thereof.
[15] The patterning process of any one of [9] to [14], wherein the circuit pattern is developed with an alkaline development or an organic solvent.
[16] The patterning process of any one of [9] to [15], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[17] The patterning process of [16], wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising:
(A) a resin or compound for forming an organic film;
(B) a fluorine-containing compound represented by the following general formula (1); and
(C) a solvent, 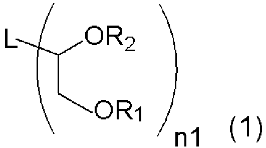
wherein L represents a single bond or an nl-valent organic group having 1 to 50 carbon atoms, R₁ represents a saturated or unsaturated monovalent organic group having 1 to 20 carbon atoms, the organic group R₁ having at least one fluorine-containing structure represented by any of the following formulae (2), R₂ represents a hydrogen atom or a monovalent organic group having 1 to 30 carbon atoms, and "n1" represents an integer of 2 to 8, 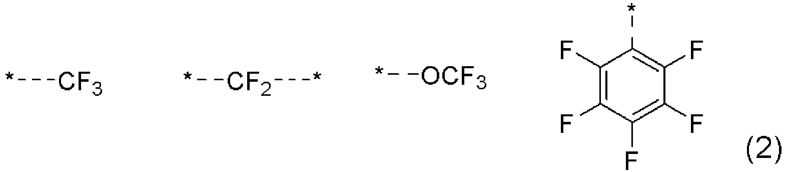
wherein "*" represents an attachment point in the organic group represented by the R₁, the organic group R₁ optionally having two or more kinds among the structures represented by the formulae (2), or optionally having two or more identical structures.

2. The composition for forming an organic film according to claim 1, wherein the R₁ in the general formula (1) has a structure represented by any of the following general formulae (3), 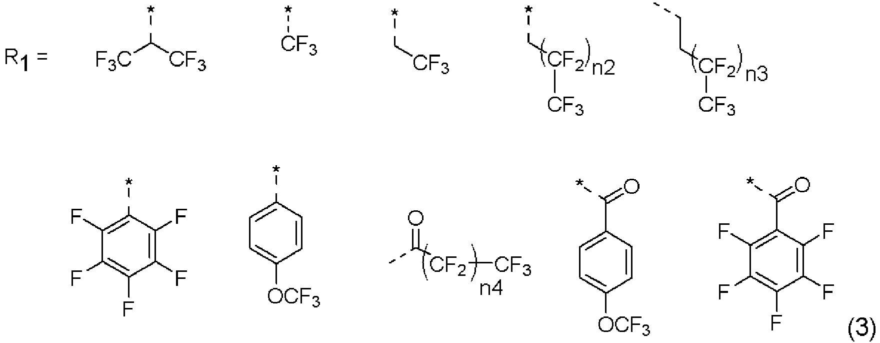 wherein "*" represents an attachment point in the organic group represented by the R₁; and "n2", "n3", and "n4" each represent an integer of 1 to 10.

3. The composition for forming an organic film according to claim 1 or 2, wherein the L in the general formula (1) is an organic group represented by any of the following general formulae (4), 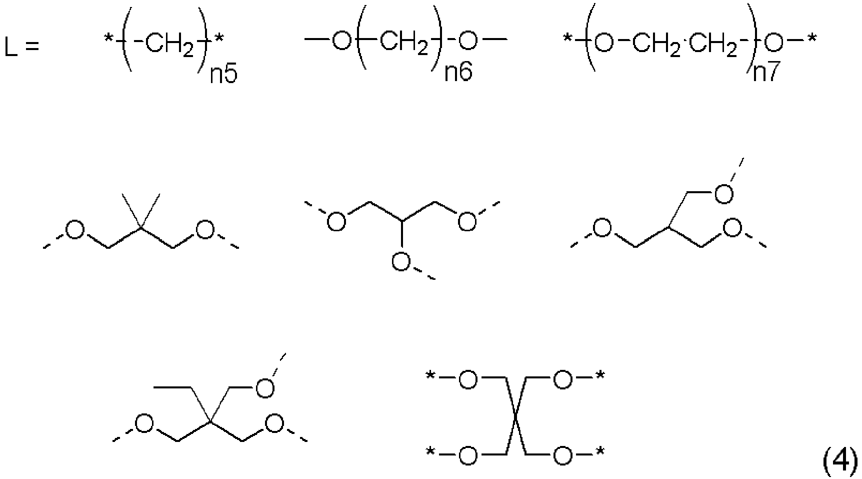 wherein "*" represents an attachment point to a terminal structure including the OR₁ and the OR₂; and "n5", "n6", and "n7" each represent an integer of 1 to 10.

4. The composition for forming an organic film according to any one of claims 1 to 3, wherein the R₂ in the general formula (1) is a hydrogen atom.

5. The composition for forming an organic film according to any one of claims 1 to 4, wherein the fluorine-containing compound (B) represented by the general formula (1) has a weight-average molecular weight of 300 to 1500.

6. The composition for forming an organic film according to any one of claims 1 to 5, wherein the fluorine-containing compound (B) represented by the general formula (1) satisfies 1.00 ≤ Mw/Mn ≤ 1.10, where Mw is a weight-average molecular weight and Mn is a number-average molecular weight measured by gel permeation chromatography in terms of polystyrene.

7. The composition for forming an organic film according to any one of claims 1 to 6, wherein the fluorine-containing compound (B) is contained in an amount of 0.01 parts by mass to 5 parts by mass based on 100 parts by mass of the resin or compound (A) for forming an organic film.

8. A method for forming an organic film to be used in a manufacturing process of a semiconductor device, the method comprising:
spin-coating a substrate to be processed with the composition for forming an organic film according to any one of claims 1 to 7 to obtain a coating film; and
forming a cured film by heating the coating film at a temperature of 100°C or higher and 600°C or lower for 10 to 600 seconds.

9. A patterning process comprising:
forming an organic underlayer film on a body to be processed by using the composition for forming an organic film according to any one of claims 1 to 7;
forming a resist middle layer film on the organic underlayer film by using a resist middle layer film material containing a silicon atom;
forming a resist upper layer film on the resist middle layer film by using a resist upper layer film material comprising a photoresist composition;
forming a circuit pattern in the resist upper layer film;
transferring the pattern to the resist middle layer film by etching while using the resist upper layer film having the formed circuit pattern as a mask;
transferring the pattern to the organic underlayer film by etching while using the resist middle layer film having the transferred pattern as a mask; and
further transferring the pattern to the body to be processed by etching while using the organic underlayer film having the transferred pattern as a mask.

10. A patterning process comprising:
forming an organic underlayer film on a body to be processed by using the composition for forming an organic film according to any one of claims 1 to 7;
forming a resist middle layer film on the organic underlayer film by using a resist middle layer film material containing a silicon atom;
forming an organic antireflective film or an adhesive film on the resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the resist middle layer film by etching while using the resist upper layer film having the formed circuit pattern as a mask;
transferring the pattern to the organic underlayer film by etching while using the resist middle layer film having the transferred pattern as a mask; and
further transferring the pattern to the body to be processed by etching while using the organic underlayer film having the transferred pattern as a mask.

11. A patterning process comprising:
forming an organic underlayer film on a body to be processed by using the composition for forming an organic film according to any one of claims 1 to 7;
forming an inorganic hard mask selected from the group consisting of a silicon oxide film, a silicon nitride film, and a silicon oxynitride film on the organic underlayer film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic underlayer film by etching while using the inorganic hard mask having the transferred pattern as a mask; and
further transferring the pattern to the body to be processed by etching while using the organic underlayer film having the transferred pattern as a mask,
preferably wherein the inorganic hard mask is formed by a CVD method or an ALD method.

12. A patterning process comprising:
forming an organic underlayer film on a body to be processed by using the composition for forming an organic film according to any one of claims 1 to 7;
forming an inorganic hard mask selected from the group consisting of a silicon oxide film, a silicon nitride film, and a silicon oxynitride film on the organic underlayer film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic underlayer film by etching while using the inorganic hard mask having the transferred pattern as a mask; and
further transferring the pattern to the body to be processed by etching while using the organic underlayer film having the transferred pattern as a mask,
preferably wherein the inorganic hard mask is formed by a CVD method or an ALD method..

13. The patterning process according to any one of claims 9 to 12, wherein the circuit pattern is formed by a lithography using light having a wavelength of 10 nm or more and 300 nm or less, a direct writing with electron beam, nanoimprinting, or a combination thereof.

14. The patterning process according to any one of claims 9 to 13, wherein the circuit pattern is developed with an alkaline development or an organic solvent.

15. The patterning process according to any one of claims 9 to 14, wherein the body to be processed is a semiconductor device substrate or the semiconductor device substrate coated with any of a metal film, a metal carbide film, a metal oxide film, a metal nitride film, a metal oxycarbide film, and a metal oxynitride film,
preferably wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
